# EUROPEAN PATENT APPLICATION

(11) **EP 4 697 596 A1**
(43) Date of publication of application: **18.02.2026**
(21) Application number: 24933200.8
(22) Date of filing: 21.06.2024
(51) Int. Cl.: H03F 1/32

(54) **POWER AMPLIFICATION CIRCUIT WITH SIMILAR COMBINING AND CANCELLATION**

(30) Priority: 20.06.2024 CN 202410803976
(71) Applicant: Wuguang Technologies Pte. Ltd., Singapore 409051 (SG); Accula Electronic Technologies Pte. Ltd., Singapore 189677 (SG); Avalen Info System Technologies Company Limited, Vancouver, BC V6C 3L6 (CA); Wisdor Technologies Pte. Ltd., Singapore 159836 (SG); Oneany Technologies Company Limited, Kowloon 999077 (HK)
(72) Inventor: MENG, Qingnan, Wuhan, Hubei 430070 (CN)
(74) Representative: Regimbeau
(86) International application number: PCT/CN2024/100805
(87) International publication number: WO 2025/260382

(57) **Abstract**

Provided a similar combination and cancellation power amplifier circuit including a combiner main circuit implemented by connecting an output of a main signal and branch similar input combination and cancellation parallel circuit or main signal and branch similar input combination and cancellation series circuit to a main power amplifier circuit. An output of a main signal and branch similar input combination combiner circuit in the main signal and branch similar input combination and cancellation parallel circuit or main signal and branch similar input combination and cancellation series circuit is connected to an input of the main power amplifier circuit, to implement a branch similar input combination and main signal combiner main circuit. In the present disclosure, a linear ACPR value of a Class C-like main power signal with extended linear gain of a main power signal of the branch similar input combination and main signal combiner main circuit is increased to above 30-35 dBc, and at the same time, a linear ACPR value of a Class C-like main power signal with extended linear gain of a main power signal of a branch similar input combination and input cancellation combiner main circuit is also increased to above 40-45 dBC.

## Description

This application claims priority to Chinese Patent Application No. 202410803976.6 filed Jun. 20, 2024, the disclosure of which is incorporated herein by reference in its entirety.

### TECHNICAL FIELD

The present disclosure relates to the technical field of signal power amplification, and specifically to a similar combination and cancellation power amplifier circuit.

### BACKGROUND

In a signal power amplification technical device, in an output power performance indicator, it requires that an output gain in a power amplifier circuit is Class A, Class AB, or Class AB-like linear gain and a distorted signal in an output power meets a requirement for a power linear adjacent channel power ratio (ACPR) value, and working efficiency is high at a rated output power. In recent years, in order to cause the power amplifier circuit to have the Class A or Class AB linear gain and meet a working efficiency requirement at a certain power linear index, currently existing technologies include a feed-forward technology, an analog pre-distortion technology, a digital analog pre-distortion technology, a digital pre-distortion technology, and an analog pre-distortion or digital analog pre-distortion and feed-forward mixed technology, and a power amplifier in feed-forward is a Doherty technology, and a feed-forward cancellation combination technology.

For a Class A, Class AB, or Doherty Class AB-like power amplifier circuit, the analog pre-distortion technology, the analog digital pre-distortion technology, and the digital pre-distortion technology all have the effect of canceling out a distorted signal in an output power of the Class A, Class AB, or Class AB-like Doherty power amplifier circuit, and are especially highly effective after cooperative cancellation with Doherty.

For a Class C or Class C-like power amplifier circuit, the analog pre-distortion technology, the analog digital pre-distortion technology, and the digital pre-distortion technology cannot extend a Class C linear gain dynamic range or extend an output linear gain dynamic range of a Class C power amplifier circuit with a certain power amplifier circuit to within a power dynamic range of smaller output main powers.

A Doherty power amplifier circuit is implemented by combining, through an impedance transformer network, a Class C power amplifier and a Class A power amplifier or by combining, through an impedance transformer network, a Class C power amplifier and a Class AB power amplifier, achieving a linear gain dynamic range like Class A or Class AB, and only with this linearity dynamic range can digital pre-distortion (DPD), analog digital pre-distortion (APD), or analog digital pre-distortion (ADPD) be applied to cancel distortion. Since the DPD, APD, ADPD, etc. are all distorted signals in the Class A or AB main power signals, a linear gain dynamic range of a Class C power amplifier cannot be compensated, the Class C power amplifier provides efficiency but has unqualified linearity, and Class A and Class AB power amplifiers improve the linearity but has reduced efficiency. A feed-forward power amplifier and ADPD may improve the linearity and may improve the efficiency. APD and DPD+Doherty may improve the linearity and may improve the efficiency. A main power amplifier in the feed-forward power amplifier is Doherty feed-forward combination + cancellation, or since the gain extension range canceled by the Class C feed-forward itself is limited, and when the extension range meets requirements, Class C efficiency is reduced, such that when the Class C efficiency is high, the extension range is insufficient. For ADPD + feed-forward or APD + feed-forward, there is no Class C distorted signal in the distorted signal in a distortion extraction circuit in a feed-forward circuit, as the linear gain of the implemented power amplifier cannot meet Class A, Class AB, or the range rolling back from P1dB (1dB power compression point) to more than 30 dB, or the power amplifier in the feed-forward circuit. When a cancellation requirement meeting APD or ADPD meets a requirement for 45 dBc, the feed-forward power amplifier itself has a certain requirement for linearity, which is to reach more than 35 dBc, thus the efficiency of the feed-forward power amplifier itself is reduced.

The analog pre-distortion technology, the analog digital pre-distortion technology, and the digital pre-distortion technology provide little or no compensation effects for an output distorted signal of the Class C power amplifier circuit with little linear gain, or for the compensation effect on the output distorted signal of the Class C or Class C-like power amplifier circuit with the linear gain being within a certain range, a lower output power is extended with the linear gain range from small to some value only within one-half or one-third of a compensation value of the output distorted signal of the Class A or Class AB power amplifier circuit, and in this case, the efficiency of the Class C-like power amplifier circuit is close to the efficiency of the Class AB power amplifier circuit, and still does not meet the requirements for the gain of the power amplifier circuit being Class A or Class AB or Class AB-like linear gain.

The feed-forward technology can meet an output linearity requirement of the power amplifier circuit, such as Class AB and Class Doherty. However, the overall working efficiency after the feed-forward technology compensates the output linearity requirement of the Doherty power amplifier circuit is much lower than the overall working efficiency after DPD compensates the output linearity requirement of the Doherty power amplifier circuit.

The Class C or Class C-like power amplifier circuit in the AP or APD feed-forward technology cooperates with a front pre-distortion section circuit after compensation, the distorted signal is canceled out by extracting a front section after cooperative compensation, and the canceled distorted signal of the front section circuit after cooperative compensation is canceled out in a rear section circuit implemented by a feed-forward cancellation time-delay circuit in the feed-forward technology, as the front section circuit is same as the analog pre-distortion technology or the analog digital pre-distortion technology and the cooperative compensation of the Class C or Class C-like power amplifier circuit.

All of the above linearization technologies and power amplifier high efficiency technologies have shortcomings in terms of cooperation, such that how to further improve the efficiency and linearity of a power amplifier circuit is a topic worthy of in-depth study.

### SUMMARY

The present disclosure is intended to provide a similar combination and cancellation power amplifier circuit, which specifically indicates a power amplifier circuit having a similar combination and cancellation function. The circuit can increase a linear ACPR value of a Class C-like main power signal with extended linear gain of a main power signal of a branch similar input combination and main signal combiner main circuit to above 30-35 dBc under a small signal condition, and at the same time, increase a linear ACPR value of a Class C-like main power signal with extended linear gain of a main power signal of a branch similar input combination and input cancellation combiner main circuit to above 40-45 dBC.

The present disclosure provides a technical solution to solve the above problem, which specifically provides a similar combination and cancellation power amplifier circuit. The similar combination and cancellation power amplifier circuit having a function of a branch similar input combination and input cancellation combiner main circuit is implemented by connecting an output of a main signal branch similar input combination and input cancellation parallel circuit or main signal branch similar input combination and input cancellation series circuit to a main power amplifier circuit, and an output of a main signal and branch similar input combination combiner circuit in the main signal branch similar input combination and input cancellation parallel circuit or main signal branch similar input combination and input cancellation series circuit is connected to an input of the main power amplifier circuit, to implement a branch similar input combination and main signal combiner main circuit.

In a branch similar input combination and input cancellation combiner main circuit of the similar combination and cancellation power amplifier circuit, the main signal and branch similar input combination and cancellation parallel circuit is implemented through a parallel input divider circuit or through a parallel digital input divider circuit and a parallel output combiner circuit by parallelly connecting analog input ports of two circuits, which are the main signal and branch similar input combination combiner circuit and a branch similar input cancellation circuit, or one analog input port and one digital input port in the two circuits or the digital input ports of the two circuits and outputs of the two circuits; or implemented through the parallel input divider circuit or through the parallel digital input divider circuit and the parallel output combiner circuit by parallelly connecting analog input ports of two circuits, which are a main signal and branch similar input cancellation combiner circuit and a branch similar input combiner circuit, or one analog input port and one digital input port in the two circuits or the digital input ports of the two circuits and outputs of the two circuits; or implemented through the parallel input divider circuit or through the parallel digital input divider circuit and the parallel output combiner circuit by parallelly connecting inputs of two circuits, which are a branch similar input combination and input cancellation combiner circuit and a corresponding input combination or input cancellation main signal time-delay adjustment circuit, or one analog input port and one digital input port in the two circuits and outputs of the two circuits. An input of the parallel input divider circuit or a digital input port of the parallel digital input divider circuit and an output of the parallel output combiner circuit are a corresponding input or digital input port and an output of the main signal and branch similar input combination and cancellation parallel circuit.

In the branch similar input combination and input cancellation combiner main circuit of the similar combination and cancellation power amplifier circuit, the main signal and branch similar input combination and cancellation series circuit is implemented by serially connecting the main signal and branch similar input combination combiner circuit and the main signal and branch similar input cancellation combiner circuit. An input of the main signal and branch similar input cancellation combiner circuit and the output of the main signal and branch similar input combination combiner circuit or an input of the main signal and branch similar input combination combiner circuit and the output of the main signal and branch similar input cancellation combiner circuit are a corresponding input and output of the main signal and branch similar input combination and cancellation series circuit.

In the main signal and branch similar input combination and cancellation parallel circuit, only one input combination or input cancellation main signal time-delay adjustment circuit is provided, and in the main signal and branch similar input combination combiner circuit or the main signal and branch similar input cancellation combiner circuit, only one input combination or input cancellation main signal time-delay adjustment circuit is provided.

The main signal and branch similar input combination combiner circuit or the main signal and branch similar input cancellation combiner circuit is implemented through a branch-main combination or branch-main cancellation input divider circuit or through a branch-main combination or branch-main cancellation digital input divider circuit, and a branch-main combination or branch-main cancellation output combiner circuit parallelly connected to inputs of the two circuits, which are the branch similar input combiner circuit or the branch similar input cancellation circuit and the corresponding input combination or input cancellation main signal time-delay adjustment circuit, or one analog input port and one digital input port in the two circuits and the outputs of the two circuits;

or the branch similar input combination and input cancellation combiner circuit therein is implemented through the branch-main combination or branch-main cancellation input divider circuit or through the branch-main combination or branch-main cancellation digital input divider circuit and the branch-main combination or branch-main cancellation output combiner circuit parallelly connected to inputs of the two circuits, which are the branch similar input combiner circuit and the branch similar input cancellation circuit, or the digital input ports of the two circuits or one analog input port and one digital input port in the two circuits and the outputs of the two circuits.

The branch similar input combiner circuit is configured to output a distorted signal having input same-phase combination compensation, which has a characteristic of compensating for extension of a linear gain dynamic range of main power signals among Class C main power signals outputted by a Class C main power amplifier circuit that are less than an input combination equal-power point to have main power signals with lower output power level.

The branch similar input cancellation circuit is configured to output a pre-distorted signal having input reversed-phase similar cancellation, which has a characteristic similar to that of the distorted signal greater than an input cancellation equal-power point in the Class C main power signal with an extended linear gain dynamic range of main power signals of the branch similar input combination and main signal combiner main circuit.

Input combination and input cancellation features of the output of the branch similar input combination and input cancellation combiner main circuit are as follows.

At an input combination equal-power point in the branch similar input combination and main signal combiner main circuit and an input cancellation equal-power point in the branch similar input combination and input cancellation combiner main circuit, when a main power amplifier circuit is a Class C power amplifier circuit, at equal or nearly equal time delays, equal or nearly equal amplitudes, and when phase of the two circuits in the branch similar input combination and main signal combiner main circuit are within a range from 0 degree to 45 degrees, and phase of the branch similar input combination and input cancellation combiner main circuit are opposite or nearly opposite, in the main signal and branch similar input combination and cancellation parallel circuit or main signal and branch similar input combination and cancellation series circuit meeting the above conditions, the distorted signal having input same-phase combination compensation outputted by the branch similar input combiner circuit and the pre-distorted signal having input reversed-phase similar cancellation outputted by the branch similar input cancellation circuit are generated on the output of the main signal and branch similar input combination and cancellation parallel circuit or main signal and branch similar input combination and cancellation series circuit, to implement a combination cancellation mixed distorted signal.

In the combination cancellation mixed distorted signal, when the distorted signal having input same-phase combination compensation outputted by the branch similar input combiner circuit has the characteristic of compensating for the extension of the linear gain dynamic range of the main power signals among the Class C main power signals outputted by the Class C main power amplifier circuit that are less than the input combination equal-power point to have the main power signals with lower output power level, and on the output of the branch similar input combination and main signal combiner main circuit in the branch similar input combination and input cancellation combiner main circuit, when the time delays equal to the input combination equal-power point are equal, the amplitudes are equal or nearly equal, and the phase of the two circuits are within the range from 0 degree to 45 degrees, the distorted signal having same-phase combination compensation outputted by the branch similar input combiner circuit and the compensation extension of the linear gain dynamic range of the main power signals among the Class C main power signals outputted by the Class C main power amplifier circuit that are less than the input combination equal-power point to the main power signals with lower output power level are realized, and an error vector magnitude (EVM) value and a gain fluctuation are increased within the linear gain dynamic range that has been extended to the main power signals with lower output power level, thereby increasing a linear ACPR value of the Class C main power signal with the extended linear gain dynamic range of the main power signals of the branch similar input combination and main signal combiner main circuit to above 30-35 dBc.

When the linear ACPR value of the Class C main power signal with the extended linear gain dynamic range of the main power signals reaches above 30-35 dBc on the output of the branch similar input combination and main signal combiner main circuit, the pre-distorted signal having input reversed-phase similar cancellation outputted by the branch similar input cancellation circuit in the combination cancellation mixed distorted signal has the characteristic similar to that of the distorted signal greater than the input cancellation equal-power point in the Class C main power signal with the extended linear gain dynamic range of the main power signals of the branch similar input combination and main signal combiner main circuit, and on the output of the branch similar input combination and input cancellation combiner main circuit, when the time delays equal to the input cancellation equal-power point are equal or nearly equal, the amplitudes are equal or nearly equal, and the phase are opposite or nearly opposite, the reversed-phase similar cancellation between the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, thereby increasing a linear ACPR value of the Class C main power signal with the extended linear gain dynamic range of the main power signals outputted by the branch similar input combination and input cancellation combiner main circuit to above 40-45 dBC; or the reversed-phase similar cancellation between the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, the linear gain dynamic range of the main power signals is achieved to extend a linear gain dynamic range of a Class C output main power signal, to further extend to the main power signals with lower output power level, and the EVM value and the gain fluctuation are increased within the linear gain dynamic range that has been extended to the main power signals with lower output power level, thereby increasing the linear ACPR value of the Class C main power signal with the extended or further extended linear gain dynamic range of the main power signals of the branch similar input combination and input cancellation combiner main circuit to above 40-45 dBC, and improving the overall efficiency of the similar combination and cancellation power amplifier circuit.

Or through a combination input divider circuit or through a combination digital input divider circuit and a combination output coupling circuit parallelly connecting analog input ports or digital input ports of the two circuits or one analog input port and one digital input port in the two circuits and the outputs of the two circuits, which are the branch similar input combination and input cancellation combiner main circuit and a branch similar output cancellation circuit, to implement the similar combination and cancellation power amplifier circuit having a function of a branch similar input combination cancellation and branch output cancellation combiner main circuit.

In a branch similar input combination cancellation and branch output cancellation combiner main circuit, only one input combination or input cancellation main signal time-delay adjustment circuit is provided.

A distorted signal having output reversed-phase similar cancellation is generated on the output of the branch similar output cancellation circuit, and has a characteristic similar to that of the distorted signal greater than an output cancellation equal-power point in the Class C main power signal with the extended linear gain dynamic range of the main power signals of the branch similar input combination and input cancellation combiner main circuit.

Output cancellation features of an output of the branch similar input combination cancellation and branch output cancellation combiner main circuit are as follows.

When the linear ACPR value of the Class C main power signal with the extended linear gain dynamic range of the main power signals reaches above 40-45 dBC on an output of the branch similar input combination and input cancellation combiner main circuit, and at the output cancellation equal-power point in the branch similar input combination cancellation and branch output cancellation combiner main circuit when time delays are equal or nearly equal, amplitudes are equal or nearly equal, and phase are opposite or nearly opposite, the distorted signal generated by the branch similar output cancellation circuit and having the output reversed-phase similar cancellation characteristic is similar to the distorted signal greater than the output cancellation equal-power point in the Class C main power signal with the extended linear gain dynamic range of the main power signals outputted by the branch similar input combination and input cancellation combiner main circuit, such that the distorted signal having output reversed-phase similar cancellation generated by the branch similar output cancellation circuit and a distorted signal greater than an output cancellation equal-power point in a Class C main power signal with an extended linear gain dynamic range of main power signals outputted by a main similar input combination and input cancellation combiner main circuit cancel out each other, thereby increasing a linear ACPR value of the Class C main power signal further extended by the main power signals outputted by the branch similar input combination cancellation and branch output cancellation combiner main circuit to more than 50-55 dBC, or a distorted signal having output reversed-phase equality cancellation generated by the branch similar output cancellation circuit and the distorted signal greater than the output cancellation equal-power point in the Class C main power signal with the extended linear gain dynamic range of the main power signals outputted by the main similar input combination and input cancellation combiner main circuit cancel out each other, the linear gain of a Class C output main power signal with the extended linear gain dynamic range of the main power signals is extended through the reverse compensation characteristic of the Class C main power signal with the extended linear gain dynamic range of the main power signals of the branch similar input combination and input cancellation combiner main circuit generated by the branch similar output cancellation circuit, to further extend to have a smaller output main power signal range, and the EVM value and a gain fluctuation are increased within the further extended linear gain dynamic range, thereby increasing the linear ACPR value of the Class C main power signal further extended by the main power signals outputted by the branch similar input combination cancellation and branch output cancellation combiner main circuit to more than 50-55 dBC, and improving overall efficiency.

Or a main power output of a feed-forward distortion extraction circuit of the branch similar input combination and input cancellation combiner main circuit is connected to a main power input of a main feed-forward output cancellation circuit, and a distortion output of the feed-forward distortion extraction circuit of the branch similar input combination and input cancellation combiner main circuit is connected to a distortion input of the main feed-forward output cancellation circuit, to implement a similar combination and cancellation power amplifier circuit having a function of a branch similar input combination cancellation and feed-forward output cancellation series circuit.

In a branch similar input combination cancellation and feed-forward output cancellation series circuit, from an input of a main circuit of a main feed-forward input coupling circuit to an output of a feed-forward cancellation coupling circuit via a feed-forward main time-delay circuit and via a feed-forward distortion adjustment power amplifier circuit connected to an output of a feed-forward distortion output combiner circuit, a main feed-forward combination cancellation circuit is implemented, which including from the input of the main feed-forward input coupling circuit to the output of the feed-forward cancellation coupling circuit.

Same type cancellation features of at the output of a branch similar input combination cancellation and feed-forward output cancellation series circuit is as follows: when Class C main power linear ACPR of the extended linear gain dynamic range of the main power signals reaches above 40-45 dBC on the output of the branch similar input combination and input cancellation combiner main circuit, on the output of the branch similar input combination cancellation and feed-forward output cancellation series circuit, when time delays at a feed-forward cancellation equal-power point are equal or nearly equal, amplitudes are equal or nearly equal, and phase are opposite or nearly opposite, a distorted signal in a Class C main power signal with an extended linear gain dynamic range of main power signals outputted by the branch similar input combination and input cancellation combiner main circuit is extracted by the distortion output of the feed-forward distortion extraction circuit of the branch similar input combination and input cancellation combiner main circuit and a distorted signal in a Class C main power signal with an extended linear gain dynamic range of main power signals outputted by the main power output of the feed-forward distortion extraction circuit of the branch similar input combination and input cancellation combiner main circuit are the same type of distorted signals, on an output of a main feed-forward combination cancellation circuit, when the time delays at the feed-forward cancellation equal-power point are equal or nearly equal, the amplitudes are equal or nearly equal, and the phase are opposite or nearly opposite, the same type distortion signal cancellation of the distorted signal in the Class C main power signal with the extended linear gain dynamic range of the main power signals outputted by the branch similar input combination and input cancellation combiner main circuit is realized, and a linear gain dynamic range of the Class C output main power signal with the extended linear gain dynamic range of the main power signals is further extended to reach a linear gain dynamic range of a Class AB output main power, and an EVM value and a gain fluctuation are increased within the linear gain dynamic range that has been extended, thereby causing a Class C total linear dynamic range of Class AB output main power signals outputted by the branch similar input combination cancellation and feed-forward output cancellation series circuit to reach a linear ACPR value of the Class AB output main power signal to more than 50-55 dBC, and improving the overall efficiency.

In an exemplary embodiment, the similar combination and cancellation power amplifier circuit having a function of a branch similar input combination and input cancellation combiner main circuit is implemented by connecting an output of a main signal branch similar input combination and input cancellation parallel circuit or main signal branch similar input combination and input cancellation series circuit to a main power amplifier circuit, and an output of a main signal and branch similar input combination combiner circuit in the main signal branch similar input combination and input cancellation parallel circuit or main signal branch similar input combination and input cancellation series circuit is connected to an input of the main power amplifier circuit, to implement a branch similar input combination and main signal combiner main circuit.

The branch similar input combiner circuit is configured to output the distorted signal having input same-phase combination compensation, which has the characteristic of compensating for extension of the linear gain dynamic range of main power signals among the Class C main power signals outputted by the Class C main power amplifier circuit that are less than the input combination equal-power point to have the main power signals with lower output power level.

The branch similar input cancellation circuit is configured to output the pre-distorted signal having input reversed-phase similar cancellation, which has the characteristic similar to that of the distorted signal greater than the input cancellation equal-power point in the Class C main power signal with the extended linear gain dynamic range of main power signals of the branch similar input combination and main signal combiner main circuit.

The input combination and input cancellation features of the output of the branch similar input combination and input cancellation combiner main circuit are as follows: at the input combination equal-power point in the branch similar input combination and main signal combiner main circuit and the input cancellation equal-power point in the branch similar input combination and input cancellation combiner main circuit, when the main power amplifier circuit is the Class C power amplifier circuit, at equal or nearly equal time delays, equal or nearly equal amplitudes, and when the phase of the two circuits in the branch similar input combination and main signal combiner main circuit are within the range from 0 degree to 45 degrees, and the phase of the branch similar input combination and input cancellation combiner main circuit are opposite or nearly opposite, in the main signal branch similar input combination and input cancellation parallel circuit or main signal branch similar input combination and input cancellation series circuit meeting the above conditions, the distorted signal having input same-phase combination compensation outputted by the branch similar input combiner circuit and the pre-distorted signal having input reversed-phase similar cancellation outputted by the branch similar input cancellation circuit are generated on the output of the main signal branch similar input combination and input cancellation parallel circuit or main signal branch similar input combination and input cancellation series circuit, to implement the combination cancellation mixed distorted signal.

In the combination cancellation mixed distorted signal, when the distorted signal having input same-phase combination compensation outputted by the branch similar input combiner circuit has the characteristic of compensating for the extension of the linear gain dynamic range of the main power signals among the Class C main power signals outputted by the Class C main power amplifier circuit that are less than the input combination equal-power point to the main power signals with lower output power level, and on the output of the branch similar input combination and main signal combiner main circuit in the branch similar input combination and input cancellation combiner main circuit, when the time delays equal to the input combination equal-power point are equal, the amplitudes are equal or nearly equal, and the phase of the two circuits are within the range from 0 degree to 45 degrees, the distorted signal having same-phase combination compensation outputted by the branch similar input combiner circuit and the compensation extension of the linear gain dynamic range of the main power signals among the Class C main power signals outputted by the Class C main power amplifier circuit that are less than the input combination equal-power point to the main power signals with lower output power level are realized, and the EVM value and the gain fluctuation are increased within the linear gain dynamic range that has been extended to the main power signals with lower output power level, thereby increasing the linear ACPR value of the Class C main power signal with the extended linear gain dynamic range of the main power signals of the branch similar input combination and main signal combiner main circuit to above 30-35 dBc.

When the linear ACPR value of the Class C main power signal with the extended linear gain dynamic range of the main power signals reaches above 30-35 dBc on the output of the branch similar input combination and main signal combiner main circuit, the pre-distorted signal having input reversed-phase similar cancellation outputted by the branch similar input cancellation circuit in the combination cancellation mixed distorted signal has the characteristic similar to that of the distorted signal greater than the input cancellation equal-power point in the Class C main power signal with the extended linear gain dynamic range of the main power signals of the branch similar input combination and main signal combiner main circuit, and on the output of the branch similar input combination and input cancellation combiner main circuit, when the time delays equal to the input cancellation equal-power point are equal or nearly equal, the amplitudes are equal or nearly equal, and the phase are opposite or nearly opposite, the reversed-phase similar cancellation between the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, thereby increasing the linear ACPR value of the Class C main power signal with the extended linear gain dynamic range of the main power signals outputted by the branch similar input combination and input cancellation combiner main circuit to above 40-45 dBC; or the reversed-phase similar cancellation between the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, the linear gain dynamic range of the main power signals is achieved to extend the linear gain dynamic range of the Class C output main power signal, to further extend to the main power signals with lower output power level, and the EVM value and the gain fluctuation are increased within the linear gain dynamic range that has been extended to the main power signals with lower output power level, thereby increasing the linear ACPR value of the Class C main power signal with the extended or further extended linear gain dynamic range of the main power signals of the branch similar input combination and input cancellation combiner main circuit to above 40-45 dBC, and improving the overall efficiency of the similar combination and cancellation power amplifier circuit.

In an exemplary embodiment, the main power amplifier circuit in the branch similar input combination and input cancellation combiner main circuit is the Class C power amplifier circuit, which is implemented by a single Class C power amplifier circuit or multi-channels power amplifiers which including at least one Class C power amplifier circuits and through combination or by combining impedance transformation networks to achieve.

In an exemplary embodiment, in the branch similar input combination and input cancellation combiner main circuit of the similar combination and cancellation power amplifier circuit, the main signal branch similar input combination and input cancellation parallel circuit is implemented through the parallel input divider circuit or through the parallel digital input divider circuit and the parallel output combiner circuit by parallelly connecting analog input ports of two circuits, which are a main signal and branch similar input combination combiner circuit of the distortion extraction adjustment amplifier circuit for analog distortion in the main signal and branch similar input combination combiner circuit, or a branch similar input combination analog digital distortion circuit, or a branch similar input combination digital distortion circuit, and the branch similar input cancellation circuit, or one analog input port and one digital input port in the two circuits or the digital input ports of the two circuits and outputs of the two circuits; or implemented through the parallel input divider circuit or through the parallel digital input divider circuit and the parallel output combiner circuit by parallelly connecting analog input ports of two circuits, which are a distortion extraction adjustment amplification combiner circuit for analog pre-distortion of the main signal and branch similar input cancellation in the main signal and branch similar input cancellation combiner circuit, or a distortion extraction adjustment amplification combiner circuit of a branch similar input combination and main signal combined auxiliary circuit for branch similar input cancellation, or a branch similar input cancellation analog digital pre-distortion circuit, or a branch similar input cancellation digital pre-distortion circuit, and the branch similar input combiner circuit, or one analog input port and one digital input port in the two circuits or the digital input ports of the two circuits and outputs of the two circuits; or implemented through the parallel input divider circuit or through the parallel digital input divider circuit and the parallel output combiner circuit by parallelly connecting the inputs of two circuits, which are the branch similar input combination and input cancellation combiner circuit and the corresponding input combination or input cancellation main signal time-delay adjustment circuit, or one analog input port and one digital input port in the two circuits and outputs of the two circuits, wherein the input of the parallel input divider circuit or the digital input port of the parallel digital input divider circuit and the output of the parallel output combiner circuit are the corresponding input or digital input port and the output of the main signal branch similar input combination and input cancellation parallel circuit.

In the main signal branch similar input combination and input cancellation parallel circuit, only one input combination or input cancellation main signal time-delay adjustment circuit is provided, and in the main signal and branch similar input combination combiner circuit or the main signal and branch similar input cancellation combiner circuit, only one input combination or input cancellation main signal time-delay adjustment circuit is provided.

Cancellation features of the combination cancellation mixed distorted signal of the main signal branch similar input combination and input cancellation parallel circuit in the branch similar input combination and input cancellation combiner main circuit are as follows: at the input combination equal-power point in the branch similar input combination and main signal combiner main circuit and the input cancellation equal-power point in the branch similar input combination and input cancellation combiner main circuit, when the main power amplifier circuit is the Class C power amplifier circuit, at equal or nearly equal time delays, equal or nearly equal amplitudes, and when the phase of the two circuits in the branch similar input combination and main signal combiner main circuit are within the range from 0 degree to 45 degrees, and the phase of the branch similar input combination and input cancellation combiner main circuit are opposite or nearly opposite, in the main signal branch similar input combination and input cancellation parallel circuit meeting the above conditions, the distorted signal having input same-phase combination compensation outputted by the branch similar input combiner circuit and the pre-distorted signal having input reversed-phase similar cancellation outputted by the branch similar input cancellation circuit are generated on the output of the main signal branch similar input combination and input cancellation parallel circuit, to implement the combination cancellation mixed distorted signal.

In the combination cancellation mixed distorted signal, the distorted signal having input same-phase combination compensation outputted by the branch similar input combiner circuit has the characteristic of compensating for the extension of the linear gain dynamic range of the main power signals among the Class C main power signals outputted by the Class C main power amplifier circuit that are less than the input combination equal-power point to have the main power signals with lower output power level.

In the combination cancellation mixed distorted signal, the pre-distorted signal having input reversed-phase similar cancellation generated by the branch similar input cancellation circuit has the characteristic similar to that of the distorted signal greater than the input cancellation equal-power point in the Class C main power signal with the extended linear gain dynamic range of the main power signals of the branch similar input combination and main signal combiner main circuit.

In an exemplary embodiment, in the branch similar input combination and input cancellation combiner main circuit of the similar combination and cancellation power amplifier circuit, the main signal branch similar input combination and input cancellation series circuit is implemented by serially connecting the main signal and branch similar input combination combiner circuit and the main signal and branch similar input cancellation combiner circuit. An input of the main signal and branch similar input cancellation combiner circuit and the output of the main signal and branch similar input combination combiner circuit or an input of the branch similar input combination combiner circuit and the output of the branch similar input cancellation combiner circuit are a corresponding input and output of the main signal branch similar input combination and input cancellation series circuit.

The main signal and branch similar input combination combiner circuit comprises a main signal and branch similar input combination combiner circuit of the distortion extraction adjustment amplifier circuit for analog distortion, a branch similar input combination analog digital distortion circuit, and a branch similar input combination digital distortion circuit.

The main signal and branch similar input cancellation combiner circuit comprises a combiner circuit of a distortion extraction adjustment amplifier circuit for analog pre-distortion of the main signal and branch similar input cancellation, a branch similar input cancellation analog digital pre-distortion circuit, a branch similar input cancellation digital pre-distortion circuit, and a combiner circuit of a distortion extraction adjustment amplifier circuit of a branch similar input combination and main signal combined auxiliary circuit for main signal and branch similar input cancellation.

In the main signal and branch similar input combination combiner circuit or main signal and branch similar input cancellation combiner circuit, only one input combination or input cancellation main signal time-delay adjustment circuit is provided.

Features of the combination cancellation mixed distorted signal of the main signal branch similar input combination and input cancellation series circuit in the branch similar input combination and input cancellation combiner main circuit are as follows: at the input combination equal-power point in the branch similar input combination and main signal combiner main circuit and the input cancellation equal-power point in the branch similar input combination and input cancellation combiner main circuit, when the main power amplifier circuit is the Class C power amplifier circuit, at equal or nearly equal time delays, equal or nearly equal amplitudes, and when the phase of the two circuits in the branch similar input combination and main signal combiner main circuit are within the range from 0 degree to 45 degrees, and the phase of the branch similar input combination and input cancellation combiner main circuit are opposite or nearly opposite, in the main signal branch similar input combination and input cancellation series circuit meeting the above conditions, the distorted signal having input same-phase combination compensation outputted by the branch similar input combiner circuit and the pre-distorted signal having input reversed-phase similar cancellation outputted by the branch similar input cancellation circuit are generated on the output of the main signal branch similar input combination and input cancellation series circuit, to implement the combination cancellation mixed distorted signal.

In the combination cancellation mixed distorted signal, the distorted signal having input same-phase combination compensation outputted by the branch similar input combiner circuit has the characteristic of compensating for the extension of the linear gain dynamic range of the main power signals among the Class C main power signals outputted by the Class C main power amplifier circuit that are less than the input combination equal-power point to have the main power signals with lower output power level.

In the combination cancellation mixed distorted signal, the pre-distorted signal having input reversed-phase similar cancellation generated by the branch similar input cancellation circuit has the characteristic similar to that of the distorted signal greater than the input cancellation equal-power point in the Class C main power signal with the extended linear gain dynamic range of the main power signals of the branch similar input combination and main signal combiner main circuit.

In an exemplary embodiment, the main signal and branch similar input combination combiner circuit is parallelly connected to outputs of two circuits, which are a distortion extraction adjustment amplifier circuit for analog distortion of a branch similar input combination in the branch similar input combiner circuit, or a distortion extraction adjustment amplifier circuit for analog digital distortion of branch similar input combination, or a distortion extraction adjustment amplifier circuit for digital distortion of branch similar input combination, and a corresponding input combination main signal time-delay adjustment circuit, or one analog input port and one digital input port in the two circuits and outputs of the two circuits through a branch-main combination input divider circuit or a branch-main combination digital input divider circuit and a branch-main combination output combiner circuit, to implement the main signal and branch similar input combination combiner circuit.

Since a branch similar input combination analog digital distortion circuit includes the main signal and the distorted signal, a branch similar input combination analog digital pre-distortion circuit or a branch similar input combination digital distortion circuit directly implements the main signal and branch similar input combination combiner circuit.

The branch similar input combiner circuit includes the branch similar input combination distortion extraction and adjustment amplifier circuit for analog distortion, the distortion extraction adjustment amplifier circuit for analog digital distortion of branch similar input combination, and the distortion extraction adjustment amplifier circuit for digital distortion of the branch similar input combination.

In the main signal and branch similar input combination combiner circuit, only one input combination main signal time-delay adjustment circuit is provided.

In an exemplary embodiment, the main signal and branch similar input cancellation combiner circuit is parallelly connected to inputs of two circuits, which are a distortion extraction adjustment amplifier circuit for analog pre-distortion of branch similar input cancellation in the branch similar input cancellation circuit, or a distortion extraction adjustment amplifier circuit for analog digital pre-distortion of branch similar input cancellation, or a distortion extraction adjustment amplifier circuit for digital pre-distortion of branch similar input cancellation, or a distortion extraction adjustment amplifier circuit of a branch similar input combination and main signal combined auxiliary circuit for branch similar input cancellation, and a corresponding input cancellation main signal time-delay adjustment circuit, or one analog input port and one digital input port in the two circuits and outputs of the two circuits through a branch-main cancellation input divider circuit or through a branch-main cancellation digital input divider circuit and a branch-main cancellation output combiner circuit, to implement the main signal and branch similar input cancellation combiner circuit.

The branch similar input cancellation circuit includes the distortion extraction adjustment amplifier circuit for analog pre-distortion of branch similar input cancellation, the distortion extraction adjustment amplifier circuit for analog digital pre-distortion of branch similar input cancellation, the distortion extraction adjustment amplifier circuit for digital pre-distortion of branch similar input cancellation, and the distortion extraction adjustment amplifier circuit of the branch similar input combination and main signal combined auxiliary circuit for branch similar input cancellation.

In the main signal and branch similar input cancellation combiner circuit, only one input cancellation main signal time-delay adjustment circuit is provided.

In an exemplary embodiment, the branch similar input combination and input cancellation combiner circuit therein is parallelly connected to the inputs of the two circuits, which are the branch similar input combiner circuit and the branch similar input cancellation circuit, or the digital input ports of the two circuits or one analog input port and one digital input port in the two circuits and the outputs of the two circuits through the branch-main combination or branch-main cancellation input divider circuit or through the branch-main combination or branch-main cancellation digital input divider circuit and the branch-main combination or branch-main cancellation output combiner circuit, to implement the branch similar input combination and input cancellation combiner circuit.

The branch similar input combiner circuit includes the branch similar input combination distortion extraction and adjustment amplifier circuit for analog distortion, the distortion extraction adjustment amplifier circuit for analog digital distortion of branch similar input combination, and the distortion extraction adjustment amplifier circuit for digital distortion of the branch similar input combination.

The branch similar input cancellation circuit includes a distortion extraction adjustment amplifier circuit for analog pre-distortion of branch similar input cancellation, a distortion extraction adjustment amplifier circuit for analog digital pre-distortion of branch similar input cancellation, a distortion extraction adjustment amplifier circuit for digital pre-distortion of branch similar input cancellation, and a distortion extraction adjustment amplifier circuit of a branch similar input combination and main signal combined auxiliary circuit for branch similar input cancellation.

In an exemplary embodiment, circuit features of the branch similar input combiner circuit are as follows: an output of a branch similar input combination analog distortion circuit, or an output of a branch similar input combination analog digital distortion circuit, or an output of a branch similar input combination digital distortion circuit is connected to a main input of an input combination coupling output load circuit or an input of an amplitude adjustment attenuation circuit of input combination, to implement an analog distortion branch similar input combination signal extraction circuit for analog distortion, or implement an analog digital distortion signal extraction circuit for analog digital distortion of branch similar input combination, or implement a digital distortion signal extraction circuit for digital distortion of branch similar input combination, and a main signal adjustment power amplifier circuit of input combination, an output of a branch similar input combination distortion extraction circuit for analog distortion, or an output of a distortion extraction circuit for analog digital distortion of branch similar input combination, or an output of a distortion extraction circuit for digital distortion of the branch similar input combination implemented by parallelly connecting the analog input ports of the corresponding two circuits or one digital input port and one analog input port in the two circuits and the outputs of the two circuits through an input combiner and output divider circuit or through an input combination digital input divider circuit and an input combination distortion output combiner circuit is connected to an input of a distortion adjustment power amplifier circuit of input combination, to implement the branch similar input combiner circuit having a function of a branch similar input combination distortion extraction and adjustment amplifier circuit for analog distortion, or having a function of a distortion extraction adjustment amplifier circuit for analog digital distortion of branch similar input combination, or having a function of a distortion extraction adjustment amplifier circuit for digital distortion of branch similar input combination, and by generating the distorted signal having input same-phase combination compensation, the branch similar input combiner circuit has the characteristic of compensating for the extension of the linear gain dynamic range of the main power signals among the Class C main power signals outputted by the Class C main power amplifier circuit that are less than the input combination equal-power point to have the main power signals with lower output power level.

An input of the input divider circuit of the input combination or the digital input divider circuit of the input combination in the branch similar input combiner circuit and an output of the distortion adjustment power amplifier circuit of the input combination respectively correspond to an input and an output of the branch similar input combination distortion extraction and adjustment amplifier circuit for analog distortion, or an input and an output of the distortion extraction adjustment amplifier circuit for analog digital distortion of branch similar input combination, or an input and an output of the distortion extraction adjustment amplifier circuit for digital distortion of the branch similar input combination.

The analog distortion circuit of the branch similar input combination is implemented by a low-power input combination branch power amplifier circuit or an input combination branch feed-forward power amplifier circuit and has, by generating the distorted signal with input same-phase combination compensation, to get the characteristic of compensating for extension of the linear gain dynamic range of main power signals among the Class C main power signals outputted by the Class C main power amplifier circuit that are less than the input combination equal-power point to have the main power signals with lower output power level.

The analog digital distortion circuit or digital pre-distortion circuit of the branch similar input combination through generating the distorted signal having input same-phase combination compensation, to get the characteristic of compensating for extension of the linear gain dynamic range of main power signals among the Class C main power signals outputted by the Class C main power amplifier circuit that are less than the input combination equal-power point to the main power signals with lower output power level, and is implemented by connecting an output of an input combination digital-to-analog conversion circuit and an input of a low-power input combination analog power amplifier circuit, wherein a feedback input of the analog digital distortion circuit or digital pre-distortion circuit of the branch similar input combination is connected and mounted to a feedback output of an input combination coupling feedback adjustment circuit on the output of the main power amplifier circuit, to implement the corresponding main signal and branch similar input combination combiner circuit having a function of the analog digital distortion circuit or digital pre-distortion circuit of the branch similar input combination.

In an exemplary embodiment, circuit features of the branch similar input cancellation circuit are as follows: an output of an analog pre-distortion circuit for branch similar input cancellation, or an output of a branch similar input cancellation analog digital pre-distortion circuit, or an output of a branch similar input cancellation digital pre-distortion circuit, or an output of a branch similar input combination and main signal combined auxiliary circuit for branch similar input cancellation is connected to a main input of a coupling output load circuit for input cancellation or an input of an amplitude adjustment attenuation circuit for input cancellation, to implement an analog pre-distortion signal extraction circuit for analog pre-distortion of branch similar input cancellation, or implement an analog digital pre-distortion signal extraction circuit for analog digital pre-distortion of branch similar input cancellation, or implement a digital pre-distortion signal extraction circuit for digital pre-distortion of branch similar input cancellation, or implement a signal extraction circuit of the branch similar input combination and main signal combined auxiliary circuit for branch similar input cancellation, and a main signal adjustment power amplifier circuit of input cancellation, an output of a distortion extraction circuit for analog pre-distortion of branch similar input cancellation, or an output of a distortion extraction circuit for analog digital pre-distortion of branch similar input cancellation, or an output of a distortion extraction circuit for digital pre-distortion of branch similar input cancellation, or an output of a distortion extraction circuit of the branch similar input combination and main signal combined auxiliary circuit for branch similar input cancellation are implemented by parallelly connecting the analog input ports of the corresponding two circuits or one digital input port and one analog input port in the two circuits and the outputs of the two circuits through an input cancellation input divider circuit or through an input cancellation digital input divider circuit and an input cancellation distortion output combiner circuit is connected to an input of a distortion adjustment power amplifier circuit for input cancellation, to implement the branch similar input cancellation circuit having a function of a distortion extraction adjustment amplifier circuit for analog pre-distortion of branch similar input cancellation, or having a function of a distortion extraction adjustment amplifier circuit for analog digital pre-distortion of branch similar input cancellation, or having a function of a distortion extraction adjustment amplifier circuit for digital pre-distortion of branch similar input cancellation, or having a function of a distortion extraction adjustment amplifier circuit of the branch similar input combination and main signal combined auxiliary circuit for branch similar input cancellation, and by generating the pre-distorted signal having input reversed-phase similar cancellation, the branch similar input cancellation circuit has the characteristic similar to that of the distorted signal greater than the input cancellation equal-power point in the Class C main power signal with the extended linear gain dynamic range of the main power signals of the branch similar input combination and main signal combiner main circuit.

An input of the input cancellation input divider circuit or the input cancellation digital input divider circuit in the branch similar input cancellation circuit and an output of the distortion adjustment power amplifier circuit for input cancellation are respectively correspond to an input and an output of the distortion extraction adjustment amplifier circuit for analog pre-distortion of branch similar input cancellation, or an input and an output of the distortion extraction adjustment amplifier circuit for analog digital pre-distortion of branch similar input cancellation, or an input and an output of the distortion extraction adjustment amplifier circuit for digital pre-distortion of branch similar input cancellation, or and input and an output of the distortion extraction adjustment amplifier circuit of the branch similar input combination and main signal combined auxiliary circuit for branch similar input cancellation.

The branch similar input cancellation circuit implemented by the analog pre-distortion circuit for branch similar input cancellation through a low-power input cancellation branch power amplifier circuit or an input cancellation branch feed-forward power amplifier circuit has, by generating the pre-distorted signal having input reversed-phase similar cancellation, the characteristic similar to that of the distorted signal greater than the input cancellation equal-power point in the Class C main power signal with the extended linear gain dynamic range of main power signals of the branch similar input combination and main signal combiner main circuit.

By replacing the main power amplifier circuit in the branch similar input combination and main signal combiner main circuit with a similar low-power Class C input first auxiliary power amplifier circuit, the branch similar input combination and main signal combined auxiliary circuit for branch similar input cancellation generates the pre-distorted signal having input reversed-phase similar cancellation, and has the characteristic similar to that of the distorted signal greater than the input cancellation equal-power point in the Class C main power signal with the extended linear gain dynamic range of the main power signals outputted by the branch similar input combination and main signal combiner main circuit.

The pre-distorted signal having input reversed-phase similar cancellation generated by the branch similar input cancellation analog digital pre-distortion circuit or the branch similar input cancellation digital pre-distortion circuit has the characteristic similar to that of the distorted signal greater than the input cancellation equal-power point in the Class C main power signal with the extended linear gain dynamic range of main power signals of the branch similar input combination and main signal combiner main circuit, and is implemented by connecting an output of an input cancellation digital-to-analog conversion circuit and an input of a low-power input cancellation analog power amplifier circuit, wherein a feedback input of the branch similar input cancellation analog digital pre-distortion circuit or the branch similar input cancellation digital pre-distortion circuit is connected and mounted to a feedback output of an input cancellation coupling feedback adjustment circuit on the output of the main power amplifier circuit, to implement the corresponding main signal and branch similar input cancellation combiner circuit having a function of the branch similar input cancellation analog digital pre-distortion circuit or the branch similar input cancellation digital pre-distortion circuit.

The input and another output of the input cancellation input divider circuit connected to the input of the input cancellation main signal adjustment power amplifier circuit in the branch similar input cancellation circuit are perhaps mounted in the input cancellation main signal time-delay adjustment circuit.

In an exemplary embodiment, the input combination or input cancellation main signal time-delay adjustment circuit is implemented by serially connecting an input combination or input cancellation time-delay circuit and an input combination or input cancellation adjustable attenuation circuit or an input combination or input cancellation amplitude adjustable circuit, and meets a main power signal requirement in the branch similar input combination and input cancellation combiner main circuit without generating a new distorted signal.

In an exemplary embodiment, through the combination input divider circuit or through the combination digital input divider circuit parallelly connected, the analog input ports of the two circuits, which are the branch similar input combination and input cancellation combiner main circuit and the branch similar output cancellation circuit, or the digital input ports of the two circuits or one analog input port and one digital input port in the two circuits in the two circuits are parallelly connected and to the outputs of the two circuits to the combination output coupling circuit, to implement the similar combination and cancellation power amplifier circuit having a function of the branch similar input combination cancellation and branch output cancellation combiner main circuit.

The branch similar output cancellation circuit outputs the distorted signal having output reversed-phase similar cancellation, and has the characteristic similar to that of the distorted signal greater than the output cancellation equal-power point in the Class C main power signal with the extended linear gain dynamic range of the main power signals of the branch similar input combination and input cancellation combiner main circuit.

The branch similar output cancellation circuit comprises a distortion extraction adjustment amplifier circuit for analog distortion of branch similar output cancellation, a distortion extraction adjustment amplifier circuit for analog digital distortion of branch similar output cancellation, a distortion extraction adjustment amplifier circuit for digital distortion of branch similar output cancellation, or a distortion extraction adjustment amplifier circuit of a branch similar input combination and input cancellation combined auxiliary circuit for branch similar output cancellation.

The output cancellation features of the output of the branch similar input combination cancellation and branch output cancellation combiner main circuit are as follows: when the linear ACPR value of the Class C main power signal with the extended linear gain dynamic range of the main power signals reaches above 40-45 dBC on the output of the branch similar input combination and input cancellation combiner main circuit, and when the time delays at the output cancellation equal-power point in the branch similar input combination cancellation and branch output cancellation combiner main circuit are equal or nearly equal, the amplitudes are equal or nearly equal, and the phase are opposite or nearly opposite, the distorted signal generated by the branch similar output cancellation circuit and having the output reversed-phase similar cancellation characteristic is similar to the distorted signal greater than the output cancellation equal-power point in the Class C main power signal with the extended linear gain dynamic range of the main power signals outputted by the branch similar input combination and input cancellation combiner main circuit, such that the distorted signal having output reversed-phase similar cancellation generated by the branch similar output cancellation circuit and the distorted signal greater than the output cancellation equal-power point in the Class C main power signal with the extended linear gain dynamic range of main power signals outputted by the main similar input combination and input cancellation combiner main circuit cancel out each other, thereby increasing the linear ACPR value of the Class C main power signal further extended by the main power signals outputted by the branch similar input combination cancellation and branch output cancellation combiner main circuit to more than 50-55 dBC, or the distorted signal having output reversed-phase equality cancellation generated by the branch similar output cancellation circuit and the distorted signal greater than the output cancellation equal-power point in the Class C main power signal with the extended linear gain dynamic range of the main power signals outputted by the main similar input combination and input cancellation combiner main circuit cancel out each other, the linear gain of the Class C output main power signal with the extended linear gain dynamic range of the main power signals is extended through the reverse compensation characteristic of the Class C main power signal with the extended linear gain dynamic range of the main power signals of the branch similar input combination and input cancellation combiner main circuit generated by the branch similar output cancellation circuit, to further extend to have the smaller output main power signal range, and the EVM value and the gain fluctuation are increased within the further extended linear gain dynamic range.

In an exemplary embodiment, in the branch similar input combination cancellation and branch output cancellation combiner main circuit, the features of the branch similar output cancellation circuit are as follows: an output of an analog distortion circuit for branch similar output cancellation, or an output of an analog branch similar output cancellation digital distortion circuit, or an output of a branch similar output cancellation digital distortion circuit, or an output of a branch similar input combination and input cancellation combined auxiliary circuit for branch similar output cancellation is connected to an input of a main circuit of a coupling output load circuit for output cancellation or an input of an amplitude adjustment attenuation circuit for output cancellation, to implement an analog distorted signal extraction circuit for branch similar output cancellation, or implement an analog digital distorted signal extraction circuit for branch similar output cancellation, or implement a branch similar output cancellation signal extraction circuit for digital distortion , or implement a signal extraction circuit of the branch similar input combination and input cancellation combined auxiliary circuit for branch similar output cancellation, and an output cancellation main signal adjustment power amplifier circuit; an output of a distortion extraction circuit for analog distortion of branch similar output cancellation, or an output of a distortion extraction circuit for analog digital distortion of branch similar output cancellation, or an output of a branch similar output cancellation distortion extraction circuit for digital distortion, or an output of a distortion extraction circuit of the branch similar input combination and input cancellation combined auxiliary circuit for branch similar output cancellation implement ed by parallelly connecting the analog input ports of the two circuits or one digital input port and one analog input port in the two circuits and the outputs of the two circuits through an output cancellation input divider circuit or an output cancellation digital input divider circuit and an output cancellation distortion output combiner circuit is connected to an input of an output cancellation distortion adjustment power amplifier circuit, to implement the branch similar output cancellation circuit having a function of a distortion extraction adjustment amplifier circuit for analog distortion of branch similar output cancellation, or having a function of a distortion extraction adjustment amplifier circuit for analog digital distortion of branch similar output cancellation, or having a function of a distortion extraction adjustment amplifier circuit for digital distortion of branch similar output cancellation, or having a function of a distortion extraction adjustment amplifier circuit of the branch similar input combination and input cancellation combined auxiliary circuit for branch similar output cancellation, and by outputting generating the distorted signal having output reversed-phase similar cancellation, the branch similar output cancellation circuit has the characteristic similar to that of the distorted signal greater than the output cancellation equal-power point in the Class C main power signal with the extended linear gain dynamic range of the main power signals of the branch similar input combination and input cancellation combiner main circuit.

The branch similar output cancellation circuit N and the branch similar input combination cancellation and branch output cancellation combiner main circuit are parallelly connected to the analog input ports of the two circuits or the digital input ports of the two circuits or one analog input port and one digital input port in the two circuits and the outputs of the two circuits through the combination input divider circuit N or the combination digital input divider circuit N and the combination output coupling circuit N, to the branch similar input combination cancellation and branch output cancellation N-1 combiner main circuit, wherein after the combination output coupling circuit N connected to the output of the branch similar output cancellation circuit is mounted to an output of a combination output coupling circuit N-1 connected to the output of the branch similar input cancellation circuit, the generated distorted signal having reversed-phase similar cancellation is similar to the distorted signal greater than the output cancellation equal-power point in the Class C main power signal with the extended linear gain dynamic range of the main power signals of the branch similar input combination cancellation and branch output cancellation N-1 combiner main circuit, and the branch similar output cancellation circuit is N, and so on, wherein N is a natural number greater than 1.

An input of the output cancellation input divider circuit N or output cancellation digital input divider circuit N and an output of the output cancellation distortion adjustment power amplifier circuit correspond to an input and an output of the branch similar input combination cancellation and branch output cancellation N-1 combiner main circuit.

The analog distortion circuit for branch similar output cancellation implemented by a low-power output cancellation branch power amplifier circuit or an output power branch feed-forward power amplifier circuit has, by generating the distorted signal having output reversed-phase similar cancellation, the characteristic similar to that of the distorted signal greater than the output cancellation equal-power point in the Class C main power signal with the extended linear gain dynamic range of the main power signals of the branch similar input combination and input cancellation combiner main circuit.

By replacing the main power amplifier circuit in the branch similar input combination and input cancellation combiner main circuit with a similar low-power Class C output first auxiliary power amplifier circuit, the branch similar input combination and input cancellation combined auxiliary circuit for branch similar output cancellation is implemented, generates the distorted signal having output reversed-phase similar cancellation, and has the characteristic similar to that of the distorted signal greater than the output cancellation equal-power point in the Class C main power signal with the extended linear gain dynamic range of the main power signals of the branch similar input combination and input cancellation combiner main circuit.

Or by replacing a main power amplifier circuit in the branch similar input combination cancellation and branch output cancellation N-1 combiner main circuit with a similar low-power Class C output Nth auxiliary power amplifier circuit, a branch similar input combination cancellation and branch output cancellation N-1 combined auxiliary circuit for branch similar output cancellation is implemented, generates the distorted signal having output reversed-phase similar cancellation, and has the characteristic similar to that of the distorted signal greater than the output cancellation equal-power point in the Class C main power signal with the extended linear gain dynamic range of the main power signals of the branch similar input combination cancellation and branch output cancellation N-1 combiner main circuit, wherein N is a natural number greater than 1.

The analog branch similar output cancellation digital distortion circuit or the branch similar output cancellation digital distortion circuit generates the distorted signal having output reversed-phase similar cancellation, has the characteristic similar to that of the distorted signal greater than the output cancellation equal-power point in the Class C main power signal with the extended linear gain dynamic range of the main power signals of the branch similar input combination and input cancellation combiner main circuit, and is implemented by connecting an output of an output cancellation digital-to-analog conversion circuit and an input of a low-power output cancellation analog power amplifier circuit, wherein a feedback input of the analog digital distortion circuit or branch similar output cancellation digital distortion circuit is connected and mounted to a feedback output of an output cancellation coupling feedback adjustment circuit on the output of the branch similar input combination cancellation and branch output cancellation combiner main circuit, to implement the analog branch similar output cancellation digital distortion circuit or the branch similar output cancellation digital distortion circuit.

In the branch similar output cancellation circuit in the branch similar input combination cancellation and branch output cancellation combiner main circuit, the input and another output of the output cancellation input divider circuit connected to an input of the output cancellation main signal adjustment power amplifier circuit are perhaps mounted in the input combination or input cancellation main signal time-delay adjustment circuit in the branch similar input combination cancellation and branch output cancellation combiner main circuit.

In an exemplary embodiment, the main power output of the feed-forward distortion extraction circuit of the branch similar input combination and input cancellation combiner main circuit is connected to the main power input of the main feed-forward output cancellation circuit, and the distortion output of the feed-forward distortion extraction circuit of the branch similar input combination and input cancellation combiner main circuit is connected to the distortion input of the main feed-forward output cancellation circuit, to implement the similar combination and cancellation power amplifier circuit having a function of the branch similar input combination cancellation and feed-forward output cancellation series circuit.

In the branch similar input combination cancellation and feed-forward output cancellation series circuit, features of the feed-forward distortion extraction circuit of the branch similar input combination and input cancellation combiner main circuit are as follows: by connecting the output of the branch similar input combination and input cancellation combiner main circuit and the input of the main circuit of the main feed-forward input coupling circuit, a feed-forward signal extraction circuit of the branch similar input combination and input cancellation combiner main circuit is implemented, and is parallely connected, with a feed-forward main circuit main signal adjustment power amplifier circuit and a feed-forward distortion output combiner circuit, to analog input ports of the two circuits or one digital input port and one analog input port in the two circuits and outputs of the two circuits through a feed-forward input divider circuit or through a feed-forward digital input divider circuit and a feed-forward distortion output combiner circuit, to implement the feed-forward distortion extraction circuit of the branch similar input combination and input cancellation combiner main circuit, wherein a coupling output of the main feed-forward input coupling circuit is an output of the feed-forward signal extraction circuit of the branch similar input combination and input cancellation combiner main circuit, and an analog input port of the feed-forward input divider circuit or a digital input port of the feed-forward digital input divider circuit, an output of the main circuit of the main feed-forward input coupling circuit, and an output of the feed-forward distortion output combiner circuit are an analog/Digital input port, main power output, and distortion output corresponding to the feed-forward distortion extraction circuit of the branch similar input combination and input cancellation combiner main circuit.

In the branch similar input combination cancellation and feed-forward output cancellation series circuit, the main feed-forward output cancellation circuit is implemented by connecting a main input of a feed-forward cancellation coupling circuit and an output of the feed-forward main time-delay circuit and connecting a coupling input of the feed-forward cancellation coupling circuit and an output of the feed-forward distortion adjustment power amplifier circuit, wherein an input of the feed-forward main time-delay circuit is the main power input of the main feed-forward output cancellation circuit, an input of the feed-forward distortion adjustment power amplifier circuit is the distortion input of the main feed-forward output cancellation circuit, and an output of the feed-forward cancellation coupling circuit is the output of the main feed-forward output cancellation circuit.

In the branch similar input combination cancellation and feed-forward output cancellation series circuit, from the main input of the main feed-forward input coupling circuit to the output of the feed-forward cancellation coupling circuit via the feed-forward main time-delay circuit and via the feed-forward distortion adjustment power amplifier circuit connected to the output of the feed-forward distortion output combiner circuit, the main feed-forward combination cancellation circuit from the input of the main feed-forward input coupling circuit to the output of the feed-forward cancellation coupling circuit is implemented.

The input and another output of the feed-forward input divider circuit connected to the input of the feed-forward main circuit main signal adjustment power amplifier circuit in the feed-forward distortion extraction circuit of the branch similar input combination and input cancellation combiner main circuit in the branch similar input combination cancellation and feed-forward output cancellation series circuit are perhaps mounted in the input combination or input cancellation main signal time-delay adjustment circuit.

The same type cancellation features of the output of the branch similar input combination cancellation and feed-forward output cancellation series circuit are as follows: when the Class C main power linear ACPR of the extended linear gain dynamic range of the main power signals reaches above 40-45 dBC on the output of the branch similar input combination and input cancellation combiner main circuit, on the output of the branch similar input combination cancellation and feed-forward output cancellation series circuit, when the time delays equal to the feed-forward cancellation equal-power point are equal or nearly equal, the amplitudes are equal or nearly equal, and the phase are opposite or nearly opposite, the distorted signal in the Class C main power signal with the extended linear gain dynamic range of the main power signals outputted by the branch similar input combination and input cancellation combiner main circuit is extracted by the distortion output of the feed-forward distortion extraction circuit of the branch similar input combination and input cancellation combiner main circuit and the distorted signal in the Class C main power signal with the extended linear gain dynamic range of main power signals outputted by the main power output of the feed-forward distortion extraction circuit of the branch similar input combination and input cancellation combiner main circuit are the same type of distorted signals, on the output of the main feed-forward combination cancellation circuit, when the time delays equal to the feed-forward cancellation equal-power point are equal or nearly equal, the amplitudes are equal or nearly equal, and the phase are opposite or nearly opposite, the same type distortion signal cancellation of the distorted signal in the Class C main power signal with the extended linear gain dynamic range of the main power signals outputted by the branch similar input combination and input cancellation combiner main circuit is realized, and the linear gain dynamic range of the Class C output main power signal with the extended linear gain dynamic range of the main power signals is further extended to reach the linear gain dynamic range of the Class AB output main power, and the EVM value and the gain fluctuation are increased within the linear gain dynamic range that has been extended, thereby causing the Class C total linear dynamic range of Class AB output main power signals outputted by the branch similar input combination cancellation and feed-forward output cancellation series circuit to reach the linear ACPR value of the Class AB output main power signal to more than 50-55 dBC, and improving the overall efficiency.

In an exemplary embodiment, the combination input divider circuit or the parallel input divider circuit, the branch-main combination or branch-main cancellation input divider circuit, the input combination or input cancellation input divider circuit, the output cancellation input divider circuit, and the feed-forward input divider circuit are implemented by divider circuits, or coupling circuits, or other circuits achieving a division function, and meet power capacity requirements in the corresponding circuits and requirements of not generating new distorted signals, respectively.

The combination digital input divider circuit, the parallel digital input divider circuit, the feed-forward digital input divider circuit, the input combination digital input divider circuit, the input cancellation digital input divider circuit, and the output cancellation digital input divider circuit are implemented by digital divider circuits and meet digital signal requirements; the two outputs are digital ends, or one of the two outputs is a digital signal output, and the other digital output is an analog output by connecting the output of the digital-to-analog conversion circuit; and power capacity requirements in the corresponding circuits and requirements of not generating new distortion are met respectively.

The combination output coupling circuit, a load coupling circuit, a feedback coupling circuit, the main feed-forward input coupling circuit, and the feed-forward cancellation coupling circuit are implemented by coupling circuits or other circuits achieving a coupling function, and meet power capacity requirements in the corresponding circuits and requirements of not generating new distortion, respectively.

The parallel output combiner circuit, the branch-main combination or branch-main cancellation output combiner circuit, the input combination or input cancellation distortion output combiner circuit, the output cancellation distortion output combiner circuit, and the feed-forward distortion output combiner circuit are implemented by combiner circuits or coupling circuits, or other circuits achieving a combination function, and meet power capacity requirements in the corresponding circuits and requirements of not generating new distortion, respectively.

The input combination or input cancellation main signal adjustment power amplifier circuit, the output cancellation main signal adjustment power amplifier circuit, and the feed-forward main circuit main signal adjustment power amplifier circuit are implemented by serially connecting an input combination or input cancellation or output cancellation or feed-forward main circuit amplitude modulation circuit and an input combination or input cancellation or output cancellation or feed-forward main circuit adjustment circuit implemented by input combination or input cancellation or output cancellation or feed-forward main circuit phase modulation, to serially connect an input combination or input cancellation or output cancellation or feed-forward main circuit main signal adjustment power amplifier circuit, and meet main signal power capacity requirements in the corresponding circuits, as well as requirements of not generating new distortion.

The output cancellation distortion adjustment power amplifier circuit, the input combination or input cancellation distortion adjustment power amplifier circuit, and the feed-forward distortion adjustment power amplifier circuit are implemented by serially connecting an input combination or input cancellation or output cancellation or feed-forward amplitude modulation circuit and an input combination or input cancellation or output cancellation or feed-forward adjustment circuit implemented by an input combination or input cancellation or output cancellation or feed-forward phase modulation circuit, and then serially connecting an input combination or input cancellation or output cancellation or feed-forward distortion signal power amplifier circuit, and meet corresponding power capacity requirements of the corresponding distorted signal in the corresponding circuits, as well as requirements of not generating new distortion.

The input combination or input cancellation main signal time-delay adjustment circuit and the output cancellation main signal time-delay adjustment circuit are implemented by serially connecting an input combination or input cancellation amplitude adjustable circuit or an output cancellation amplitude modulation circuit and an input combination or input cancellation adjustment circuit or an output cancellation adjustment circuit implemented by an input combination or input cancellation phase modulation circuit or an output cancellation phase modulation circuit, and then serially connecting an input combination or input cancellation or output cancellation time-delay circuit, and meet power capacity requirements of the corresponding circuits and requirements of not generating new distortion.

The input combination or input cancellation or output cancellation coupling output load circuit is implemented by connecting a main output of the input combination or input cancellation or output cancellation load coupling circuit and an ungrounded end of an input combination or input cancellation or output cancellation load resistor, and meets power capacity requirements of the corresponding circuits and requirements of not generating new distortion.

The input combination or input cancellation or output cancellation coupling feedback adjustment circuit is implemented by connecting the coupling output of the input combination or input cancellation or output cancellation feedback coupling circuit and an input combination or input cancellation or output cancellation feedback signal adjustment power amplifier circuit, wherein the input combination or input cancellation or output cancellation feedback signal adjustment power amplifier circuit is implemented by connecting the input combination or input cancellation or output cancellation amplitude modulation circuit and an input combination or input cancellation or output cancellation feedback signal power amplifier circuit, and meets power capacity requirements of the corresponding circuits and requirements of not generating new distortion.

In an exemplary embodiment, a similar combination and cancellation envelope tracking (ET) power amplifier circuit is implemented by connecting with an ET circuit.

The ET circuit is implemented by respectively connecting an input of an envelope tracking control circuit and an input of an ET main signal adjustment time-delay circuit to two outputs of an ET divider circuit, wherein the envelope tracking control circuit is implemented by connecting an output of an envelope tracking signal processing circuit and an envelope input of a control power supply circuit, and an input of an ET input divider circuit, power supply outputs and power supply inputs of a plurality of different voltages of the control power supply circuit in the envelope tracking control circuit, and a main signal output of the ET main signal adjustment time-delay circuit respectively are an input and power supply output of the ET circuit, and a power supply input and a main signal output.

The similar combination and cancellation ET power amplifier circuit is implemented by connecting power supply outputs of a plurality of different and same voltages of the ET circuit and drain power supply ends of a plurality of different power amplifier circuits of a plurality of different and same corresponding voltages in the similar combination and cancellation power amplifier circuit, connecting the power supply input of the ET circuit and a power supply, and connecting the main signal output of the ET circuit and an input of the similar combination and cancellation power amplifier circuit.

In the similar combination and cancellation ET power amplifier circuit, ET control power supply and power features of the power amplifier circuit of the branch similar combination input cancellation combiner main circuit are as follows: through segment selection of an envelope tracking signal and according to a relationship between a drain voltage and an output power, a corresponding output main power is reached under different drain voltage combinations in the similar combination and cancellation power amplifier circuit corresponding to each segment region of the envelope tracking signal.

When the switching of the envelope tracking signal between the segments needs to be re-adjusted to cause the linear ACPR value of the output main power signal of the similar combination and cancellation power amplifier circuit achieving the input combination and input cancellation features of the output of the branch similar input combination and input cancellation combiner main circuit, or achieving the output cancellation features of the output of the branch similar input combination cancellation and branch output cancellation combiner main circuit, or achieving the same type cancellation features of the output of the branch similar input combination cancellation and feed-forward output cancellation series main circuit to reach more than 55 dBc again, and overall efficiency is improved, a sum of a time delay consumed, a signal processing time delay of the envelope tracking signal in the envelope tracking control circuit, and a time delay required for the control power supply circuit to change the voltages is equal to a time delay of the main signal adjustment time-delay circuit, or a time delay consumed under a condition of known envelope tracking signal segment region information is equally equal to a sum of an envelope signal processing time delay of the envelope tracking control circuit and a time delay required for the control power supply to change the voltages, and is equal to a time delay of the ET main signal adjustment time-delay circuit.

Features of the relationship between the drain voltage and the output power are as follows: when an output power of the similar combination and cancellation power amplifier circuit is at one of power values from a high power to a low power, the drain voltages of the plurality of power amplifier circuits are able to be reduced from an original high voltage combination to a low voltage drain voltage combination at one of the power values; and when the output power of the similar combination and cancellation power amplifier circuit is at one of the power values from the low power to the high power, the drain voltages of the plurality of power amplifier circuits shall be increased from an original low voltage combination to a high voltage combination corresponding to one of the power values of the high power, and then the output power is able to change from the low power to one of the power values of the high power.

The present disclosure may be applied to a signal power amplification device in a wireless communication device, a wired communication device, an audio amplification device, a radio frequency power supply device, etc.

The present disclosure has the following beneficial effects. For the branch similar input combination and main signal combiner main circuit, the linear ACPR value of the Class C-like main power signal with extended linear gain is increased to above 30-35 dBc , and meanwhile, for the branch similar input combination and input cancellation combiner main circuit, the linear ACPR value of the Class C-like main power signal with extended linear gain is also increased to above 40-45 dBC.

### BRIEF DESCRIPTION OF DRAWINGS

The accompanying drawings constituting a part of the present disclosure are used to provide a further understanding of the present disclosure. The exemplary embodiments of the present disclosure and the description thereof are used to explain the present disclosure, but do not constitute improper limitations to the present disclosure. In the drawings:
Fig. 1 is a schematic diagram of a branch similar input combination and main signal combiner main circuit according to the present disclosure.
Fig. 2 is a schematic diagram of a branch similar input combination and input cancellation combiner main circuit according to the present disclosure.
Fig. 3 is a schematic diagram of a branch similar input combination and input cancellation combiner main circuit according to the present disclosure.
Fig. 4 is a schematic diagram of another branch similar input combination and input cancellation combiner main circuit according to the present disclosure.
Fig. 5 is a schematic diagram of a branch similar input combination cancellation and branch output cancellation combiner main circuit according to the present disclosure.
Fig. 6 is a schematic diagram of a branch similar input combination cancellation and branch output cancellation combiner main circuit according to the present disclosure.
Fig. 7 is a schematic diagram of a branch similar input combination cancellation and feed-forward output cancellation series circuit according to the present disclosure.

### DETAILED DESCRIPTION

The technical solutions in the embodiments of the present disclosure will be clearly and completely described below in combination with the drawings in the embodiments of the present disclosure. It is apparent that the described embodiments are only part of the embodiments of the present disclosure, not all the embodiments. The following description of at least one exemplary embodiment is merely illustrative in nature and is not intended to limit the present disclosure and application or use thereof in any way. Based on the embodiments in the present disclosure, all other embodiments obtained by those of ordinary skill in the art without creative work shall fall within the protection scope of the present disclosure.

It is to be noted that, terms used herein are intended to describe specific implementations only and are not intended to limit exemplary embodiments according to the present disclosure. As used herein, unless the context clearly indicates otherwise, a singular form is also intended to include a plural form. In addition, it is further understood that when the terms "including" and/or "comprising" are used in this specification, the terms indicate the presence of features, steps, operations, devices, components, and/or a combination thereof.

Unless specifically stated otherwise, the relative arrangement, numerical expressions, and numerical values of the components and steps set forth in these embodiments do not limit the scope of the present disclosure. In addition, it is to be understood that the dimension of each portion shown in the drawings is not drawn to actual scale for ease of description. Techniques, methods, and devices known to those of ordinary skill in the relevant art may not be discussed in detail, but where appropriate, such techniques, methods, and devices should be considered as a part of the specification. In all examples shown and discussed herein, any specific value should be construed as illustrative merely and not as limitations. Accordingly, other examples of the exemplary embodiments may have different values. It is to be noted that similar numbers and letters indicate similar items in the following drawings, so once a certain item is defined in one drawing, no further discussions are required for same in the subsequent drawings.

Next, a similar combination and cancellation power amplifier circuit of the present disclosure is described below through the following embodiments.

### Embodiment 1

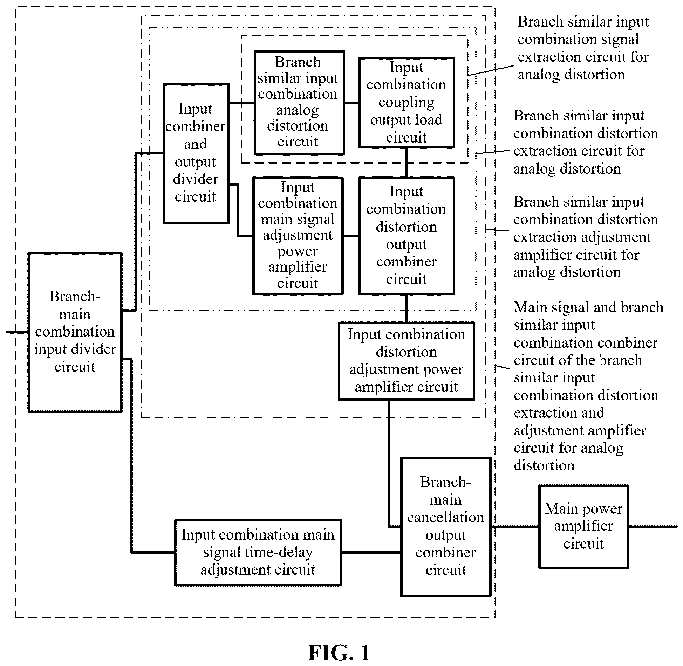

As shown in Fig. 1, in Embodiment 1, a specific implementation is to provide a branch similar input combination and main signal combiner main circuit in a similar combination and cancellation power amplifier circuit. The branch similar input combination and main signal combiner main circuit is implemented by connecting an output of a main signal and branch similar input combination combiner circuit of the distortion extraction adjustment amplifier circuit for analog distortionbranch similar input combination distortion extraction and adjustment amplifier circuit for analog distortion and an input of a main power amplifier circuit.

The main signal and branch similar input combination combiner circuit of the distortion extraction adjustment amplifier circuit for analog distortion is connected to inputs of two circuits, which are the branch similar input combination distortion extraction and adjustment amplifier circuit for analog distortion and an input combination main signal time-delay adjustment circuit, and outputs of the two circuits through a branch-main combination input divider circuit and a branch-main combination output combiner circuit, to implement a main signal and branch similar input combination combiner circuit having a function of the main signal and branch similar input combination combiner circuit of the distortion extraction adjustment amplifier circuit for analog distortion.

An output of a branch similar input combination analog distortion circuit is connected to a main input of an input combination coupling output load circuit or an input of an input combination amplitude modulation attenuation circuit, an implemented branch similar input combination signal extraction circuit for analog distortion and an input combination main signal adjustment power amplifier circuit are connected to the inputs of the corresponding two circuits and the outputs of the two circuits through an input combiner and output divider circuit and an input combination distortion output combiner circuit, and an output of an implemented branch similar input combination distortion extraction circuit for analog distortion is connected to an input of an input combination distortion adjustment power amplifier circuit, to implement a branch similar input combiner circuit having a function of the branch similar input combination distortion extraction and adjustment amplifier circuit for analog distortion.

The branch-main combination input divider circuit and the input combiner and output divider circuit are implemented by divider circuits, or coupling circuits, or other circuits achieving a division function, and meet power capacity requirements in the corresponding circuits and requirements of not generating new distorted signals, respectively.

The branch-main cancellation output combiner circuit and the input combination distortion output combiner circuit are implemented by combiner circuits or coupling circuits, or other circuits achieving a combination function, and meet power capacity requirements in the corresponding circuits and requirements of not generating new distortion, respectively.

The input combination main signal adjustment power amplifier circuit is implemented by serially connecting an amplitude modulation circuit and an adjustment circuit implemented through phase modulation and then serially connecting a main signal power amplifier circuit, and meets main signal power capacity requirements in the corresponding circuits, as well as requirements of not generating new distortion.

The input combination distortion adjustment power amplifier circuit is implemented by serially connecting the amplitude modulation circuit and the adjustment circuit implemented by a phase modulation circuit, and then serially connecting a distorted signal power amplifier circuit, and meets corresponding power capacity requirements of the corresponding distorted signal in the corresponding circuits, as well as requirements of not generating new distortion.

The input combination main signal time-delay adjustment circuit is implemented by serially connecting the amplitude modulation circuit and the adjustment circuit implemented by the phase modulation circuit or an adjustment circuit implemented by the amplitude modulation circuit, and then serially connecting a main signal time-delay circuit, and meets power capacity requirements of the corresponding circuits and requirements of not generating new distortion.

The input combination coupling output load circuit is implemented by connecting a main input of an input combination load coupling circuit and an ungrounded end of an input combination load resistor, and the main input and a coupling output of the input combination load coupling circuit respectively are a main input and output of the branch input combination coupling output load circuit. The output of the branch input combination coupling output load circuit is an output of a signal extraction circuit for analog pre-distortion of branch similar input combination.

The branch similar input combination analog distortion circuitis implemented by a low-power branch power amplifier circuit with input combination or a branch feed-forward power amplifier circuit with input combination, and generates a distorted signal with input same-phase combination compensation. This compensation extends a linear gain dynamic range of main power signals, among Class C main power signals outputted by a Class C main power amplifier circuit and below the input combination equal-power point, to main power signals with lower output power level.

The main power amplifier circuit is the Class C power amplifier circuit, which is implemented by a single power amplifier circuit or by a plurality of power amplifier circuits through combination or by combining impedance transformation networks. The main power amplifier circuit is a single-stage or multi-stage power amplifier circuit.

Embodiment 1 has the following beneficial effects. At the input combination equal-power point in a combiner main circuit of the branch similar input combination distortion extraction and adjustment amplifier circuit for analog distortion and the main signal, when time delays are equal or nearly equal, amplitudes are equal or nearly equal, and phase of the two circuits in the combiner main circuit of the branch similar input combination distortion extraction and adjustment amplifier circuit for analog distortion and the main signal are within a range from 0 degree to 45 degrees, in a main signal branch similar input combination series circuit, when the distorted signal with input same-phase combination compensation outputted by the branch similar input combiner circuit and a distorted signal having input same-phase combination compensation generated on an output of a combiner circuit of the main signal and the branch similar input combination distortion extraction and adjustment amplifier circuit for analog distortion have the characteristic of compensating for the extension of the linear gain dynamic range of the main power signals among the Class C main power signals outputted by the main power amplifier circuit that are less than the input combination equal-power point to the main power signals with lower output power level, and on the output of the combiner main circuit of the branch similar input combination distortion extraction and adjustment amplifier circuit for analog distortion and the main signal, when the time delays equal to the input combination equal-power point are equal, the amplitudes are equal or nearly equal, and the phase of the two circuits, which are the branch similar input combination distortion extraction and adjustment amplifier circuit for analog distortion and the input combination main signal time-delay adjustment circuit, are within the range from 0 degree to 45 degrees, when the phase of the two circuits are at some values within the range from 0 degree to 45 degrees, for example, at about 20 degrees, an optimal combination compensation effect of the distorted signal having input same-phase combination compensation generated by the branch similar input combination distortion extraction and adjustment amplifier circuit for analog distortion and the linear gain dynamic range of the Class C main power signals outputted by the Class C main power amplifier circuit extended to the smaller main power signals can be realized, and an EVM value and a gain fluctuation are increased within the linear gain dynamic range that has been extended to the main power signals with lower output power level, thereby increasing a linear ACPR value of the Class C main power signal with the extended linear gain dynamic range of the main power signals of the combiner main circuit of the branch similar input combination distortion extraction and adjustment amplifier circuit for analog distortion to above 30-35 dBc.

### Embodiment 2

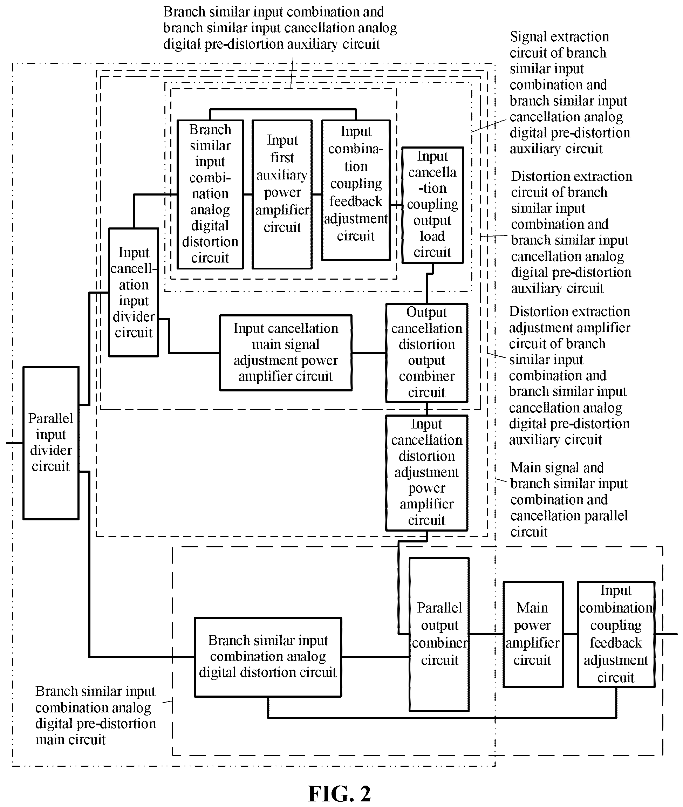

As shown in Fig. 2, a specific implementation of Embodiment 2 of the present disclosure is as follows.

A similar combination and cancellation power amplifier circuit is provided. A branch similar input combination and input cancellation combiner main circuit is implemented by connecting an output of a main signal and branch similar input combination and cancellation parallel circuit and a main power amplifier circuit.

The main signal and branch similar input combination and cancellation parallel circuit is implemented by parallelly connecting inputs of two circuits, which are a branch similar input combination analog digital distortion circuit and a distortion extraction adjustment amplifier circuit of an auxiliary circuit for analog digital distortion of branch similar input combination of branch similar input cancellation, and outputs of the two circuits through a parallel input divider circuit and a parallel output combiner circuit. An input of the parallel input divider circuit and an output of the parallel output combiner circuit respectively are a corresponding input and output of the main signal and branch similar input combination and cancellation parallel circuit.

The branch similar input combination analog digital pre-distortion circuit has, by generating a distorted signal having input same-phase compensation, a characteristic of compensating for extension of a linear gain dynamic range of main power signals among Class C main power signals outputted by a Class C main power amplifier circuit that are less than an input combination equal-power point to main power signals with lower output power level, and is implemented by connecting an output of an input combination digital-to-analog conversion circuit and an input of a low-power input combination analog power amplifier circuit. A feedback input of the analog digital pre-distortion circuit is connected and mounted to a feedback output of an input combination coupling feedback adjustment circuit on the output of the main power amplifier circuit, to implement a main signal and branch similar input combination combiner circuit having a function of the branch similar input combination analog digital distortion circuit.

An output of the branch similar input combination analog digital distortion circuit is connected to the main power amplifier circuit, the output of the main power amplifier circuit is connected to a main input of an input cancellation coupling feedback adjustment circuit, and a coupling output of the input cancellation coupling feedback adjustment circuit is connected to a feedback input of the branch similar input combination analog digital distortion circuit, to implement a main circuit for analog digital distortion of branch similar input combination having a function of the main circuit for analog digital distortion of branch similar input combination.

An output of the auxiliary circuit for analog digital distortion of branch similar input combination of branch similar input cancellation is connected to a main input of an input cancellation coupling output load circuit or an input of an input cancellation amplitude modulation attenuation circuit, to implement a signal extraction circuit of the auxiliary circuit for analog digital distortion of branch similar input combination of branch similar input cancellation, and an input cancellation main signal adjustment power amplifier circuit, and through an input cancellation input divider circuit and an input cancellation distortion output combiner circuit, by parallelly connecting the inputs of the corresponding two circuits and the outputs of the two circuits, an output of a distortion extraction circuit of the auxiliary circuit for analog digital distortion of branch similar input combination of branch similar input cancellation is connected to an input of an input cancellation distortion adjustment power amplifier circuit, to implement a distortion extraction adjustment amplifier circuit of the auxiliary circuit for analog digital distortion of branch similar input combination of branch similar input cancellation.

By replacing a main power amplifier circuit in a main circuit for analog digital distortion of branch similar input combination with a similar low-power Class C input first auxiliary power amplifier circuit, the auxiliary circuit for analog digital distortion of branch similar input combination of branch similar input cancellation is implemented, and has a characteristic similar to that of the distorted signal greater than an input cancellation equal-power point in the Class C main power signal with the extended linear gain dynamic range of the main power signals outputted by the main circuit for analog digital distortion of branch similar input combination.

The input cancellation coupling output load circuit is implemented by connecting a main input of an input cancellation load coupling circuit and an ungrounded end of an input cancellation load resistor, and the main input and a coupling output of the input cancellation load coupling circuit respectively are a main input and output of the branch input cancellation coupling output load circuit. The output of the branch input cancellation coupling output load circuit is the output of the signal extraction circuit of the auxiliary circuit for analog digital distortion of branch similar input combination of branch similar input cancellation.

The Parallel input divider circuit and the input cancellation input divider circuit are implemented by divider circuits, or coupling circuits, or other circuits achieving a division function, and meet power capacity requirements in the corresponding circuits and requirements of not generating new distorted signals, respectively.

The parallel output combiner circuit and the input cancellation distortion output combiner circuit are implemented by combiner circuits or coupling circuits, or other circuits achieving a combination function, and meet power capacity requirements in the corresponding circuits and requirements of not generating new distortion, respectively.

The input cancellation main signal adjustment power amplifier circuit is implemented by serially connecting an amplitude modulation circuit and an adjustment circuit implemented through phase modulation and then serially connecting a main signal power amplifier circuit, and meets main signal power capacity requirements in the corresponding circuits, as well as requirements of not generating new distortion.

The input cancellation distortion adjustment power amplifier circuit is implemented by serially connecting the amplitude modulation circuit and the adjustment circuit implementd by a phase modulation circuit, and then serially connecting a distorted signal power amplifier circuit, and meets corresponding power capacity requirements of the corresponding distorted signal in the corresponding circuits, as well as requirements of not generating new distortion.

The input cancellation coupling feedback adjustment circuit and the input combination coupling feedback adjustment circuit are implemented by connecting the coupling output of the feedback coupling circuit and the feedback signal adjustment power amplifier circuit. The feedback signal adjustment power amplifier circuit is implemented by connecting the amplitude modulation circuit and the feedback signal power amplifier circuit, or implemented by the amplitude modulation circuit.

The main power amplifier circuit in the branch similar input combination and input cancellation combiner main circuit is the Class C power amplifier circuit, which is implemented by a single power amplifier circuit or by a plurality of power amplifier circuits through combination or by combining impedance transformation networks. The main power amplifier circuit is a single or multi-stage power amplifier circuit.

Embodiment 2 has the following beneficial effects. The combination and cancellation features of the output of the branch similar input combination and input cancellation combiner main circuit are as follows: at the input combination equal-power point in the branch similar input combination and main signal combiner main circuit and the input cancellation equal-power point in the branch similar input combination and input cancellation combiner main circuit, when the time delays are equal or nearly equal, the amplitudes are equal or nearly equal, and the phase of the two circuits in the branch similar input combination and main signal combiner main circuit are within the range from 0 degree to 45 degrees, and the phase of the branch similar input combination and input cancellation combiner main circuit are opposite or nearly opposite, in the Main signal and branch similar input combination and cancellation parallel circuit meeting the above conditions, the distorted signal having input same-phase combination compensation outputted by the branch similar input combiner circuit and the pre-distorted signal having input reversed-phase similar cancellation outputted by the branch similar input cancellation circuit are generated on the output of the main signal and branch similar input combination and cancellation parallel circuit, to implement the combination cancellation mixed distorted signal.

In the combination cancellation mixed distorted signal, when the distorted signal having input same-phase combination compensation outputted by the branch similar input combiner circuit has the characteristic of compensating for the extension of the linear gain dynamic range of the main power signals among the Class C main power signals outputted by the Class C main power amplifier circuit that are less than the input combination equal-power point to the main power signals with lower output power level, and on the output of the branch similar input combination and main signal combiner main circuit in the branch similar input combination and input cancellation combiner main circuit, when the time delays equal to the input combination equal-power point are equal, the amplitudes are equal or nearly equal, and the phase of the two circuits are within the range from 0 degree to 45 degrees, the distorted signal having same-phase combination compensation outputted by the branch similar input combiner circuit and the compensation extension of the linear gain dynamic range of the main power signals among the Class C main power signals outputted by the Class C main power amplifier circuit that are less than the input combination equal-power point to the main power signals with lower output power level are realized, and the EVM value and the gain fluctuation are increased within the linear gain dynamic range that has been extended to the main power signals with lower output power level, thereby increasing the linear ACPR value of the Class C main power signal with the extended linear gain dynamic range of the main power signals of the branch similar input combination and main signal combiner main circuit to above 30-35 dBc.

When the branch similar input combiner main circuit reaches a range in which the linear gain dynamic range of the Class C main power signals is extended, the linear ACPR value of the outputted Class C main power signal reaches above 30-35 dBc, and the pre-distorted signal having input reversed-phase similar cancellation generated by the branch similar input cancellation circuit in the combination cancellation mixed distorted signal has the characteristic similar to that of the distorted signal greater than the input cancellation equal-power point in the Class C main power signal with the extended linear gain dynamic range of main power signals of the branch similar input combination and main signal combiner main circuit, and on the output of the branch similar input combination and input cancellation combiner main circuit, when the time delays equal to the input cancellation equal-power point are equal or nearly equal, the amplitudes are equal or nearly equal, and the phase are opposite or nearly opposite, the reversed-phase similar cancellation between the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, thereby increasing the linear ACPR value of the Class C main power signal outputted by the branch similar input combination and input cancellation combiner main circuit to above 40-45 dBC. Or the reversed-phase similar cancellation between the pre-distorted signal having reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, the linear gain dynamic range of the Class C output main power signals is extended to the main power signals with lower output power level, and the EVM value and the gain fluctuation are increased within the linear gain dynamic range that has been extended to the main power signals with lower output power level, thereby increasing the linear ACPR value of the Class C main power signal with the extended linear gain dynamic range of the main power signals of the branch similar input combination and input cancellation combiner main circuit to above 40-45 dBC. Furthermore, the overall efficiency of the similar combination and cancellation power amplifier circuit is improved through a higher linear ACPR value.

A similarity degree and synchronization accuracy of the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit determine the effect of realizing the reversed-phase similar cancellation between the pre-distorted signal having reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit.

### Embodiment 3

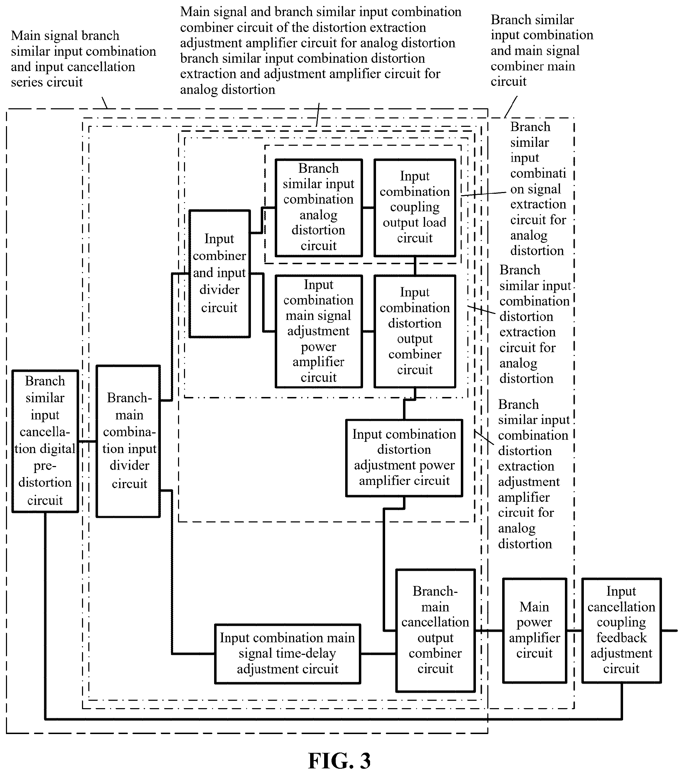

As shown in Fig. 3, a specific implementation of Embodiment 3 of the present disclosure is as follows.

A similar combination and cancellation power amplifier circuit is provided. An output of a main signal branch similar input combination and input cancellation series circuit is connected to a main power amplifier circuit, an output of the main power amplifier circuit is connected to an input of an input cancellation coupling feedback adjustment circuit, and a coupling output of a main signal branch similar input combination and input cancellation series circuit is connected to a coupling input of the input cancellation coupling feedback adjustment circuit, to implement a branch similar input combination and input cancellation combiner main circuit.

The main signal branch similar input combination and cancellation series circuit is implemented by serially connecting a main signal and branch similar input combination combiner circuit and a branch similar input cancellation digital pre-distortion circuit. An output of the main signal and branch similar input combination combiner circuit and an input of the branch similar input cancellation digital pre-distortion circuit are the corresponding output and input of the main signal branch similar input combination and cancellation series circuit.

The output of the main signal and branch similar input combination combiner circuit is connected to the input of the main power amplifier circuit, to implement a branch similar input combination and main signal combiner main circuit.

An output of the branch similar input cancellation digital pre-distortion circuit is connected to an input of the branch similar input combination and main signal combiner main circuit, to implement a branch similar input combination and input cancellation combiner main circuit.

The main signal and branch similar input combination combiner circuit is connected to inputs of two circuits, which are a distortion extraction adjustment amplifier circuit for analog distortion of a branch similar input combiner circuit and an input combination main signal time-delay adjustment circuit , and outputs of the two circuits through a branch-main combination input divider circuit and a branch-main combination output combiner circuit, to implement a main signal and branch similar input combination combiner circuit.

An output of a branch similar input combination analog distortion circuit is connected to a main input of an input combination coupling output load circuit or an input of an input combination amplitude modulation attenuation circuit, an implemented branch similar input combination signal extraction circuit for analog distortion and an input combination main signal adjustment power amplifier circuit are connected to the inputs of the corresponding two circuits and the outputs of the two circuits through an input combiner and output divider circuit and an input combination distortion output combiner circuit, and an output of an implemented branch similar input combination distortion extraction circuit for analog distortion is connected to an input of an input combination distortion adjustment power amplifier circuit, to implement a branch similar input combiner circuit having a function of the branch similar input combination distortion extraction and adjustment amplifier circuit for analog distortion.

The branch-main combination input divider circuit and the input combiner and output divider circuit are implemented by divider circuits, or coupling circuits, or other circuits achieving a division function, and meet power capacity requirements in the corresponding circuits and requirements of not generating new distorted signals, respectively.

The branch-main cancellation output combiner circuit and the input combination distortion output combiner circuit are constituted by combiner circuits or coupling circuits, or other circuits achieving a combination function, and meet power capacity requirements in the corresponding circuits and requirements of not generating new distortion, respectively.

The input combination main signal adjustment power amplifier circuit is implemented by serially connecting an amplitude modulation circuit and an adjustment circuit formed through phase modulation and then serially connecting a main signal power amplifier circuit, and meets main signal power capacity requirements in the corresponding circuits, as well as requirements of not generating new distortion.

The input combination distortion adjustment power amplifier circuit is implemented by serially connecting the amplitude modulation circuit and the adjustment circuit formed by a phase modulation circuit, and then serially connecting a distorted signal power amplifier circuit, and meets corresponding power capacity requirements of the corresponding distorted signal in the corresponding circuits, as well as requirements of not generating new distortion.

The input combination main signal time-delay adjustment circuit is implemented by serially connecting the amplitude modulation circuit and the adjustment circuit implemented by the phase modulation circuit or an adjustment circuit implemented by the amplitude modulation circuit, and then serially connecting a main signal time-delay circuit, and meets power capacity requirements of the corresponding circuits and requirements of not generating new distortion.

The input combination coupling output load circuit is implemented by connecting a main input of an input combination load coupling circuit and an ungrounded end of an input combination load resistor, and the main input and a coupling output of the input combination load coupling circuit respectively are a main input and output of the branch input combination coupling output load circuit. The output of the branch input combination coupling output load circuit is an output of a signal extraction circuit for analog pre-distortion of branch similar input combination.

The branch similar input combination analog distortion circuit implemented by a low-power input combination branch power amplifier circuit or an input combination branch feed-forward power amplifier circuit generates a distorted signal having input same-phase combination compensation, and has a characteristic of compensating for the extension of a linear gain dynamic range of main power signals among Class C main power signals outputted by a Class C main power amplifier circuit that are less than an input combination equal-power point to main power signals with lower output power level.

The main power amplifier circuit is the Class C power amplifier circuit, which is implemented by a single power amplifier circuit or by a plurality of power amplifier circuits through combination or by combining impedance transformation networks. The main power amplifier circuit is a single or multi-stage power amplifier circuit.

The branch similar input cancellation digital pre-distortion circuit is implemented by connecting a digital pre-distortion circuit to an input of a low-power input cancellation analog power amplifier circuit through an output of an input cancellation digital-to-analog conversion circuit, where the digital pre-distortion circuit generates a distorted signal with input reversed-phase similar cancellation, which has a characteristic similar to that of the distorted signal greater than the input cancellation equal-power point in the Class C main power signal with the extended linear gain dynamic range of main power signals of the branch similar input combination and main signal. A feedback input of the digital pre-distortion circuit is connected and mounted to a feedback output of a branch input cancellation coupling feedback adjustment circuit at the output of the main power amplifier circuit, to implement a main signal and branch similar input cancellation combiner circuit having a function of the branch similar input cancellation digital pre-distortion circuit.

The input cancellation coupling feedback adjustment circuit is implemented by connecting the coupling output of the feedback coupling circuit and the feedback signal adjustment power amplifier circuit. The feedback signal adjustment power amplifier circuit is implemented by connecting the amplitude modulation circuit and the feedback signal power amplifier circuit, or implemented by the amplitude modulation circuit.

Embodiment 3 has the following beneficial effects. The combination and cancellation features of the output of the branch similar input combination and input cancellation combiner main circuit of the similar combination and cancellation power amplifier circuit are as follows: at the input combination equal-power point in the branch similar input combination and main signal combiner main circuit and the input cancellation equal-power point in the branch similar input combination and input cancellation combiner main circuit, when the main power amplifier circuit is the Class C power amplifier circuit, and when the time delays are equal or nearly equal, the amplitudes are equal or nearly equal, the phase of the two circuits in the branch similar input combination and main signal combiner main circuit are within the range from 0 degree to 45 degrees, and the phase of the branch similar input combination and input cancellation combiner main circuit are opposite or nearly opposite, in the main signal and branch similar input combination and cancellation parallel circuit or main signal and branch similar input combination and cancellation series circuit meeting the above conditions, the distorted signal having input same-phase combination compensation outputted by the branch similar input combiner circuit and the pre-distorted signal having input reversed-phase similar cancellation outputted by the branch similar input cancellation circuit are generated on the output of the main signal and branch similar input combination and cancellation parallel circuit or main signal and branch similar input combination and cancellation series circuit, to implement the combination cancellation mixed distorted signal.

In the combination cancellation mixed distorted signal, when the distorted signal having input same-phase combination compensation outputted by the branch similar input combiner circuit has the characteristic of compensating for the extension of the linear gain dynamic range of the main power signals among the Class C main power signals outputted by the Class C main power amplifier circuit that are less than the input combination equal-power point to the main power signals with lower output power level, and on the output of the branch similar input combination and main signal combiner main circuit in the branch similar input combination and input cancellation combiner main circuit, when the time delays equal to the input combination equal-power point are equal, the amplitudes are equal or nearly equal, and the phase of the two circuits are within the range from 0 degree to 45 degrees, the distorted signal having same-phase combination compensation outputted by the branch similar input combiner circuit and the compensation extension of the linear gain dynamic range of the main power signals among the Class C main power signals outputted by the Class C main power amplifier circuit that are less than the input combination equal-power point to the main power signals with lower output power level are realized, and the EVM value and the gain fluctuation are increased within the linear gain dynamic range that has been extended to the main power signals with lower output power level, thereby increasing the linear ACPR value of the Class C main power signal with the extended linear gain dynamic range of the main power signals of the branch similar input combination and main signal combiner main circuit to above 30-35 dBc.

When the linear ACPR value of the Class C main power signal with the extended linear gain dynamic range of the main power signals reaches above 30-35 dBc on the output of the branch similar input combination and main signal combiner main circuit, the pre-distorted signal having input reversed-phase similar cancellation generated by the branch similar input cancellation circuit in the combination cancellation mixed distorted signal has the characteristic similar to that of the distorted signal greater than the input cancellation equal-power point in the Class C main power signal with the extended linear gain dynamic range of main power signals of the branch similar input combination and main signal combiner main circuit, and on the output of the branch similar input combination and input cancellation combiner main circuit, when the time delays equal to the input cancellation equal-power point are equal or nearly equal, the amplitudes are equal or nearly equal, and the phase are opposite or nearly opposite, the reversed-phase similar cancellation between the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, thereby increasing the linear ACPR value of the Class C main power signal with the extended linear gain dynamic range of the main power signals outputted by the branch similar input combination and input cancellation combiner main circuit to above 40-45 dBC. Or the reversed-phase similar cancellation between the pre-distorted signal having reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, the linear gain dynamic range of the Class C output main power signals with the extended linear gain dynamic range of the main power signals is extended to the main power signals with lower output power level again, and the EVM value and the gain fluctuation are increased within the linear gain range that has been extended to the main power signals with lower output power level, thereby increasing the linear ACPR value of the Class C main power signal with the extended linear gain dynamic range of the main power signals of the branch similar input combination and input cancellation combiner main circuit to above 40-45 dBC. Furthermore, the overall efficiency of the similar combination and cancellation power amplifier circuit is improved.

A similarity degree and synchronization accuracy of the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit determine the effect of realizing the reversed-phase similar cancellation between the pre-distorted signal having reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit.

### Embodiment 4

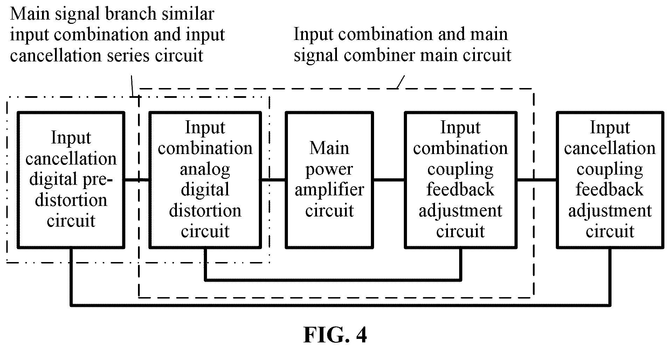

As shown in Fig. 4, a specific implementation of Embodiment 4 of the present disclosure is as follows.

A similar combination and cancellation power amplifier circuit is provided. An output of a main signal branch similar input combination and input cancellation series circuit is connected to a main power amplifier circuit, an output of the main power amplifier circuit is connected to an input of an input combination coupling feedback adjustment circuit, a feedback input of an input combination analog digital distortion circuit is connected to a feedback output of the input combination coupling feedback adjustment circuit, an output of the input combination coupling feedback adjustment circuit is connected to an input of an input cancellation coupling feedback adjustment circuit, and a feedback input of an input cancellation digital pre-distortion circuit is connected to a feedback output of the input cancellation coupling feedback adjustment circuit, to implement a branch similar input combination and input cancellation combiner main circuit.

The main signal branch similar input combination and input cancellation series circuit is implemented by serially connecting the input combination analog digital distortion circuit in the main signal and input combination combiner circuit and the input cancellation digital pre-distortion circuit. An output of the input combination analog digital distortion circuit and an input of the input cancellation digital pre-distortion circuit are the corresponding output and input of the main signal branch similar input combination and input cancellation series circuit.

The input combination and main signal combiner main circuit having the function of a combiner main circuit for analog digital distortion of input combination is implemented by connecting an output of the input combination analog digital distortion circuit and an input of the main power amplifier circuit, and connecting the output of the main power amplifier circuit and the input of the input combination coupling feedback adjustment circuit. The input of the input combination analog digital distortion circuit and the output of the input combination coupling feedback adjustment circuit respectively are an input and output of the input combination and main signal combiner main circuit.

The input combination analog digital distortion circuit is implemented by an analog digital pre-distortion circuit generating a distorted signal having input same-phase similar compensation by connecting an output of an input combination digital-to-analog conversion circuit and an input of a low-power input combination analog power amplifier circuit. A feedback input of the analog digital pre-distortion circuit is connected and mounted to a feedback output of an input combination coupling feedback adjustment circuit on the output of the main power amplifier circuit, to constitute a main signal and input combination combiner circuit having a function of the analog digital distortion circuit of input combination.

The input cancellation digital pre-distortion circuit is implemented by the digital pre-distortion circuit generating the distorted signal having input reversed-phase similar cancellation by connecting the output of the input cancellation digital-to-analog conversion circuit and the input of the low-power input cancellation analog power amplifier circuit. The feedback input of the analog digital pre-distortion circuit is connected and mounted to the feedback output of the input cancellation coupling feedback adjustment circuit on the output of the main power amplifier circuit, to implement the main signal and input cancellation combiner circuit having the function of the input cancellation digital pre-distortion circuit.

The input cancellation coupling feedback adjustment circuit and the input combination coupling feedback adjustment circuit are implemented by connecting the coupling output of the feedback coupling circuit and the feedback signal adjustment power amplifier circuit. The feedback signal adjustment power amplifier circuit is implemented by connecting the amplitude modulation and phase modulation circuit and the feedback signal power amplifier circuit, or implemented by the amplitude modulation circuit.

The main power amplifier circuit in the branch similar input combination and input cancellation combiner main circuit is the Class C power amplifier circuit, which is implemented by a single power amplifier circuit or by a plurality of power amplifier circuits through combination or by combining impedance transformation networks. The main power amplifier circuit is a single or multi-stage power amplifier circuit.

Embodiment 4 has the following beneficial effects. The combination and cancellation features of the output of the input combination and input cancellation combiner main circuit of the similar combination and cancellation power amplifier circuit are as follows: at the input combination equal-power point in the input combination and main signal combiner main circuit and the input cancellation equal-power point in the input combination and input cancellation combiner main circuit, when the main power amplifier circuit is the Class C power amplifier circuit, and when the time delays are equal or nearly equal, the amplitudes are equal or nearly equal, the phase of the two circuits in the input combiner circuit and main signal combiner main circuit are within the range from 0 degree to 45 degrees, and the phase of the input combination and input cancellation combiner main circuit are opposite or nearly opposite, in the main signal input combination and input cancellation parallel or series circuit meeting the above conditions, the distorted signal having input same-phase combination compensation outputted by the input combiner circuit and the pre-distorted signal having input reversed-phase similar cancellation outputted by the input cancellation circuit are generated on the output of the main signal input combination and input cancellation parallel or series circuit, to implement the combination cancellation mixed distorted signal.

When the linear ACPR value of the Class C main power signal with the extended linear gain dynamic range of the main power signals reaches above 30-35 dBc on the output of the input combination and main signal combiner main circuit, the pre-distorted signal having input reversed-phase similar cancellation generated by the input cancellation circuit in the combination cancellation mixed distorted signal has the characteristic similar to that of the distorted signal greater than the input cancellation equal-power point in the Class C main power signal with the extended linear gain dynamic range of main power signals of the input combination and main signal combiner main circuit, and on the output of the input combination and input cancellation combiner main circuit, when the time delays equal to the input cancellation equal-power point are equal or nearly equal, the amplitudes are equal or nearly equal, and the phase are opposite or nearly opposite, the reversed-phase similar cancellation between the pre-distorted signal having input reversed-phase similar cancellation generated by the input cancellation circuit and the distorted signal greater than the input cancellation equal-power point in the Class C main power signal with the extended linear gain dynamic range of the main power signals of the input combination and main signal combiner main circuit is realized, thereby increasing the linear ACPR value of the Class C main power signal with the extended linear gain dynamic range of the main power signals outputted by the input combination and input cancellation combiner main circuit to above 40-45 dBC.

Or the reversed-phase similar cancellation between the pre-distorted signal having reversed-phase similar cancellation generated by the input cancellation circuit and the distorted signal greater than the input cancellation equal-power point in the Class C main power signal with the extended linear gain of the main power signals of the input combination and main signal combiner main circuit is realized, the linear gain range of the Class C output main power signals with extended linear gain of the main power signals is extended to the main power signals with lower output power level again, and the EVM value and the gain fluctuation are increased within the linear gain range that has been extended to the main power signals with lower output power level, thereby increasing the linear ACPR value of the Class C main power signal with the extended linear gain of the main power signals of the input combination and input cancellation combiner main circuit to above 40-45 dBC. Furthermore, the overall efficiency of the similar combination and cancellation power amplifier circuit is improved.

A similarity degree and synchronization accuracy of the pre-distorted signal having input reversed-phase similar cancellation generated by the input cancellation circuit and the distorted signal greater than the input cancellation equal-power point in the Class C main power signal with the extended linear gain dynamic range of the main power signals of the input combination and main signal combiner main circuit determine the effect of realizing the reversed-phase similar cancellation between the pre-distorted signal having reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit.

### Embodiment 5

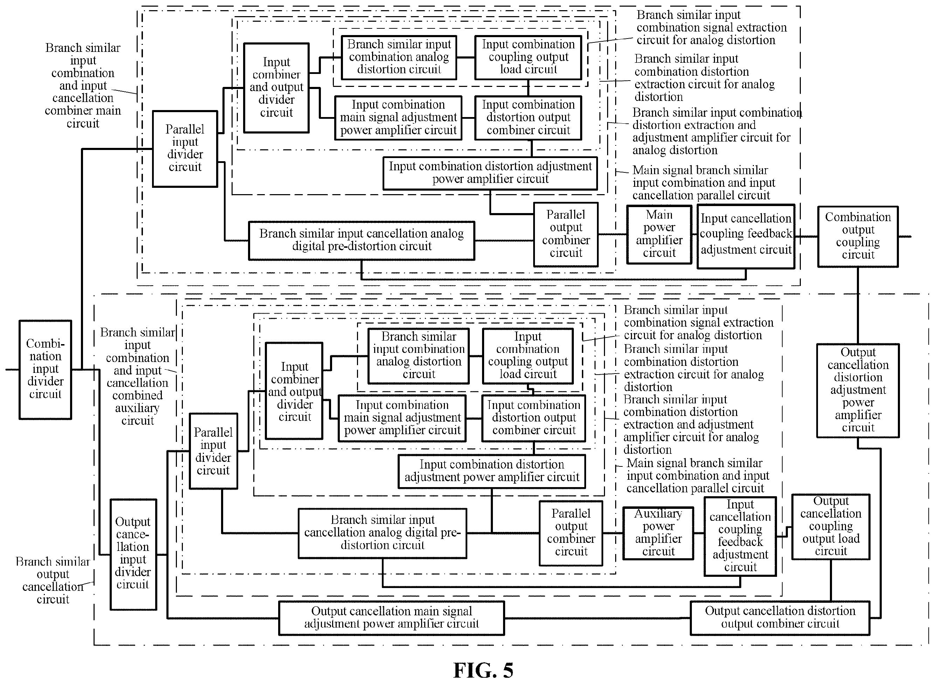

As shown in Fig. 5, a specific implementation of Embodiment 5 of the present disclosure is as follows.

A similar combination and cancellation power amplifier circuit is provided. Through a combination input divider circuit and a combination output coupling circuit, inputs and outputs of a branch similar input combination and input cancellation combiner main circuit and a branch similar output cancellation circuit are parallelly connected to implement the similar combination and cancellation power amplifier circuit having a branch similar input combination cancellation and branch output cancellation combiner main circuit.

In the branch similar input combination and input cancellation combiner main circuit of the similar combination and cancellation power amplifier circuit, the branch similar input combination and input cancellation combiner main circuit is implemented by connecting an output of a main signal branch similar input combination and input cancellation parallel circuit and a main power amplifier circuit.

An output of a combiner circuit of a main signal and a branch similar input combination distortion extraction and adjustment amplifier circuit for analog distortion in a branch similar input cancellation analog digital pre-distortion circuit is connected to an input of the main power amplifier circuit, to implement a branch similar input combination and main signal combiner main circuit having a function of a main signal combiner main circuit in a branch similar input combination and branch similar input cancellation analog digital pre-distortion circuit.

The main signal branch similar input combination and input cancellation parallel circuit is implemented by parallelly connecting inputs and outputs of the branch similar input cancellation analog digital pre-distortion circuit and the branch similar input combination distortion extraction and adjustment amplifier circuit for analog distortion through a parallel input divider circuit and a parallel output combiner circuit. An input of the parallel input divider circuit and an output of the parallel output combiner circuit respectively are a corresponding input and output of the main signal and branch similar input combination and cancellation parallel circuit.

The analog digital pre-distortion circuit of branch similar input cancellation is implemented by the analog digital pre-distortion circuit generating the distorted signal having input same-phase compensation by connecting an output of an input combination digital-to-analog conversion circuit and an input of a low-power input cancellation analog power amplifier circuit. A feedback input of the analog digital pre-distortion circuit is connected and mounted to a feedback output of an input cancellation coupling feedback adjustment circuit on the output of the main power amplifier circuit, to implement a main signal and branch similar input cancellation combiner circuit having a function of the analog digital pre-distortion circuit of branch similar input cancellation.

An output of a branch similar input combination analog distortion circuit is connected to an input of a main circuit of an input combination coupling output load circuit or an input of an input combination amplitude modulation attenuation circuit, an implemented distorted branch similar input combination signal extraction circuit for analog distortion and an input combination main signal adjustment power amplifier circuit are connected to the inputs of the corresponding two circuits and the outputs of the two circuits through an input combiner and output divider circuit and an input combination distortion output combiner circuit, and an output of an implemented branch similar input combination distortion extraction circuit for analog distortion is connected to an input of an input combination distortion adjustment power amplifier circuit, to implement a branch similar input combiner circuit having a function of the branch similar input combination distortion extraction and adjustment amplifier circuit for analog distortion.

The combination input divider circuit, the parallel input divider circuit, and the input combiner and output divider circuit are implemented by divider circuits, or coupling circuits, or other circuits achieving a division function, and meet power capacity requirements in the corresponding circuits and requirements of not generating new distorted signals, respectively.

The parallel output combiner circuit and the input combination distortion output combiner circuit are implemented by combiner circuits or coupling circuits, or other circuits achieving a combination function, and meet power capacity requirements in the corresponding circuits and requirements of not generating new distortion, respectively.

The input combination main signal adjustment power amplifier circuit is implemented by serially connecting an amplitude modulation circuit and an adjustment circuit implemented through phase modulation and then serially connecting a main signal power amplifier circuit, and meets main signal power capacity requirements in the corresponding circuits, as well as requirements of not generating new distortion.

The input combination distortion adjustment power amplifier circuit is implemented by serially connecting the amplitude modulation circuit and the adjustment circuit implemented by a phase modulation circuit, and then serially connecting a distorted signal power amplifier circuit, and meets corresponding power capacity requirements of the corresponding distorted signal in the corresponding circuits, as well as requirements of not generating new distortion.

The input combination coupling output load circuit is implemented by connecting a main input of an input combination load coupling circuit and an ungrounded end of an input combination load resistor, and the main input and a coupling output of the input combination load coupling circuit respectively are a main input and output of the branch input combination coupling output load circuit. The output of the branch input combination coupling output load circuit is an output of a distorted branch similar input combination signal extraction circuit for analog distortion.

The branch similar input combination analog distortion circuit implemented by a low-power input combination branch power amplifier circuit or an input combination branch feed-forward power amplifier circuit generates a distorted signal having input same-phase combination compensation, and has a characteristic of compensating for the extension of a linear gain dynamic range of main power signals among Class C main power signals outputted by a Class C main power amplifier circuit that are less than an input combination equal-power point to main power signals with lower output power level.

The input cancellation coupling feedback adjustment circuit is implemented by connecting the coupling output of the feedback coupling circuit and the feedback signal adjustment power amplifier circuit. The feedback signal adjustment power amplifier circuit is implemented by connecting the amplitude modulation circuit and the feedback signal power amplifier circuit, or implemented by the amplitude modulation circuit.

In the branch similar input combination cancellation and branch output cancellation combiner main circuit in the similar combination and cancellation power amplifier circuit, features of the branch similar output cancellation circuit are as follows: an output of a branch similar input combination and input cancellation combined auxiliary circuit for branch similar output cancellation is connected to a main input of an output cancellation coupling output load circuit, or an input of an output cancellation amplitude modulation attenuation circuit, to implement a distorted signal extraction circuit of the branch similar input combination and input cancellation combined auxiliary circuit for branch similar output cancellation, and an output cancellation main signal adjustment power amplifier circuit, and through an output cancellation input divider circuit and an output cancellation distortion output combiner circuit, a distortion extraction circuit of the branch similar input combination and input cancellation combined auxiliary circuit for branch similar output cancellation is implemented by parallelly connecting the inputs of the two circuits and the outputs of the two circuits.

By replacing the main power amplifier circuit in the branch similar input combination and input cancellation combiner main circuit with a similar low-power Class C first auxiliary power amplifier circuit, the branch similar input combination and input cancellation combined auxiliary circuit for branch similar output cancellation is implemented, and generates the distorted signal having output reversed-phase similar cancellation, and the branch similar output cancellation circuit has the function similar to that of the distorted signal greater than the output cancellation equal-power point in the Class C main power signal with the extended linear gain of the main power signals of the branch similar input combination and input cancellation combiner main circuit.

An output of the distortion extraction circuit of the branch similar input combination and input cancellation combined auxiliary circuit for branch similar output cancellation is connected to an input of an output cancellation distortion adjustment power amplifier circuit, to implement the branch similar output cancellation circuit having a function of a distortion extraction adjustment amplifier circuit of the branch similar input combination and input cancellation combined auxiliary circuit for branch similar output cancellation.

An input of an output cancellation input divider circuit in the branch similar output cancellation circuit and an output of the output cancellation distortion adjustment power amplifier circuit respectively correspond to an input and an output of the branch similar output cancellation circuit.

The output cancellation coupling output load circuit is implemented by connecting a main input of an output cancellation load coupling circuit and an ungrounded end of an output cancellation load resistor, and a main input and a coupling output of the output cancellation load coupling circuit are a main input and output of the output cancellation coupling output load circuit. The output of the output cancellation coupling output load circuit is the output of the distorted signal extraction circuit of the branch similar input combination and input cancellation combined auxiliary circuit for branch similar output cancellation.

The output cancellation distortion output combiner circuit is implemented by combiner circuits or coupling circuits, or other circuits achieving a combination function, and meets power capacity requirements in the corresponding circuits and requirements of not generating new distorted signals, respectively.

The output cancellation main signal adjustment power amplifier circuit is implemented by serially connecting an amplitude modulation circuit and an adjustment circuit implemented through phase modulation and then serially connecting a main signal power amplifier circuit, and meets main signal power capacity and low power requirements in the corresponding circuits, as well as requirements of not generating new distortion.

The output cancellation distortion adjustment power amplifier circuit is implemented by serially connecting the amplitude modulation circuit and the adjustment circuit implemented by a phase modulation circuit, and then serially connecting a distorted signal power amplifier circuit, and meets corresponding power capacity requirements of the corresponding distorted signal in the corresponding circuits, as well as requirements of not generating new distortion.

The combination output coupling circuit is implemented by combiner circuits or coupling circuits, or other circuits achieving a combination or coupling function, and meets corresponding power capacity requirements of the corresponding distorted signal in the corresponding circuits, as well as requirements of not generating new distortion.

Embodiment 5 has the following beneficial effects. When the linear ACPR value of the Class C main power signal with the extended linear gain of the main power signals of the branch similar input combination and input cancellation combiner main circuit reaches above 40-45 dBC on an output of the branch similar input combination and input cancellation combiner main circuit, and when time delays at the output cancellation equal-power point in the branch similar input combination cancellation and branch output cancellation combiner main circuit are equal or nearly equal, amplitudes are equal or nearly equal, and phase are opposite or nearly opposite, the distorted signal having the output reversed-phase similar cancellation characteristic generated and implemented by the branch similar output cancellation circuit is similar to the distorted signal greater than the output cancellation equal-power point in the Class C main power signal with the extended linear gain of the main power signals outputted by the branch similar input combination and input cancellation combiner main circuit, such that on the output of the branch similar input combination cancellation and branch output cancellation combiner main circuit, the distorted signal having output reversed-phase similar cancellation generated by the branch similar output cancellation circuit and the distorted signal greater than the output cancellation equal-power point in the Class C main power signal with the extended linear gain dynamic range of the main power signals outputted by the main similar input combination and input cancellation combiner main circuit cancel out each other, the main power signal generated by the branch similar output cancellation circuit and the Class C main power signal with the extended linear gain dynamic range of the main power signals of the branch similar input combination and input cancellation combiner main circuit have compensation characteristics, the linear gain of the Class C output main power signal with the extended linear gain of the main power signals is further extend to a smaller output main power signal range, and an EVM value and a gain fluctuation are increased within the further extended linear gain range, thereby increasing the linear ACPR value of the Class C main power signal further extended by the main power signals outputted by the branch similar input combination cancellation and branch output cancellation combiner main circuit to more than 50-55 dBC, and improving overall efficiency.

A similarity degree and synchronization accuracy of the distorted signal having output reversed-phase similar cancellation characteristic generated and implemented by the branch similar output cancellation circuit and the distorted signal greater than the output cancellation equal-power point in the Class C main power signal with the extended linear gain of the main power signals outputted by the branch similar input combination and input cancellation combiner main circuit determine the effect of realizing the reversed-phase similar cancellation between the distorted signal having output reversed-phase similar cancellation generated by the branch similar output cancellation circuit and the distorted signal greater than the output cancellation equal-power point in the Class C main power signal with the extended linear gain of the main power signals outputted by the main similar input combination and input cancellation combiner main circuit.

### Embodiment 6

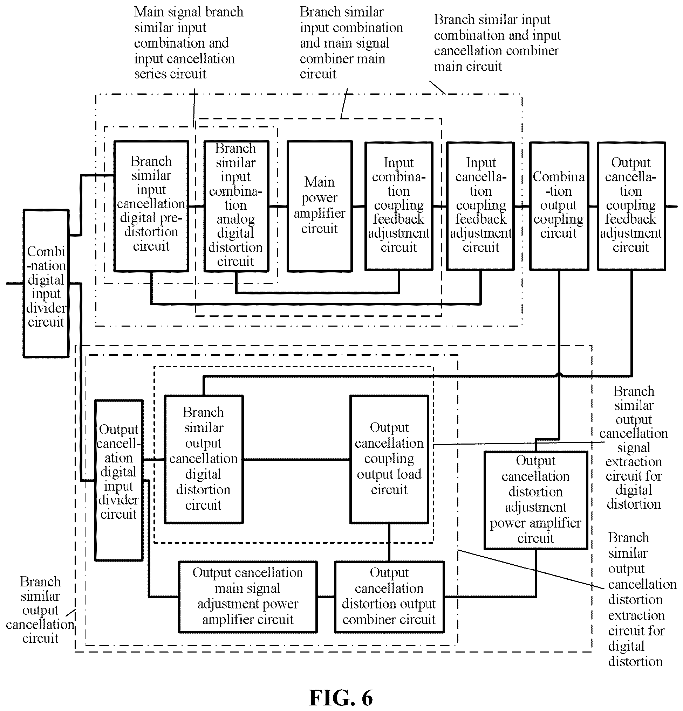

As shown in Fig. 6, a specific implementation of Embodiment 6 of the present disclosure is as follows.

A similar combination and cancellation power amplifier circuit is provided. Through a combination digital input divider circuit and a combination output coupling circuit, digital input ports of two circuits, which are a branch similar input combination and input cancellation combiner main circuit and a branch similar output cancellation circuit, and outputs of the two circuits are parallelly connected to implement the similar combination and cancellation power amplifier circuit having a branch similar input combination cancellation and branch output cancellation combiner main circuit.

In the branch similar input combination and input cancellation combiner main circuit of the similar combination and cancellation power amplifier circuit, the branch similar input combination and input cancellation combiner main circuit is implemented by connecting an output of a main signal branch similar input combination and input cancellation series circuit and a main power amplifier circuit.

The main signal branch similar input combination and input cancellation series circuit is implemented by serially connecting an input of a branch similar input combination analog digital distortion circuit in a main signal and branch similar input combination combiner circuit and an output of a branch similar input cancellation digital pre-distortion circuit. An output of the branch similar input combination analog digital distortion circuit and an input of the branch similar input cancellation digital pre-distortion circuit are a corresponding output and digital input port of the main signal branch similar input combination and input cancellation series circuit.

The branch similar input combination analog digital pre-distortion circuit has, by generating a distorted signal having input same-phase compensation, a characteristic of compensating for extension of a linear gain dynamic range of main power signals among Class C main power signals outputted by a Class C main power amplifier circuit that are less than an input combination equal-power point to main power signals with lower output power level, and is implemented by connecting an output of an input combination digital-to-analog conversion circuit and an input of a low-power input combination analog power amplifier circuit. A feedback input of the analog digital pre-distortion circuit is connected and mounted to a feedback output of an input combination coupling feedback adjustment circuit on the output of the main power amplifier circuit, to implement a main signal and branch similar input combination combiner circuit having a function of the branch similar input combination analog digital distortion circuit.

Through the digital pre-distortion circuit generating the distorted signal having input reversed-phase similar cancellation, the branch similar input cancellation digital pre-distortion circuit generates a distorted signal having input reversed-phase similar cancellation, has a characteristic similar to that of a distorted signal greater than an input cancellation equal-power point in a Class C main power signal with an extended linear gain dynamic range of main power signals of the branch similar input combination and main signal combiner main circuit, and is implemented by connecting an output of an input cancellation digital-to-analog conversion circuit and an input of a low-power input cancellation analog power amplifier circuit. A feedback input of the digital pre-distortion circuit is connected and mounted to a feedback output of an input cancellation coupling feedback adjustment circuit on the output of the main power amplifier circuit, to implement the main signal and branch similar input cancellation combiner circuit having the function of the branch similar input cancellation digital pre-distortion circuit.

The input cancellation coupling feedback adjustment circuit is implemented by connecting the coupling output of the input cancellation feedback coupling circuit and the feedback signal adjustment power amplifier circuit. The feedback signal adjustment power amplifier circuit is implemented by connecting the amplitude modulation circuit and the feedback signal power amplifier circuit, or implemented by the amplitude modulation circuit.

The input combination coupling feedback adjustment circuit is implemented by connecting the coupling output of the input combination feedback coupling circuit and the feedback signal adjustment power amplifier circuit. The feedback signal adjustment power amplifier circuit is implemented by connecting the amplitude modulation circuit and the feedback signal power amplifier circuit, or implemented by the amplitude modulation circuit.

The main power amplifier circuit is the Class C power amplifier circuit, which is implemented by a single power amplifier circuit or by a plurality of power amplifier circuits through combination or by combining impedance transformation networks. The main power amplifier circuit is a single or multi-stage power amplifier circuit.

In the similar combination and cancellation power amplifier circuit, within the branch similar input combination cancellation and branch output cancellation , the branch similar output cancellation circuit has the following features: a branch similar output cancellation distortion extraction circuit for digital distortion is implemented by connecting a branch similar output cancellation digital distortion signal extraction circuit and an output cancellation main signal adjustment power amplifier circuit through an output cancellation digital input divider circuit and an output cancellation distortion output combined circuit to one analog input port and one digital input port in both circuits and analog outputs of both circuits in parallel, where the branch similar output cancellation digital distortion signal extraction circuit is implemented by connecting an output of a branch similar output cancellation digital distortion circuit to a main input of an output cancellation coupling output load circuit. An output of the branch similar output cancellation distortion extraction circuit for digital distortion is connected to an input of the output cancellation distortion adjustment power amplifier circuit, to implement the branch similar output cancellation circuit with a function of a distortion extraction adjustment amplifier circuit for digital distortion of branch similar output cancellation.

The output cancellation coupling output load circuit is implemented by connecting a main input of an output cancellation load coupling circuit and an ungrounded end of an output cancellation load resistor, and a main input and a coupling output of the output cancellation load coupling circuit are a main input and output of the output cancellation coupling output load circuit. The output of the output cancellation coupling output load circuit is the output of the branch similar output cancellation signal extraction circuit for digital distortion.

The digital distortion circuit of branch similar output cancellation is implemented by the digital distortion circuit generating the distorted signal having output reversed-phase similar cancellation by connecting an output of an output combination digital-to-analog conversion circuit and an input of a low-power output cancellation analog power amplifier circuit. A feedback input of the digital distortion circuit is connected and mounted to a feedback output of an output cancellation coupling feedback adjustment circuit on the output of the branch similar input combination cancellation and branch output cancellation combiner main circuit.

The combination digital input divider circuit and the output cancellation digital input divider circuit are implemented by digital divider circuits and meet digital signal requirements; the two outputs are digital ends, or one of the two outputs is a digital signal output, and the other digital output is an analog output by connecting the output of the digital-to-analog conversion circuit; and power capacity requirements in the corresponding circuits and requirements of not generating new distortion are met respectively.

The output cancellation distortion output combiner circuit is implemented by combiner circuits or coupling circuits, or other circuits achieving a combination function, and meets power capacity requirements in the corresponding circuits and requirements of not generating new distorted signals, respectively.

The output cancellation coupling feedback adjustment circuit is implemented by connecting the coupling output of the output cancellation feedback coupling circuit and the feedback signal adjustment power amplifier circuit. The feedback signal adjustment power amplifier circuit is implemented by connecting the amplitude modulation circuit and the feedback signal power amplifier circuit, or implemented by the amplitude modulation circuit.

The output cancellation main signal adjustment power amplifier circuit is implemented by serially connecting an amplitude modulation circuit and an adjustment circuit implemented through phase modulation and then serially connecting a main signal power amplifier circuit, and meets main signal power capacity requirements in the corresponding circuits, as well as requirements of not generating new distortion.

The output cancellation distortion adjustment power amplifier circuit is implemented by serially connecting the amplitude modulation circuit and the adjustment circuit implemented by a phase modulation circuit, and then serially connecting a distorted signal power amplifier circuit, and meet corresponding power capacity requirements of the corresponding distorted signal in the corresponding circuits, as well as requirements of not generating new distortion.

The combination output coupling circuit is implemented by combiner circuits or coupling circuits, or other circuits achieving a combination or coupling function, and meets corresponding power capacity requirements of the corresponding distorted signal in the corresponding circuits, as well as requirements of not generating new distortion.

Embodiment 6 has the following beneficial effects. When the linear ACPR value of the Class C main power signal with the extended linear gain dynamic range of the main power signals of the branch similar input combination and input cancellation combiner main circuit reaches above 40-45 dBC on an output of the branch similar input combination and input cancellation combiner main circuit, and when time delays at the output cancellation equal-power point in the branch similar input combination cancellation and branch output cancellation combiner main circuit are equal or nearly equal, amplitudes are equal or nearly equal, and phase are opposite or nearly opposite, the distorted signal having the output reversed-phase similar cancellation characteristic generated and implemented by the branch similar output cancellation circuit is similar to the distorted signal greater than the output cancellation equal-power point in the Class C main power signal with the extended linear gain dynamic range of the main power signals outputted by the branch similar input combination and input cancellation combiner main circuit, such that on the output of the branch similar input combination cancellation and branch output cancellation combiner main circuit, the distorted signal having output reversed-phase similar cancellation generated by the branch similar output cancellation circuit and the distorted signal greater than the output cancellation equal-power point in the Class C main power signal with the extended linear gain dynamic range of the main power signals outputted by the main similar input combination and input cancellation combiner main circuit cancel out each other, the main power signal generated by the branch similar output cancellation circuit and the Class C main power signal with the extended linear gain dynamic range of the main power signals of the branch similar input combination and input cancellation combiner main circuit have compensation characteristics, the linear gain of the Class C output main power signal with the extended linear gain dynamic range of the main power signals is further extend to a smaller output main power signal range, and an EVM value and a gain fluctuation are increased within the further extended linear gain dynamic range, thereby increasing the linear ACPR value of the Class C main power signal with the further extended linear gain dynamic range of the main power signals outputted by the branch similar input combination cancellation and branch output cancellation combiner main circuit to more than 50-55 dBC, and improving overall efficiency.

A similarity degree and synchronization accuracy of the distorted signal having output reversed-phase similar cancellation characteristic generated and implemented by the branch similar output cancellation circuit and the distorted signal greater than the output cancellation equal-power point in the Class C main power signal with the extended linear gain of the main power signals outputted by the branch similar input combination and input cancellation combiner main circuit determine the effect of realizing the reversed-phase similar cancellation between the distorted signal having output reversed-phase similar cancellation generated by the branch similar output cancellation circuit and the distorted signal greater than the output cancellation equal-power point in the Class C main power signal with the extended linear gain of the main power signals outputted by the main similar input combination and input cancellation combiner main circuit.

### Embodiment 7

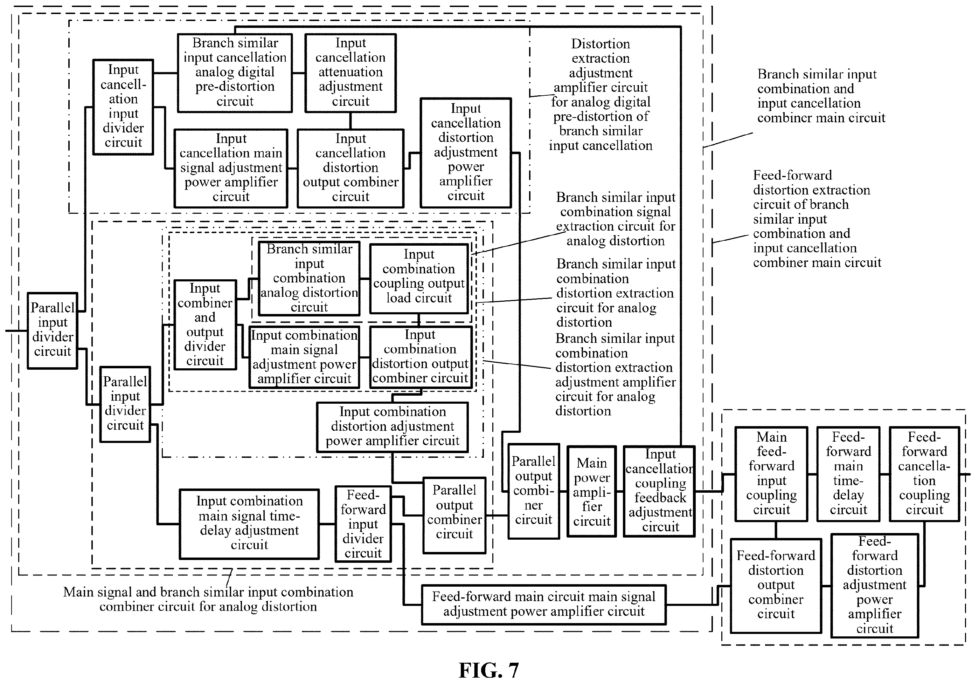

As shown in Fig. 7, a specific implementation of Embodiment 7 of the present disclosure is as follows.

A similar combination and cancellation power amplifier circuit is provided. The main power output of the feed-forward distortion extraction circuit of the branch similar input combination and input cancellation combiner main circuit is connected to the main power input of the main feed-forward output cancellation circuit, and the distortion output of the feed-forward distortion extraction circuit of the branch similar input combination and input cancellation combiner main circuit is connected to the distortion input of the main feed-forward output cancellation circuit, to implement the similar combination and cancellation power amplifier circuit having a function of the branch similar input combination cancellation and feed-forward output cancellation series circuit.

In a branch similar input combination cancellation and feed-forward output cancellation series circuit of the similar combination and cancellation power amplifier circuit, features of a feed-forward distortion extraction circuit of a branch similar input combination and input cancellation combiner main circuit are as follows. An output of the branch similar input combination and input cancellation combiner main circuit is connected to a main input of a main feed-forward input coupling circuit, to implement a feed-forward signal extraction circuit of the branch similar input combination and input cancellation combiner main circuit. A coupling output of the main feed-forward input coupling circuit is an output of the feed-forward signal extraction circuit of the branch similar input combination and input cancellation combiner main circuit, and for a feed-forward main circuit main signal adjustment power amplifier circuit, an input of the feed-forward main circuit main signal adjustment power amplifier circuit is connected to an input or another output of a feed-forward input divider circuit, a feed-forward distortion output combiner circuit is parallelly connected to outputs of two circuits, to implement the feed-forward distortion extraction circuit of the branch similar input combination and input cancellation combiner main circuit. The input of the feed-forward input divider circuit, the main output of the main feed-forward input coupling circuit, and the output of the feed-forward distortion output combiner circuit respectively are a corresponding main signal input, main power output, and a distortion output of the feed-forward distortion extraction circuit of the branch similar input combination and input cancellation combiner main circuit.

In a branch similar input combination cancellation and feed-forward output cancellation series circuit of the similar combination and cancellation power amplifier circuit, features of a feed-forward distortion extraction circuit of a branch similar input combination and input cancellation combiner main circuit are as follows. An output of the branch similar input combination and input cancellation combiner main circuit is connected to a main input of a main feed-forward input coupling circuit, to implement a feed-forward signal extraction circuit of the branch similar input combination and input cancellation combiner main circuit, and the feed-forward main circuit main signal adjustment power amplifier circuit, the input of the feed-forward main circuit main signal adjustment power amplifier circuit is mounted in an input combination and input cancellation main signal adjustment power amplifier circuit via the connected input or another output of the feed-forward input divider circuit, and is parallelly connected to analog input ports of the two circuits or one digital input port and one analog input port in the two circuits and outputs of the two circuits through the feed-forward input divider circuit or feed-forward digital input divider circuit and a feed-forward distortion output combiner circuit, to implement the feed-forward distortion extraction circuit of the branch similar input combination and input cancellation combiner main circuit. A coupling output of the main feed-forward input coupling circuit is an output of the feed-forward signal extraction circuit of the branch similar input combination and input cancellation combiner main circuit. The analog input port of the feed-forward input divider circuit or the digital input port of the feed-forward digital input divider circuit, the main output of the main feed-forward input coupling circuit, and the output of the feed-forward distortion output combiner circuit respectively are a corresponding analog or digital input port, main power output, and a distortion output of the feed-forward distortion extraction circuit of the branch similar input combination and input cancellation combiner main circuit.

In the branch similar input combination cancellation and feed-forward output cancellation series circuit of the similar combination and cancellation power amplifier circuit, the main feed-forward output cancellation circuit is implemented by connecting a main input of a feed-forward cancellation coupling circuit and an output of a feed-forward main time-delay circuit, and connecting a coupling input of the feed-forward cancellation coupling circuit and an output of a feed-forward distortion adjustment power amplifier circuit. An input of the feed-forward main time-delay circuit is a main power input of the main feed-forward output cancellation circuit, and an input of the feed-forward distortion adjustment power amplifier circuit is a distortion input of the main feed-forward output cancellation circuit. An output of the feed-forward cancellation coupling circuit is an output of the main feed-forward output cancellation circuit.

In the branch similar input combination cancellation and feed-forward output cancellation series circuit, from the main input of the main feed-forward input coupling circuit to the output of the feed-forward cancellation coupling circuit via the feed-forward main time-delay circuit and via the feed-forward distortion adjustment power amplifier circuit connected to the output of the feed-forward distortion output combiner circuit, the combination feed-forward cancellation circuit from the input of the main feed-forward input coupling circuit to the output of the feed-forward cancellation coupling circuit is an implemented.

The branch similar input combination and input cancellation combiner main circuit is implemented by parallelly connecting analog input ports of two circuits, which are a main signal and branch similar input combination analog distortion combiner circuit and a distortion extraction adjustment amplifier circuit for analog digital pre-distortion of branch similar input cancellation, and outputs of the two circuits through a parallel input divider circuit and a parallel output combiner circuit, and then serially connecting the input of the main power amplifier circuit. An input of the parallel input divider circuit and an output of the main power amplifier circuit respectively are a corresponding input and output of the branch similar input combination and input cancellation combiner main circuit.

The main signal and branch similar input combination analog distortion combiner circuit is parallelly connected to inputs and outputs of a branch similar input combination distortion extraction and adjustment amplifier circuit for analog distortion and an input combination main signal time-delay adjustment circuit through an input combiner and output divider circuit and an input combination distortion output combiner circuit, to implement the main signal and branch similar input combination analog distortion combiner circuit.

An output of a branch similar input combination analog distortion circuit is connected to a main input of an input combination coupling output load circuit or an input of an input combination amplitude modulation attenuation circuit, an implemented branch similar input combination signal extraction circuit for analog distortion and an input combination main signal adjustment power amplifier circuit are connected to the inputs and outputs of the corresponding two circuits through an input combiner and output divider circuit and an input combination distortion output combiner circuit, and an output of an implemented branch similar input combination distortion extraction circuit for analog distortion is connected to an input of an input combination distortion adjustment power amplifier circuit, to implement a branch similar input combiner circuit having a function of the branch similar input combination distortion extraction and adjustment amplifier circuit for analog distortion.

The input combiner and output divider circuit is implemented by divider circuits, or coupling circuits, or other circuits achieving a division function, and meets power capacity requirements in the corresponding circuits and requirements of not generating new distorted signals, respectively.

The input combination distortion output combiner circuit is implemented by combiner circuits or coupling circuits, or other circuits achieving a combination function, and meets power capacity requirements in the corresponding circuits and requirements of not generating new distortion, respectively.

The input combination main signal adjustment power amplifier circuit is implemented by serially connecting an amplitude modulation circuit and an adjustment circuit implemented through phase modulation and then serially connecting a main signal power amplifier circuit, and meets main signal power capacity requirements in the corresponding circuits, as well as requirements of not generating new distortion.

The input combination distortion adjustment power amplifier circuit is implemented by serially connecting the amplitude modulation circuit and the adjustment circuit implemented by a phase modulation circuit, and then serially connecting a distorted signal power amplifier circuit, and meets corresponding power capacity requirements of the corresponding distorted signal in the corresponding circuits, as well as requirements of not generating new distortion.

The input combination main signal time-delay adjustment circuit is implemented by serially connecting the amplitude modulation circuit and the adjustment circuit implemented by the phase modulation circuit or an adjustment circuit implemented by the amplitude modulation circuit, and then serially connecting a main signal time-delay circuit, and meets power capacity requirements of the corresponding circuits and requirements of not generating new distortion.

The input combination coupling output load circuit is implemented by connecting a main input of an input combination load coupling circuit and an ungrounded end of an input combination load resistor, and the main input and a coupling output of the input combination load coupling circuit respectively are a main input and output of the branch input combination coupling output load circuit. The output of the branch input combination coupling output load circuit is an output of a branch similar input combination signal extraction circuit for analog distortion.

The branch similar input combination analog distortion circuit is implemented by a low power branch power amplifier circuit or a branch feed-forward power amplifier circuit, and has the function of generating the distorted signal having input same-phase combination compensation.

The main power amplifier circuit is the Class C power amplifier circuit, which is implemented by a single power amplifier circuit or by a plurality of power amplifier circuits through combination or by combining impedance transformation networks. The main power amplifier circuit is a single or multi-stage power amplifier circuit.

An output of an analog pre-distortion circuit of branch similar input cancellation is connected to an input of an input cancellation attenuation adjustment circuit, an implemented signal extraction circuit for analog digital pre-distortion of branch similar input cancellation and an input cancellation main signal adjustment power amplifier circuit are parallelly connected to the inputs of the corresponding two circuits and outputs of the two circuits through an input cancellation input divider circuit and an input cancellation distortion output combiner circuit, and an output of an implemented distortion extraction circuit for analog digital pre-distortion of branch similar input cancellation is connected to an input of an input cancellation distortion adjustment power amplifier circuit, to implement a branch similar input combiner circuit having a function of the distortion extraction adjustment amplifier circuit for analog digital pre-distortion of branch similar input cancellation.

The input cancellation input divider circuit is implemented by divider circuits, or coupling circuits, or other circuits achieving a division function, and meets power capacity requirements in the corresponding circuits and requirements of not generating new distorted signals, respectively.

The input cancellation distortion output combiner circuit is implemented by combiner circuits or coupling circuits, or other circuits achieving a combination function, and meets power capacity requirements in the corresponding circuits and requirements of not generating new distortion, respectively.

The input cancellation coupling feedback adjustment circuit is implemented by connecting the coupling output of the feedback coupling circuit and the feedback signal adjustment power amplifier circuit. The feedback signal adjustment power amplifier circuit is implemented by connecting the amplitude modulation circuit and the feedback signal power amplifier circuit, or implemented by the amplitude modulation circuit.

The analog digital pre-distortion circuit of branch similar input cancellation is implemented by connecting an output of a digital-to-analog conversion circuit and an input of a low-power analog power amplifier circuit. A feedback input of the analog digital pre-distortion circuit is connected and mounted to a feedback output of an input cancellation coupling feedback adjustment circuit on the output of the main power amplifier circuit.

The input cancellation attenuation adjustment circuit is implemented by an adjustable analog or digital attenuator, and meets power capacity requirements in the corresponding circuits and requirements of not generating new distortion, respectively.

The input cancellation main signal adjustment power amplifier circuit is implemented by serially connecting an amplitude modulation circuit and an adjustment circuit implemented through phase modulation and then serially connecting a main signal power amplifier circuit, and meets main signal power capacity requirements in the corresponding circuits, as well as requirements of not generating new distortion.

The input cancellation distortion adjustment power amplifier circuit is implemented by serially connecting the amplitude modulation circuit and the adjustment circuit implemented by a phase modulation circuit, and then serially connecting a distorted signal power amplifier circuit, and meets corresponding power capacity requirements of the corresponding distorted signal in the corresponding circuits, as well as requirements of not generating new distortion.

The same type cancellation features of the output of the branch similar input combination cancellation and feed-forward output cancellation series circuit of the similar combination and cancellation power amplifier circuit are as follows: when the Class C main power linear ACPR of the extended linear gain of the main power signals reaches above 40-45 dBC in the branch similar input combination and input cancellation combiner main circuit, when the time delays equal to the feed-forward cancellation equal-power point are equal or nearly equal, the amplitudes are equal or nearly equal, and the phase are opposite or nearly opposite, the distorted signal in the Class C main power signal with the extended linear gain of the main power signals outputted by the branch similar input combination and input cancellation combiner main circuit is extracted by the distortion output of the feed-forward distortion extraction circuit of the branch similar input combination and input cancellation combiner main circuit, from the input of the main feed-forward coupling circuit to the output of the combination feed-forward cancellation circuit on the output of the feed-forward cancellation coupling circuit, the same type distortion signal cancellation of the distorted signal in the Class C main power signal with the extended linear gain of the main power signals outputted by the branch similar input combination and input cancellation combiner main circuit is realized, and the linear gain of the Class C output main power signal with the extended linear gain of the main power signals is further extended to reach the linear gain of the Class AB output main power, and the EVM value and the gain fluctuation are increased within the linear gain dynamic range that has been extended, thereby increasing the linear ACPR value of the Class AB output main power signal outputted by the branch similar input combination cancellation and feed-forward output cancellation series circuit to more than 50-55 dBC, and improving the overall efficiency.

A similarity degree and synchronization accuracy of the distorted signal extracted by the feed-forward distortion extraction circuit of the branch similar input combination and input cancellation combiner main circuit and the distorted signal in the Class C main power signal with the extended linear gain of the main power signals outputted by the branch similar input combination and input cancellation combiner main circuit determine the effect of realizing the same type distortion signal cancellation of the distorted signal in the Class C main power signal with the extended linear gain of the main power signals outputted by the branch similar input combination and input cancellation combiner main circuit.

The above are only the preferred embodiments of the present disclosure and are not intended to limit the present disclosure. For those skilled in the art, the present disclosure may have various modifications and variations. Any modifications, equivalent replacements, improvements and the like made within the spirit and principle of the present disclosure shall fall within the scope of protection of the present disclosure.

## Claims

1. A similar combination and cancellation power amplifier circuit, wherein the similar combination and cancellation power amplifier circuit having a function of a branch similar input combination and input cancellation combiner main circuit is implemented by connecting an output of a main signal branch similar input combination and input cancellation parallel circuit or main signal branch similar input combination and input cancellation series circuit to a main power amplifier circuit, and an output of a main signal and branch similar input combination combiner circuit in the main signal branch similar input combination and input cancellation parallel circuit or main signal branch similar input combination and input cancellation series circuit is connected to an input of the main power amplifier circuit, to implement a branch similar input combination and main signal combiner main circuit;
in a branch similar input combination and input cancellation combiner main circuit of the similar combination and cancellation power amplifier circuit, the main signal branch similar input combination and input cancellation parallel circuit is implemented through a parallel input divider circuit or through a parallel digital input divider circuit and a parallel output combiner circuit by parallelly connecting analog input ports of two circuits, which are the main signal and branch similar input combination combiner circuit and a branch similar input cancellation circuit, or one analog input port and one digital input port in the two circuits or the digital input ports of the two circuits and outputs of the two circuits; or implemented through the parallel input divider circuit or through the parallel digital input divider circuit and the parallel output combiner circuit by parallelly connecting analog input ports of two circuits, which are a main signal and branch similar input cancellation combiner circuit and a branch similar input combiner circuit, or one analog input port and one digital input port in the two circuits or the digital input ports of the two circuits and outputs of the two circuits; or implemented through the parallel input divider circuit or through the parallel digital input divider circuit and the parallel output combiner circuit by parallelly connecting inputs of two circuits, which are a branch similar input combination and input cancellation combiner circuit and a corresponding input combination or input cancellation main signal time-delay adjustment circuit, or one analog input port and one digital input port in the two circuits and outputs of the two circuits, wherein an input of the parallel input divider circuit or a digital input port of the parallel digital input divider circuit and an output of the parallel output combiner circuit are a corresponding input or digital input port and an output of the main signal branch similar input combination and input cancellation parallel circuit;
in the branch similar input combination and input cancellation combiner main circuit of the similar combination and cancellation power amplifier circuit, the main signal branch similar input combination and input cancellation series circuit is implemented by serially connecting the main signal and branch similar input combination combiner circuit and the main signal and branch similar input cancellation combiner circuit, wherein an input of the main signal and branch similar input cancellation combiner circuit and the output of the main signal and branch similar input combination combiner circuit or an input of the branch similar input combination combiner circuit and the output of the branch similar input cancellation combiner circuit are a corresponding input and output of the main signal branch similar input combination and input cancellation series circuit;
in the main signal branch similar input combination and input cancellation parallel circuit, only one input combination or input cancellation main signal time-delay adjustment circuit is provided, and in the main signal and branch similar input combination combiner circuit or the main signal and branch similar input cancellation combiner circuit, only one input combination or input cancellation main signal time-delay adjustment circuit is provided;
the main signal and branch similar input combination combiner circuit or the main signal and branch similar input cancellation combiner circuit is parallelly connected to inputs of the two circuits, which are the branch similar input combiner circuit or the branch similar input cancellation circuit and the corresponding input combination or input cancellation main signal time-delay adjustment circuit, or one analog input port and one digital input port in the two circuits and the outputs of the two circuits through a branch-main combination or branch-main cancellation input divider circuit or through a branch-main combination or branch-main cancellation digital input divider circuit and a branch-main combination or branch-main cancellation output combiner circuit, to implement the main signal and branch similar input combination combiner circuit or the main signal and branch similar input cancellation combiner circuit;
or the branch similar input combination and input cancellation combiner circuit therein is parallelly connected to inputs of the two circuits, which are the branch similar input combiner circuit and the branch similar input cancellation circuit, or the digital input ports of the two circuits or one analog input port and one digital input port in the two circuits and the outputs of the two circuits through the branch-main combination or branch-main cancellation input divider circuit or through the branch-main combination or branch-main cancellation digital input divider circuit and the branch-main combination or branch-main cancellation output combiner circuit, to implement the branch similar input combination and input cancellation combiner circuit;
the branch similar input combiner circuit is configured to output a distorted signal having input same-phase combination compensation, which has a characteristic of compensating for extension of a linear gain dynamic range of main power signals among Class C main power signals outputted by a Class C main power amplifier circuit that are less than an input combination equal-power point to have main power signals with lower output power level;
the branch similar input cancellation circuit is configured to output a pre-distorted signal having input reversed-phase similar cancellation, which has a characteristic similar to that of the distorted signal greater than an input cancellation equal-power point in the Class C main power signal with an extended linear gain dynamic range of main power signals of the branch similar input combination and main signal combiner main circuit;
input combination and input cancellation features of the output of the branch similar input combination and input cancellation combiner main circuit are as follows:
at an input combination equal-power point in the branch similar input combination and main signal combiner main circuit and an input cancellation equal-power point in the branch similar input combination and input cancellation combiner main circuit, when a main power amplifier circuit is a Class C power amplifier circuit, at equal or nearly equal time delays, equal or nearly equal amplitudes, and when phase of the two circuits in the branch similar input combination and main signal combiner main circuit are within a range from 0 degree to 45 degrees, and phase of the branch similar input combination and input cancellation combiner main circuit are opposite or nearly opposite, in the main signal branch similar input combination and input cancellation parallel circuit or main signal branch similar input combination and input cancellation series circuit meeting the above conditions, the distorted signal having input same-phase combination compensation outputted by the branch similar input combiner circuit and the pre-distorted signal having input reversed-phase similar cancellation outputted by the branch similar input cancellation circuit are generated on the output of the main signal branch similar input combination and input cancellation parallel circuit or main signal branch similar input combination and input cancellation series circuit, to implement a combination cancellation mixed distorted signal;
in the combination cancellation mixed distorted signal, when the distorted signal having input same-phase combination compensation outputted by the branch similar input combiner circuit has the characteristic of compensating for the extension of the linear gain dynamic range of the main power signals among the Class C main power signals outputted by the Class C main power amplifier circuit that are less than the input combination equal-power point to have the main power signals with lower output power level, and on the output of the branch similar input combination and main signal combiner main circuit in the branch similar input combination and input cancellation combiner main circuit, when the time delays equal to the input combination equal-power point are equal, the amplitudes are equal or nearly equal, and the phase of the two circuits are within the range from 0 degree to 45 degrees, the distorted signal having same-phase combination compensation outputted by the branch similar input combiner circuit and the compensation extension of the linear gain dynamic range of the main power signals among the Class C main power signals outputted by the Class C main power amplifier circuit that are less than the input combination equal-power point to the main power signals with lower output power level are realized, and an EVM value and a gain fluctuation are increased within the linear gain dynamic range that has been extended to the main power signals with lower output power level, thereby increasing a linear ACPR value of the Class C main power signal with the extended linear gain dynamic range of the main power signals of the branch similar input combination and main signal combiner main circuit to above 30-35 dBc;
when the linear ACPR value of the Class C main power signal with the extended linear gain dynamic range of the main power signals reaches above 30-35 dBc on the output of the branch similar input combination and main signal combiner main circuit, the pre-distorted signal having input reversed-phase similar cancellation outputted by the branch similar input cancellation circuit in the combination cancellation mixed distorted signal has the characteristic similar to that of the distorted signal greater than the input cancellation equal-power point in the Class C main power signal with the extended linear gain dynamic range of the main power signals of the branch similar input combination and main signal combiner main circuit, and on the output of the branch similar input combination and input cancellation combiner main circuit, when the time delays equal to the input cancellation equal-power point are equal or nearly equal, the amplitudes are equal or nearly equal, and the phase are opposite or nearly opposite, the reversed-phase similar cancellation between the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, thereby increasing a linear ACPR value of the Class C main power signal with the extended linear gain dynamic range of the main power signals outputted by the branch similar input combination and input cancellation combiner main circuit to above 40-45 dBC; or the reversed-phase similar cancellation between the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, the linear gain dynamic range of the main power signals is achieved to extend a linear gain dynamic range of a Class C output main power signal, to further extend to the main power signals with lower output power level, and the EVM value and the gain fluctuation are increased within the linear gain dynamic range that has been extended to the main power signals with lower output power level, thereby increasing the linear ACPR value of the Class C main power signal with the extended or further extended linear gain dynamic range of the main power signals of the branch similar input combination and input cancellation combiner main circuit to above 40-45 dBC, and improving the overall efficiency of the similar combination and cancellation power amplifier circuit;
or through a combination input divider circuit or through a combination digital input divider circuit and a combination output coupling circuit, analog input ports of the two circuits, which are the branch similar input combination and input cancellation combiner main circuit and a branch similar output cancellation circuit, or digital input ports of the two circuits or one analog input port and one digital input port in the two circuits are parallelly connected to outputs of the two circuits, to implement the similar combination and cancellation power amplifier circuit having a function of a branch similar input combination cancellation and branch output cancellation combiner main circuit;
in a branch similar input combination cancellation and branch output cancellation combiner main circuit, only one input combination or input cancellation main signal time-delay adjustment circuit is provided;
a distorted signal having output reversed-phase similar cancellation is generated on the output of the branch similar output cancellation circuit, and has a characteristic similar to that of the distorted signal greater than an output cancellation equal-power point in the Class C main power signal with the extended linear gain dynamic range of the main power signals of the branch similar input combination and input cancellation combiner main circuit;
output cancellation features of an output of the branch similar input combination cancellation and branch output cancellation combiner main circuit are as follows:
when the linear ACPR value of the Class C main power signal with the extended linear gain dynamic range of the main power signals reaches above 40-45 dBC on an output of the branch similar input combination and input cancellation combiner main circuit, and when time delays at the output cancellation equal-power point in the branch similar input combination cancellation and branch output cancellation combiner main circuit are equal or nearly equal, amplitudes are equal or nearly equal, and phase are opposite or nearly opposite, the distorted signal generated by the branch similar output cancellation circuit and having the output reversed-phase similar cancellation characteristic is similar to the distorted signal greater than the output cancellation equal-power point in the Class C main power signal with the extended linear gain dynamic range of the main power signals outputted by the branch similar input combination and input cancellation combiner main circuit, such that the distorted signal having output reversed-phase similar cancellation generated by the branch similar output cancellation circuit and a distorted signal greater than an output cancellation equal-power point in a Class C main power signal with an extended linear gain dynamic range of main power signals outputted by a main similar input combination and input cancellation combiner main circuit cancel out each other, thereby increasing a linear ACPR value of the Class C main power signal further extended by the main power signals outputted by the branch similar input combination cancellation and branch output cancellation combiner main circuit to more than 50-55 dBC, or a distorted signal having output reversed-phase equality cancellation generated by the branch similar output cancellation circuit and the distorted signal greater than the output cancellation equal-power point in the Class C main power signal with the extended linear gain dynamic range of the main power signals outputted by the main similar input combination and input cancellation combiner main circuit cancel out each other, the linear gain of a Class C output main power signal with the extended linear gain dynamic range of the main power signals is extended through the reverse compensation characteristic of the Class C main power signal with the extended linear gain dynamic range of the main power signals of the branch similar input combination and input cancellation combiner main circuit generated by the branch similar output cancellation circuit, to further extend to have a smaller output main power signal range, and an EVM value and a gain fluctuation are increased within the further extended linear gain dynamic range, thereby increasing the linear ACPR value of the Class C main power signal further extended by the main power signals outputted by the branch similar input combination cancellation and branch output cancellation combiner main circuit to more than 50-55 dBC, and improving overall efficiency;
or a main power output of a feed-forward distortion extraction circuit of the branch similar input combination and input cancellation combiner main circuit is connected to a main power input of a main feed-forward output cancellation circuit, and a distortion output of the feed-forward distortion extraction circuit of the branch similar input combination and input cancellation combiner main circuit is connected to a distortion input of the main feed-forward output cancellation circuit, to implement a similar combination and cancellation power amplifier circuit having a function of a branch similar input combination cancellation and feed-forward output cancellation series circuit;
in the branch similar input combination cancellation and feed-forward output cancellation series circuit, from a main input of a main feed-forward input coupling circuit to an output of a feed-forward cancellation coupling circuit via a feed-forward main time-delay circuit and via a feed-forward distortion adjustment power amplifier circuit connected to an output of a feed-forward distortion output combiner circuit, a main feed-forward combination cancellation circuit from the input of the main feed-forward input coupling circuit to the output of the feed-forward cancellation coupling circuit is implemented; and
same type cancellation features of an output of the branch similar input combination cancellation and feed-forward output cancellation series circuit are as follows: when Class C main power linear ACPR of the extended linear gain dynamic range of the main power signals reaches above 40-45 dBC on the output of the branch similar input combination and input cancellation combiner main circuit, on the output of the branch similar input combination cancellation and feed-forward output cancellation series circuit, when time delays at a feed-forward cancellation equal-power point are equal or nearly equal, amplitudes are equal or nearly equal, and phase are opposite or nearly opposite, a distorted signal in a Class C main power signal with an extended linear gain dynamic range of main power signals outputted by the branch similar input combination and input cancellation combiner main circuit is extracted by the distortion output of the feed-forward distortion extraction circuit of the branch similar input combination and input cancellation combiner main circuit and a distorted signal in a Class C main power signal with an extended linear gain dynamic range of main power signals outputted by the main power output of the feed-forward distortion extraction circuit of the branch similar input combination and input cancellation combiner main circuit are the same type of distorted signals, on an output of a main feed-forward combination cancellation circuit, when the time delays at the feed-forward cancellation equal-power point are equal or nearly equal, the amplitudes are equal or nearly equal, and the phase are opposite or nearly opposite, the same type distortion signal cancellation of the distorted signal in the Class C main power signal with the extended linear gain dynamic range of the main power signals outputted by the branch similar input combination and input cancellation combiner main circuit is realized, and a linear gain dynamic range of the Class C output main power signal with the extended linear gain dynamic range of the main power signals is further extended to reach a linear gain dynamic range of a Class AB output main power, and an EVM value and a gain fluctuation are increased within the linear gain dynamic range that has been extended, thereby causing a Class C total linear dynamic range of Class AB output main power signals outputted by the branch similar input combination cancellation and feed-forward output cancellation series circuit to reach a linear ACPR value of the Class AB output main power signal to more than 50-55 dBC, and improving the overall efficiency.

2. The similar combination and cancellation power amplifier circuit according to claim 1, wherein the similar combination and cancellation power amplifier circuit having a function of the branch similar input combination and input cancellation combiner main circuit is implemented by connecting the output of the main signal branch similar input combination and input cancellation parallel circuit or main signal branch similar input combination and input cancellation series circuit to the main power amplifier circuit, and the output of the main signal and branch similar input combination combiner circuit in the main signal branch similar input combination and input cancellation parallel circuit or main signal branch similar input combination and input cancellation series circuit is connected to the input of the main power amplifier circuit, to implement the branch similar input combination and main signal combiner main circuit;
the branch similar input combiner circuit is configured to output the distorted signal having input same-phase combination compensation, which has the characteristic of compensating for extension of the linear gain dynamic range of main power signals among the Class C main power signals outputted by the Class C main power amplifier circuit that are less than the input combination equal-power point to have the main power signals with lower output power level;
the branch similar input cancellation circuit is configured to output the pre-distorted signal having input reversed-phase similar cancellation, which has the characteristic similar to that of the distorted signal greater than the input cancellation equal-power point in the Class C main power signal with the extended linear gain dynamic range of main power signals of the branch similar input combination and main signal combiner main circuit;
the input combination and input cancellation features of the output of the branch similar input combination and input cancellation combiner main circuit are as follows: at the input combination equal-power point in the branch similar input combination and main signal combiner main circuit and the input cancellation equal-power point in the branch similar input combination and input cancellation combiner main circuit, when the main power amplifier circuit is the Class C power amplifier circuit, at equal or nearly equal time delays, equal or nearly equal amplitudes, and when the phase of the two circuits in the branch similar input combination and main signal combiner main circuit are within the range from 0 degree to 45 degrees, and the phase of the branch similar input combination and input cancellation combiner main circuit are opposite or nearly opposite, in the main signal branch similar input combination and input cancellation parallel circuit or main signal branch similar input combination and input cancellation series circuit meeting the above conditions, the distorted signal having input same-phase combination compensation outputted by the branch similar input combiner circuit and the pre-distorted signal having input reversed-phase similar cancellation outputted by the branch similar input cancellation circuit are generated on the output of the main signal branch similar input combination and input cancellation parallel circuit or main signal branch similar input combination and input cancellation series circuit, to implement the combination cancellation mixed distorted signal;
in the combination cancellation mixed distorted signal, when the distorted signal having input same-phase combination compensation outputted by the branch similar input combiner circuit has the characteristic of compensating for the extension of the linear gain dynamic range of the main power signals among the Class C main power signals outputted by the Class C main power amplifier circuit that are less than the input combination equal-power point to the main power signals with lower output power level, and on the output of the branch similar input combination and main signal combiner main circuit in the branch similar input combination and input cancellation combiner main circuit, when the time delays equal to the input combination equal-power point are equal, the amplitudes are equal or nearly equal, and the phase of the two circuits are within the range from 0 degree to 45 degrees, the distorted signal having same-phase combination compensation outputted by the branch similar input combiner circuit and the compensation extension of the linear gain dynamic range of the main power signals among the Class C main power signals outputted by the Class C main power amplifier circuit that are less than the input combination equal-power point to the main power signals with lower output power level are realized, and the EVM value and the gain fluctuation are increased within the linear gain dynamic range that has been extended to the main power signals with lower output power level, thereby increasing the linear ACPR value of the Class C main power signal with the extended linear gain dynamic range of the main power signals of the branch similar input combination and main signal combiner main circuit to above 30-35 dBc; and
when the linear ACPR value of the Class C main power signal with the extended linear gain dynamic range of the main power signals reaches above 30-35 dBc on the output of the branch similar input combination and main signal combiner main circuit, the pre-distorted signal having input reversed-phase similar cancellation outputted by the branch similar input cancellation circuit in the combination cancellation mixed distorted signal has the characteristic similar to that of the distorted signal greater than the input cancellation equal-power point in the Class C main power signal with the extended linear gain dynamic range of the main power signals of the branch similar input combination and main signal combiner main circuit, and on the output of the branch similar input combination and input cancellation combiner main circuit, when the time delays equal to the input cancellation equal-power point are equal or nearly equal, the amplitudes are equal or nearly equal, and the phase are opposite or nearly opposite, the reversed-phase similar cancellation between the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, thereby increasing the linear ACPR value of the Class C main power signal with the extended linear gain dynamic range of the main power signals outputted by the branch similar input combination and input cancellation combiner main circuit to above 40-45 dBC; or the reversed-phase similar cancellation between the pre-distorted signal having input reversed-phase similar cancellation generated by the branch similar input cancellation circuit and the distorted signal greater than the input cancellation equal-power point in the Class C main power signal with the extended linear gain dynamic range of the main power signals of the branch similar input combination and main signal combiner main circuit is realized, the linear gain dynamic range of the main power signals is achieved to extend the linear gain dynamic range of the Class C output main power signal, to further extend to the main power signals with lower output power level, and the EVM value and the gain fluctuation are increased within the linear gain dynamic range that has been extended to the main power signals with lower output power level, thereby increasing the linear ACPR value of the Class C main power signal with the extended or further extended linear gain dynamic range of the main power signals of the branch similar input combination and input cancellation combiner main circuit to above 40-45 dBC, and improving the overall efficiency of the similar combination and cancellation power amplifier circuit.

3. The similar combination and cancellation power amplifier circuit according to claim 1 or 2, wherein the main power amplifier circuit in the branch similar input combination and input cancellation combiner main circuit is the Class C power amplifier circuit, which is implemented by a single Class C power amplifier circuit or at least one of a plurality of Class C power amplifier circuits through combination or by combining impedance transformation networks.

4. The similar combination and cancellation power amplifier circuit according to claim 1, wherein in the branch similar input combination and input cancellation combiner main circuit of the similar combination and cancellation power amplifier circuit, the main signal branch similar input combination and input cancellation parallel circuit is implemented through the parallel input divider circuit or through the parallel digital input divider circuit and the parallel output combiner circuit by parallelly connecting analog input ports of two circuits, which are a combiner circuit of a main signal and branch similar input combination combiner circuit of the distortion extraction adjustment amplifier circuit for analog distortion in the main signal and branch similar input combination combiner circuit, or a branch similar input combination analog digital distortion circuit, or a branch similar input combination digital distortion circuit, and the branch similar input cancellation circuit, or one analog input port and one digital input port in the two circuits or the digital input ports of the two circuits and outputs of the two circuits; or implemented through the parallel input divider circuit or through the parallel digital input divider circuit and the parallel output combiner circuit by parallelly connecting analog input ports of two circuits, which are a distortion extraction adjustment amplification combiner circuit for analog pre-distortion of the main signal and branch similar input cancellation in the main signal and branch similar input cancellation combiner circuit, or a distortion extraction adjustment amplification combiner circuit of a branch similar input combination and main signal combined auxiliary circuit for branch similar input cancellation, or a branch similar input cancellation analog digital pre-distortion circuit, or a branch similar input cancellation digital pre-distortion circuit, and the branch similar input combiner circuit, or one analog input port and one digital input port in the two circuits or the digital input ports of the two circuits and outputs of the two circuits; or implemented through the parallel input divider circuit or through the parallel digital input divider circuit and the parallel output combiner circuit by parallelly connecting the inputs of two circuits, which are the branch similar input combination and input cancellation combiner circuit and the corresponding input combination or input cancellation main signal time-delay adjustment circuit, or one analog input port and one digital input port in the two circuits and outputs of the two circuits, wherein the input of the parallel input divider circuit or the digital input port of the parallel digital input divider circuit and the output of the parallel output combiner circuit are the corresponding input or digital input port and the output of the main signal branch similar input combination and input cancellation parallel circuit;
in the main signal branch similar input combination and input cancellation parallel circuit, only one input combination or input cancellation main signal time-delay adjustment circuit is provided, and in the main signal and branch similar input combination combiner circuit or the main signal and branch similar input cancellation combiner circuit, only one input combination or input cancellation main signal time-delay adjustment circuit is provided;
cancellation features of the combination cancellation mixed distorted signal of the main signal branch similar input combination and input cancellation parallel circuit in the branch similar input combination and input cancellation combiner main circuit are as follows: at the input combination equal-power point in the branch similar input combination and main signal combiner main circuit and the input cancellation equal-power point in the branch similar input combination and input cancellation combiner main circuit, when the main power amplifier circuit is the Class C power amplifier circuit, at equal or nearly equal time delays, equal or nearly equal amplitudes, and when the phase of the two circuits in the branch similar input combination and main signal combiner main circuit are within the range from 0 degree to 45 degrees, and the phase of the branch similar input combination and input cancellation combiner main circuit are opposite or nearly opposite, in the main signal branch similar input combination and input cancellation parallel circuit meeting the above conditions, the distorted signal having input same-phase combination compensation outputted by the branch similar input combiner circuit and the pre-distorted signal having input reversed-phase similar cancellation outputted by the branch similar input cancellation circuit are generated on the output of the main signal branch similar input combination and input cancellation parallel circuit, to implement the combination cancellation mixed distorted signal;
in the combination cancellation mixed distorted signal, the distorted signal having input same-phase combination compensation outputted by the branch similar input combiner circuit has the characteristic of compensating for the extension of the linear gain dynamic range of the main power signals among the Class C main power signals outputted by the Class C main power amplifier circuit that are less than the input combination equal-power point to have the main power signals with lower output power level; and
in the combination cancellation mixed distorted signal, the pre-distorted signal having input reversed-phase similar cancellation generated by the branch similar input cancellation circuit has the characteristic similar to that of the distorted signal greater than the input cancellation equal-power point in the Class C main power signal with the extended linear gain dynamic range of the main power signals of the branch similar input combination and main signal combiner main circuit.

5. The similar combination and cancellation power amplifier circuit according to claim 1, wherein in the branch similar input combination and input cancellation combiner main circuit of the similar combination and cancellation power amplifier circuit, the main signal branch similar input combination and input cancellation series circuit is implemented by serially connecting the main signal and branch similar input combination combiner circuit and the main signal and branch similar input cancellation combiner circuit, wherein the input of the main signal and branch similar input cancellation combiner circuit and the output of the main signal and branch similar input combination combiner circuit or the input of the branch similar input combination combiner circuit and the output of the branch similar input cancellation combiner circuit are the corresponding input and output of the main signal branch similar input combination and input cancellation series circuit;
the main signal and branch similar input combination combiner circuit comprises a main signal and branch similar input combination combiner circuit of the distortion extraction adjustment amplifier circuit for analog distortion, a branch similar input combination analog digital distortion circuit, and a branch similar input combination digital distortion circuit;
the main signal and branch similar input cancellation combiner circuit comprises a combiner circuit of a distortion extraction adjustment amplifier circuit for analog pre-distortion of the main signal and branch similar input cancellation, a branch similar input cancellation analog digital pre-distortion circuit, a branch similar input cancellation digital pre-distortion circuit, and a combiner circuit of a distortion extraction adjustment amplifier circuit of a branch similar input combination and main signal combined auxiliary circuit for main signal and branch similar input cancellation;
in the main signal and branch similar input combination combiner circuit or main signal and branch similar input cancellation combiner circuit, only one input combination or input cancellation main signal time-delay adjustment circuit is provided;
features of the combination cancellation mixed distorted signal of the main signal branch similar input combination and input cancellation series circuit in the branch similar input combination and input cancellation combiner main circuit are as follows: at the input combination equal-power point in the branch similar input combination and main signal combiner main circuit and the input cancellation equal-power point in the branch similar input combination and input cancellation combiner main circuit, when the main power amplifier circuit is the Class C power amplifier circuit, at equal or nearly equal time delays, equal or nearly equal amplitudes, and when the phase of the two circuits in the branch similar input combination and main signal combiner main circuit are within the range from 0 degree to 45 degrees, and the phase of the branch similar input combination and input cancellation combiner main circuit are opposite or nearly opposite, in the main signal branch similar input combination and input cancellation series circuit meeting the above conditions, the distorted signal having input same-phase combination compensation outputted by the branch similar input combiner circuit and the pre-distorted signal having input reversed-phase similar cancellation outputted by the branch similar input cancellation circuit are generated on the output of the main signal branch similar input combination and input cancellation series circuit, to implement the combination cancellation mixed distorted signal;
in the combination cancellation mixed distorted signal, the distorted signal having input same-phase combination compensation outputted by the branch similar input combiner circuit has the characteristic of compensating for the extension of the linear gain dynamic range of the main power signals among the Class C main power signals outputted by the Class C main power amplifier circuit that are less than the input combination equal-power point to have the main power signals with lower output power level; and
in the combination cancellation mixed distorted signal, the pre-distorted signal having input reversed-phase similar cancellation generated by the branch similar input cancellation circuit has the characteristic similar to that of the distorted signal greater than the input cancellation equal-power point in the Class C main power signal with the extended linear gain dynamic range of the main power signals of the branch similar input combination and main signal combiner main circuit.

6. The similar combination and cancellation power amplifier circuit according to claim 1, wherein the main signal and branch similar input combination combiner circuit is parallelly connected to outputs of two circuits, which are a distortion extraction adjustment amplifier circuit for analog distortion of a branch similar input combination in the branch similar input combiner circuit, or a distortion extraction adjustment amplifier circuit for analog digital distortion of branch similar input combination, or a distortion extraction adjustment amplifier circuit for digital distortion of branch similar input combination, and a corresponding input combination main signal time-delay adjustment circuit, or one analog input port and one digital input port in the two circuits and outputs of the two circuits through a branch-main combination input divider circuit or a branch-main combination digital input divider circuit and a branch-main combination output combiner circuit, to implement the main signal and branch similar input combination combiner circuit;
since a branch similar input combination analog digital distortion circuit includes the main signal and the distorted signal, a branch similar input combination analog digital pre-distortion circuit or a branch similar input combination digital distortion circuit directly implements the main signal and branch similar input combination combiner circuit;
the branch similar input combiner circuit includes the branch similar input combination distortion extraction and adjustment amplifier circuit for analog distortion, the distortion extraction adjustment amplifier circuit for analog digital distortion of branch similar input combination, and the distortion extraction adjustment amplifier circuit for digital distortion of the branch similar input combination; and
in the main signal and branch similar input combination combiner circuit, only one input combination main signal time-delay adjustment circuit is provided.

7. The similar combination and cancellation power amplifier circuit according to claim 1, wherein the main signal and branch similar input cancellation combiner circuit is parallelly connected to inputs of two circuits, which are a distortion extraction adjustment amplifier circuit for analog pre-distortion of branch similar input cancellation in the branch similar input cancellation circuit, or a distortion extraction adjustment amplifier circuit for analog digital pre-distortion of branch similar input cancellation, or a distortion extraction adjustment amplifier circuit for digital pre-distortion of branch similar input cancellation, or a distortion extraction adjustment amplifier circuit of a branch similar input combination and main signal combined auxiliary circuit for branch similar input cancellation, and a corresponding input cancellation main signal time-delay adjustment circuit, or one analog input port and one digital input port in the two circuits and outputs of the two circuits through a branch-main cancellation input divider circuit or through a branch-main cancellation digital input divider circuit and a branch-main cancellation output combiner circuit, to implement the main signal and branch similar input cancellation combiner circuit;
the branch similar input cancellation circuit comprises the distortion extraction adjustment amplifier circuit for analog pre-distortion of branch similar input cancellation, the distortion extraction adjustment amplifier circuit for analog digital pre-distortion of branch similar input cancellation, the distortion extraction adjustment amplifier circuit for digital pre-distortion of branch similar input cancellation, and the distortion extraction adjustment amplifier circuit of the branch similar input combination and main signal combined auxiliary circuit for branch similar input cancellation; and
in the main signal and branch similar input cancellation combiner circuit, only one input cancellation main signal time-delay adjustment circuit is provided.

8. The similar combination and cancellation power amplifier circuit according to claim 1, wherein the branch similar input combination and input cancellation combiner circuit therein is parallelly connected to the inputs of the two circuits, which are the branch similar input combiner circuit and the branch similar input cancellation circuit, or the digital input ports of the two circuits or one analog input port and one digital input port in the two circuits and the outputs of the two circuits through the branch-main combination or branch-main cancellation input divider circuit or through the branch-main combination or branch-main cancellation digital input divider circuit and the branch-main combination or branch-main cancellation output combiner circuit, to implement the branch similar input combination and input cancellation combiner circuit;
the branch similar input combiner circuit includes the distortion extraction adjustment amplifier circuit for analog distortion of the branch similar input combination, the distortion extraction adjustment amplifier circuit for analog digital distortion of the branch similar input combination, and the distortion extraction adjustment amplifier circuit for digital distortion of the branch similar input combination; and
the branch similar input cancellation circuit comprises a distortion extraction adjustment amplifier circuit for analog pre-distortion of branch similar input cancellation, a distortion extraction adjustment amplifier circuit for analog digital pre-distortion of branch similar input cancellation, a distortion extraction adjustment amplifier circuit for digital pre-distortion of branch similar input cancellation, and a distortion extraction adjustment amplifier circuit of a branch similar input combination and main signal combined auxiliary circuit for branch similar input cancellation.

9. The similar combination and cancellation power amplifier circuit according to claim 1, wherein circuit features of the branch similar input combiner circuit are as follows: an output of a branch similar input combination analog distortion circuit, or an output of a branch similar input combination analog digital distortion circuit, or an output of a branch similar input combination digital distortion circuit is connected to a main input of an input combination coupling output load circuit or an input of an amplitude adjustment attenuation circuit of input combination, to implement a branch similar input combination signal extraction circuit for analog distortion, or implement a signal extraction circuit for analog digital distortion of branch similar input combination, or implement a signal extraction circuit for digital distortion of branch similar input combination, and a main signal adjustment power amplifier circuit of input combination, an output of a branch similar input combination distortion extraction circuit for analog distortion, or an output of a distortion extraction circuit for analog digital distortion of branch similar input combination, or an output of a distortion extraction circuit for digital distortion of the branch similar input combination implemented by parallelly connecting the analog input ports of the corresponding two circuits or one digital input port and one analog input port in the two circuits and the outputs of the two circuits through an input combiner and output divider circuit or through an input combination digital input divider circuit and an input combination distortion output combiner circuit is connected to an input of a distortion adjustment power amplifier circuit of input combination, to implement the branch similar input combiner circuit having a function of a branch similar input combination distortion extraction and adjustment amplifier circuit for analog distortion, or having a function of a distortion extraction adjustment amplifier circuit for analog digital distortion of branch similar input combination, or having a function of a distortion extraction adjustment amplifier circuit for digital distortion of branch similar input combination, and by generating the distorted signal having input same-phase combination compensation, the branch similar input combiner circuit has the characteristic of compensating for the extension of the linear gain dynamic range of the main power signals among the Class C main power signals outputted by the Class C main power amplifier circuit that are less than the input combination equal-power point to have the main power signals with lower output power level;
an input of the input divider circuit of the input combination or the digital input divider circuit of the input combination in the branch similar input combiner circuit and an output of the distortion adjustment power amplifier circuit of the input combination respectively correspond to an input and an output of the branch similar input combination distortion extraction and adjustment amplifier circuit for analog distortion, or an input and an output of the distortion extraction adjustment amplifier circuit for analog digital distortion of branch similar input combination, or an input and an output of the distortion extraction adjustment amplifier circuit for digital distortion of the branch similar input combination;
the analog distortion circuit of the branch similar input combination, implemented by a low-power input combination branch power amplifier circuit or an input combination branch feed-forward power amplifier circuit, has, by generating the distorted signal with input same-phase combination compensation, to get the characteristic of compensating for extension of the linear gain dynamic range of main power signals among the Class C main power signals outputted by the Class C main power amplifier circuit that are less than the input combination equal-power point to have the main power signals with lower output power level; and
the analog digital distortion circuit or digital pre-distortion circuit of the branch similar input combination has, by generating the distorted signal having input same-phase combination compensation, the characteristic of compensating for extension of the linear gain dynamic range of main power signals among the Class C main power signals outputted by the Class C main power amplifier circuit that are less than the input combination equal-power point to the main power signals with lower output power level, and is implemented by connecting an output of an input combination digital-to-analog conversion circuit and an input of a low-power input combination analog power amplifier circuit, wherein a feedback input of the analog digital distortion circuit or digital pre-distortion circuit of the branch similar input combination is connected and mounted to a feedback output of an input combination coupling feedback adjustment circuit on the output of the main power amplifier circuit, to implement the corresponding main signal and branch similar input combination combiner circuit having a function of the analog digital distortion circuit or digital pre-distortion circuit of the branch similar input combination.

10. The similar combination and cancellation power amplifier circuit according to claim 1, wherein circuit features of the branch similar input cancellation circuit are as follows: an output of an analog pre-distortion circuit for branch similar input cancellation, or an output of a branch similar input cancellation analog digital pre-distortion circuit, or an output of a branch similar input cancellation digital pre-distortion circuit, or an output of a branch similar input combination and main signal combined auxiliary circuit for branch similar input cancellation is connected to an input of a main circuit of a coupling output load circuit for input cancellation or an input of an amplitude adjustment attenuation circuit for input cancellation, to implement a signal extraction circuit for analog pre-distortion of branch similar input cancellation, or implement a signal extraction circuit for analog digital pre-distortion of branch similar input cancellation, or implement a signal extraction circuit for digital pre-distortion of branch similar input cancellation, or implement a signal extraction circuit of the branch similar input combination and main signal combined auxiliary circuit for branch similar input cancellation, and a main signal adjustment power amplifier circuit of input cancellation, an output of a distortion extraction circuit for analog pre-distortion of branch similar input cancellation, or an output of a distortion extraction circuit for analog digital pre-distortion of branch similar input cancellation, or an output of a distortion extraction circuit for digital pre-distortion of branch similar input cancellation, or an output of a distortion extraction circuit of the branch similar input combination and main signal combined auxiliary circuit for branch similar input cancellation are implemented by parallelly connecting the analog input ports of the corresponding two circuits or one digital input port and one analog input port in the two circuits and the outputs of the two circuits through an input cancellation input divider circuit or through an input cancellation digital input divider circuit and an input cancellation distortion output combiner circuit is connected to an input of a distortion adjustment power amplifier circuit for input cancellation, to implement the branch similar input cancellation circuit having a function of a distortion extraction adjustment amplifier circuit for analog pre-distortion of branch similar input cancellation, or having a function of a distortion extraction adjustment amplifier circuit for analog digital pre-distortion of branch similar input cancellation, or having a function of a distortion extraction adjustment amplifier circuit for digital pre-distortion of branch similar input cancellation, or having a function of a distortion extraction adjustment amplifier circuit of the branch similar input combination and main signal combined auxiliary circuit for branch similar input cancellation, and by generating the pre-distorted signal having input reversed-phase similar cancellation, the branch similar input cancellation circuit has the characteristic similar to that of the distorted signal greater than the input cancellation equal-power point in the Class C main power signal with the extended linear gain dynamic range of the main power signals of the branch similar input combination and main signal combiner main circuit;
an input of the input cancellation input divider circuit or the input cancellation digital input divider circuit in the branch similar input cancellation circuit and an output of the distortion adjustment power amplifier circuit for input cancellation are respectively correspond to an input and an output of the distortion extraction adjustment amplifier circuit for analog pre-distortion of branch similar input cancellation, or an input and an output of the distortion extraction adjustment amplifier circuit for analog digital pre-distortion of branch similar input cancellation, or an input and an output of the distortion extraction adjustment amplifier circuit for digital pre-distortion of branch similar input cancellation, or and input and an output of the distortion extraction adjustment amplifier circuit of the branch similar input combination and main signal combined auxiliary circuit for branch similar input cancellation;
the branch similar input cancellation circuit implemented by the analog pre-distortion circuit for branch similar input cancellation through a low-power input cancellation branch power amplifier circuit or an input cancellation branch feed-forward power amplifier circuit has, by generating the pre-distorted signal having input reversed-phase similar cancellation, the characteristic similar to that of the distorted signal greater than the input cancellation equal-power point in the Class C main power signal with the extended linear gain dynamic range of main power signals of the branch similar input combination and main signal combiner main circuit;
by replacing the main power amplifier circuit in the branch similar input combination and main signal combiner main circuit with a similar low-power Class C input first auxiliary power amplifier circuit, the branch similar input combination and main signal combined auxiliary circuit for branch similar input cancellation generates the pre-distorted signal having input reversed-phase similar cancellation, and has the characteristic similar to that of the distorted signal greater than the input cancellation equal-power point in the Class C main power signal with the extended linear gain dynamic range of the main power signals outputted by the branch similar input combination and main signal combiner main circuit;
the pre-distorted signal having input reversed-phase similar cancellation generated by the branch similar input cancellation analog digital pre-distortion circuit or the branch similar input cancellation digital pre-distortion circuit has the characteristic similar to that of the distorted signal greater than the input cancellation equal-power point in the Class C main power signal with the extended linear gain dynamic range of main power signals of the branch similar input combination and main signal combiner main circuit, and is implemented by connecting an output of an input cancellation digital-to-analog conversion circuit and an input of a low-power input cancellation analog power amplifier circuit, wherein a feedback input of the branch similar input cancellation analog digital pre-distortion circuit or the branch similar input cancellation digital pre-distortion circuit is connected and mounted to a feedback output of an input cancellation coupling feedback adjustment circuit on the output of the main power amplifier circuit, to implement the corresponding main signal and branch similar input cancellation combiner circuit having a function of the branch similar input cancellation analog digital pre-distortion circuit or the branch similar input cancellation digital pre-distortion circuit; and
the input and another output of the input cancellation input divider circuit connected to the input of the input cancellation main signal adjustment power amplifier circuit in the branch similar input cancellation circuit are perhaps mounted in the input cancellation main signal time-delay adjustment circuit.

11. The similar combination and cancellation power amplifier circuit according to claim 1, wherein the input combination or input cancellation main signal time-delay adjustment circuit is implemented by serially connecting an input combination or input cancellation time-delay circuit and an input combination or input cancellation adjustable attenuation circuit or an input combination or input cancellation amplitude adjustable circuit, and meets a main power signal requirement in the branch similar input combination and input cancellation combiner main circuit without generating a new distorted signal.

12. The similar combination and cancellation power amplifier circuit according to claim 1, wherein through the combination input divider circuit or through the combination digital input divider circuit and the combination output coupling circuit, the analog input ports of the two circuits, which are the branch similar input combination and input cancellation combiner main circuit and the branch similar output cancellation circuit, or the digital input ports of the two circuits or one analog input port and one digital input port in the two circuits are parallelly connected to the outputs of the two circuits, to implement the similar combination and cancellation power amplifier circuit having a function of the branch similar input combination cancellation and branch output cancellation combiner main circuit;
the branch similar output cancellation circuit outputs the distorted signal having output reversed-phase similar cancellation, and has the characteristic similar to that of the distorted signal greater than the output cancellation equal-power point in the Class C main power signal with the extended linear gain dynamic range of the main power signals of the branch similar input combination and input cancellation combiner main circuit;
the branch similar output cancellation circuit comprises a distortion extraction adjustment amplifier circuit for analog distortion of branch similar output cancellation, a distortion extraction adjustment amplifier circuit for analog digital distortion of branch similar output cancellation, a distortion extraction adjustment amplifier circuit for digital distortion of branch similar output cancellation, or a distortion extraction adjustment amplifier circuit of a branch similar input combination and input cancellation combined auxiliary circuit for branch similar output cancellation; and
the output cancellation features of the output of the branch similar input combination cancellation and branch output cancellation combiner main circuit are as follows: when the linear ACPR value of the Class C main power signal with the extended linear gain dynamic range of the main power signals reaches above 40-45 dBC on the output of the branch similar input combination and input cancellation combiner main circuit, and when the time delays at the output cancellation equal-power point in the branch similar input combination cancellation and branch output cancellation combiner main circuit are equal or nearly equal, the amplitudes are equal or nearly equal, and the phase are opposite or nearly opposite, the distorted signal having the output reversed-phase similar cancellation characteristic generated and implemented by the branch similar output cancellation circuit is similar to the distorted signal greater than the output cancellation equal-power point in the Class C main power signal with the extended linear gain dynamic range of the main power signals outputted by the branch similar input combination and input cancellation combiner main circuit, such that the distorted signal having output reversed-phase similar cancellation generated by the branch similar output cancellation circuit and the distorted signal greater than the output cancellation equal-power point in the Class C main power signal with the extended linear gain dynamic range of main power signals outputted by the main similar input combination and input cancellation combiner main circuit cancel out each other, thereby increasing the linear ACPR value of the Class C main power signal further extended by the main power signals outputted by the branch similar input combination cancellation and branch output cancellation combiner main circuit to more than 50-55 dBC, or the distorted signal having output reversed-phase equality cancellation generated by the branch similar output cancellation circuit and the distorted signal greater than the output cancellation equal-power point in the Class C main power signal with the extended linear gain dynamic range of the main power signals outputted by the main similar input combination and input cancellation combiner main circuit cancel out each other, the linear gain of the Class C output main power signal with the extended linear gain dynamic range of the main power signals is extended through the reverse compensation characteristic of the Class C main power signal with the extended linear gain dynamic range of the main power signals of the branch similar input combination and input cancellation combiner main circuit generated by the branch similar output cancellation circuit, to further extend to have the smaller output main power signal range, and the EVM value and the gain fluctuation are increased within the further extended linear gain dynamic range.

13. The similar combination and cancellation power amplifier circuit according to claim 1, wherein in the branch similar input combination cancellation and branch output cancellation combiner main circuit, the features of the branch similar output cancellation circuit are as follows: an output of an analog distortion circuit for branch similar output cancellation, or an output of an analog branch similar output cancellation digital distortion circuit, or an output of a branch similar output cancellation digital distortion circuit, or an output of a branch similar input combination and input cancellation combined auxiliary circuit for branch similar output cancellation is connected to an input of a main circuit of a coupling output load circuit for output cancellation or an input of an amplitude adjustment attenuation circuit for output cancellation, to implement an analog distorted signal extraction circuit for branch similar output cancellation, or implement an analog digital distorted signal extraction circuit for branch similar output cancellation, or implement a branch similar output cancellation signal extraction circuit for digital distortion , or implement a signal extraction circuit of the branch similar input combination and input cancellation combined auxiliary circuit for branch similar output cancellation, and an output cancellation main signal adjustment power amplifier circuit; an output of a distortion extraction circuit for analog distortion of branch similar output cancellation, or an output of a distortion extraction circuit for analog digital distortion of branch similar output cancellation, or an output of a branch similar output cancellation distortion extraction circuit for digital distortion, or an output of a distortion extraction circuit of the branch similar input combination and input cancellation combined auxiliary circuit for branch similar output cancellation implemented by parallelly connecting the analog input ports of the two circuits or one digital input port and one analog input port in the two circuits and the outputs of the two circuits through an output cancellation input divider circuit or an output cancellation digital input divider circuit and an output cancellation distortion output combiner circuit is connected to an input of an output cancellation distortion adjustment power amplifier circuit, to implement the branch similar output cancellation circuit having a function of a distortion extraction adjustment amplifier circuit for analog distortion of branch similar output cancellation, or having a function of a distortion extraction adjustment amplifier circuit for analog digital distortion of branch similar output cancellation, or having a function of a distortion extraction adjustment amplifier circuit for digital distortion of branch similar output cancellation, or having a function of a distortion extraction adjustment amplifier circuit of the branch similar input combination and input cancellation combined auxiliary circuit for branch similar output cancellation, and by outputting generating the distorted signal having output reversed-phase similar cancellation, the branch similar output cancellation circuit has the characteristic similar to that of the distorted signal greater than the output cancellation equal-power point in the Class C main power signal with the extended linear gain dynamic range of the main power signals of the branch similar input combination and input cancellation combiner main circuit;
the branch similar output cancellation circuit N and the branch similar input combination cancellation and branch output cancellation combiner main circuit are parallelly connected to the analog input ports of the two circuits or the digital input ports of the two circuits or one analog input port and one digital input port in the two circuits and the outputs of the two circuits through the combination input divider circuit N or the combination digital input divider circuit N and the combination output coupling circuit N, to the branch similar input combination cancellation and branch output cancellation N-1 combiner main circuit, wherein after the combination output coupling circuit N connected to the output of the branch similar output cancellation circuit is mounted to an output of a combination output coupling circuit N-1 connected to the output of the branch similar input cancellation circuit, the generated distorted signal having reversed-phase similar cancellation is similar to the distorted signal greater than the output cancellation equal-power point in the Class C main power signal with the extended linear gain dynamic range of the main power signals of the branch similar input combination cancellation and branch output cancellation N-1 combiner main circuit, and the branch similar output cancellation circuit is N, and so on, wherein N is a natural number greater than 1;
an input of the output cancellation input divider circuit N or output cancellation digital input divider circuit N and an output of the output cancellation distortion adjustment power amplifier circuit correspond to an input and an output of the branch similar input combination cancellation and branch output cancellation N-1 combiner main circuit;
the analog distortion circuit for branch similar output cancellation implemented by a low-power output cancellation branch power amplifier circuit or an output power branch feed-forward power amplifier circuit has, by generating the distorted signal having output reversed-phase similar cancellation, the characteristic similar to that of the distorted signal greater than the output cancellation equal-power point in the Class C main power signal with the extended linear gain dynamic range of the main power signals of the branch similar input combination and input cancellation combiner main circuit;
by replacing the main power amplifier circuit in the branch similar input combination and input cancellation combiner main circuit with a similar low-power Class C output first auxiliary power amplifier circuit, the branch similar input combination and input cancellation combined auxiliary circuit for branch similar output cancellation is implemented, generates the distorted signal having output reversed-phase similar cancellation, and has the characteristic similar to that of the distorted signal greater than the output cancellation equal-power point in the Class C main power signal with the extended linear gain dynamic range of the main power signals of the branch similar input combination and input cancellation combiner main circuit;
or by replacing a main power amplifier circuit in the branch similar input combination cancellation and branch output cancellation N-1 combiner main circuit with a similar low-power Class C output Nth auxiliary power amplifier circuit, a branch similar input combination cancellation and branch output cancellation N-1 combined auxiliary circuit for branch similar output cancellation is implemented, generates the distorted signal having output reversed-phase similar cancellation, and has the characteristic similar to that of the distorted signal greater than the output cancellation equal-power point in the Class C main power signal with the extended linear gain dynamic range of the main power signals of the branch similar input combination cancellation and branch output cancellation N-1 combiner main circuit, wherein N is a natural number greater than 1;
the analog branch similar output cancellation digital distortion circuit or the branch similar output cancellation digital distortion circuit generates the distorted signal having output reversed-phase similar cancellation, has the characteristic similar to that of the distorted signal greater than the output cancellation equal-power point in the Class C main power signal with the extended linear gain dynamic range of the main power signals of the branch similar input combination and input cancellation combiner main circuit, and is implemented by connecting an output of an output cancellation digital-to-analog conversion circuit and an input of a low-power output cancellation analog power amplifier circuit, wherein a feedback input of the analog digital distortion circuit or branch similar output cancellation digital distortion circuit is connected and mounted to a feedback output of an output cancellation coupling feedback adjustment circuit on the output of the branch similar input combination cancellation and branch output cancellation combiner main circuit, to implement the analog branch similar output cancellation digital distortion circuit or the branch similar output cancellation digital distortion circuit; and
in the branch similar output cancellation circuit in the branch similar input combination cancellation and branch output cancellation combiner main circuit, the input and another output of the output cancellation input divider circuit connected to an input of the output cancellation main signal adjustment power amplifier circuit are perhaps mounted in the input combination or input cancellation main signal time-delay adjustment circuit in the branch similar input combination cancellation and branch output cancellation combiner main circuit.

14. The similar combination and cancellation power amplifier circuit according to claim 1, wherein the main power output of the feed-forward distortion extraction circuit of the branch similar input combination and input cancellation combiner main circuit is connected to the main power input of the main feed-forward output cancellation circuit, and the distortion output of the feed-forward distortion extraction circuit of the branch similar input combination and input cancellation combiner main circuit is connected to the distortion input of the main feed-forward output cancellation circuit, to implement the similar combination and cancellation power amplifier circuit having the function of the branch similar input combination cancellation and feed-forward output cancellation series circuit;
in the branch similar input combination cancellation and feed-forward output cancellation series circuit, features of the feed-forward distortion extraction circuit of the branch similar input combination and input cancellation combiner main circuit are as follows: by connecting the output of the branch similar input combination and input cancellation combiner main circuit and the input of the main circuit of the main feed-forward input coupling circuit, a feed-forward signal extraction circuit of the branch similar input combination and input cancellation combiner main circuit is implemented, and is parallely connected, with a feed-forward main circuit main signal adjustment power amplifier circuit and a feed-forward distortion output combiner circuit, to analog input ports of the two circuits or one digital input port and one analog input port in the two circuits and outputs of the two circuits through a feed-forward input divider circuit or through a feed-forward digital input divider circuit and a feed-forward distortion output combiner circuit, to implement the feed-forward distortion extraction circuit of the branch similar input combination and input cancellation combiner main circuit, wherein a coupling output of the main feed-forward input coupling circuit is an output of the feed-forward signal extraction circuit of the branch similar input combination and input cancellation combiner main circuit, and an analog input port of the feed-forward input divider circuit or a digital input port of the feed-forward digital input divider circuit, an output of the main circuit of the main feed-forward input coupling circuit, and an output of the feed-forward distortion output combiner circuit are an analog/Digital input port, main power output, and distortion output corresponding to the feed-forward distortion extraction circuit of the branch similar input combination and input cancellation combiner main circuit;
in the branch similar input combination cancellation and feed-forward output cancellation series circuit, the main feed-forward output cancellation circuit is implemented by connecting a main input of a feed-forward cancellation coupling circuit and an output of the feed-forward main time-delay circuit and connecting a coupling input of the feed-forward cancellation coupling circuit and an output of the feed-forward distortion adjustment power amplifier circuit, wherein an input of the feed-forward main time-delay circuit is the main power input of the main feed-forward output cancellation circuit, an input of the feed-forward distortion adjustment power amplifier circuit is the distortion input of the main feed-forward output cancellation circuit, and an output of the feed-forward cancellation coupling circuit is the output of the main feed-forward output cancellation circuit;
in the branch similar input combination cancellation and feed-forward output cancellation series circuit, from an input of a main circuit of a main feed-forward input coupling circuit to an output of a feed-forward cancellation coupling circuit via a feed-forward main time-delay circuit and via a feed-forward distortion adjustment power amplifier circuit connected to an output of a feed-forward distortion output combiner circuit, a main feed-forward combination cancellation circuit from the input of the main feed-forward input coupling circuit to the output of the feed-forward cancellation coupling circuit is implemented; and
the input and another output of the feed-forward input divider circuit connected to the input of the feed-forward main circuit main signal adjustment power amplifier circuit in the feed-forward distortion extraction circuit of the branch similar input combination and input cancellation combiner main circuit in the branch similar input combination cancellation and feed-forward output cancellation series circuit are perhaps mounted in the input combination or input cancellation main signal time-delay adjustment circuit; and
the same type cancellation features of the output of the branch similar input combination cancellation and feed-forward output cancellation series circuit are as follows: when the Class C main power linear ACPR of the extended linear gain dynamic range of the main power signals reaches above 40-45 dBC on the output of the branch similar input combination and input cancellation combiner main circuit, on the output of the branch similar input combination cancellation and feed-forward output cancellation series circuit, when the time delays equal to the feed-forward cancellation equal-power point are equal or nearly equal, the amplitudes are equal or nearly equal, and the phase are opposite or nearly opposite, the distorted signal in the Class C main power signal with the extended linear gain dynamic range of the main power signals outputted by the branch similar input combination and input cancellation combiner main circuit is extracted by the distortion output of the feed-forward distortion extraction circuit of the branch similar input combination and input cancellation combiner main circuit and the distorted signal in the Class C main power signal with the extended linear gain dynamic range of main power signals outputted by the main power output of the feed-forward distortion extraction circuit of the branch similar input combination and input cancellation combiner main circuit are the same type of distorted signals, on the output of the main feed-forward combination cancellation circuit, when the time delays equal to the feed-forward cancellation equal-power point are equal or nearly equal, the amplitudes are equal or nearly equal, and the phase are opposite or nearly opposite, the same type distortion signal cancellation of the distorted signal in the Class C main power signal with the extended linear gain dynamic range of the main power signals outputted by the branch similar input combination and input cancellation combiner main circuit is realized, and the linear gain dynamic range of the Class C output main power signal with the extended linear gain dynamic range of the main power signals is further extended to reach the linear gain dynamic range of the Class AB output main power, and the EVM value and the gain fluctuation are increased within the linear gain dynamic range that has been extended, thereby causing the Class C total linear dynamic range of Class AB output main power signals outputted by the branch similar input combination cancellation and feed-forward output cancellation series circuit to reach the linear ACPR value of the Class AB output main power signal to more than 50-55 dBC, and improving the overall efficiency.

15. The similar combination and cancellation power amplifier circuit according to any one of claims 1 to 14, wherein the combination input divider circuit or the parallel input divider circuit, the branch-main combination or branch-main cancellation input divider circuit, the input combination or input cancellation input divider circuit, the output cancellation input divider circuit, and the feed-forward input divider circuit are implemented by divider circuits, or coupling circuits, or other circuits achieving a division function, and meet power capacity requirements in the corresponding circuits and requirements of not generating new distorted signals, respectively;
the combination digital input divider circuit, the parallel digital input divider circuit, the feed-forward digital input divider circuit, the input combination digital input divider circuit, the input cancellation digital input divider circuit, and the output cancellation digital input divider circuit are implemented by digital divider circuits and meet digital signal requirements; the two outputs are digital ends, or one of the two outputs is a digital signal output, and the other digital output is an analog output by connecting the output of the digital-to-analog conversion circuit; and power capacity requirements in the corresponding circuits and requirements of not generating new distortion are met respectively;
the combination output coupling circuit, a load coupling circuit, a feedback coupling circuit, the main feed-forward input coupling circuit, and the feed-forward cancellation coupling circuit are implemented by coupling circuits or other circuits achieving a coupling function, and meet power capacity requirements in the corresponding circuits and requirements of not generating new distortion, respectively;
the parallel output combiner circuit, the branch-main combination or branch-main cancellation output combiner circuit, the input combination or input cancellation distortion output combiner circuit, the output cancellation distortion output combiner circuit, and the feed-forward distortion output combiner circuit are implemented by combiner circuits or coupling circuits, or other circuits achieving a combination function, and meet power capacity requirements in the corresponding circuits and requirements of not generating new distortion, respectively;
the input combination or input cancellation main signal adjustment power amplifier circuit, the output cancellation main signal adjustment power amplifier circuit, and the feed-forward main circuit main signal adjustment power amplifier circuit are implemented by serially connecting an input combination or input cancellation or output cancellation or feed-forward main circuit amplitude modulation circuit and an input combination or input cancellation or output cancellation or feed-forward main circuit adjustment circuit implemented by input combination or input cancellation or output cancellation or feed-forward main circuit phase modulation, to serially connect an input combination or input cancellation or output cancellation or feed-forward main circuit main signal adjustment power amplifier circuit, and meet main signal power capacity requirements in the corresponding circuits, as well as requirements of not generating new distortion;
the output cancellation distortion adjustment power amplifier circuit, the input combination or input cancellation distortion adjustment power amplifier circuit, and the feed-forward distortion adjustment power amplifier circuit are implemented by serially connecting an input combination or input cancellation or output cancellation or feed-forward amplitude modulation circuit and an input combination or input cancellation or output cancellation or feed-forward adjustment circuit implemented by an input combination or input cancellation or output cancellation or feed-forward phase modulation circuit, and then serially connecting an input combination or input cancellation or output cancellation or feed-forward distortion signal power amplifier circuit, and meet corresponding power capacity requirements of the corresponding distorted signal in the corresponding circuits, as well as requirements of not generating new distortion;
the input combination or input cancellation main signal time-delay adjustment circuit and the output cancellation main signal time-delay adjustment circuit are implemented by serially connecting an input combination or input cancellation amplitude adjustable circuit or an output cancellation amplitude modulation circuit and an input combination or input cancellation adjustment circuit or an output cancellation adjustment circuit implemented by an input combination or input cancellation phase modulation circuit or an output cancellation phase modulation circuit, and then serially connecting an input combination or input cancellation or output cancellation time-delay circuit, and meet power capacity requirements of the corresponding circuits and requirements of not generating new distortion;
the input combination or input cancellation or output cancellation coupling output load circuit is implemented by connecting a main output of the input combination or input cancellation or output cancellation load coupling circuit and an ungrounded end of an input combination or input cancellation or output cancellation load resistor, and meets power capacity requirements of the corresponding circuits and requirements of not generating new distortion; and
the input combination or input cancellation or output cancellation coupling feedback adjustment circuit is implemented by connecting the coupling output of the input combination or input cancellation or output cancellation feedback coupling circuit and an input combination or input cancellation or output cancellation feedback signal adjustment power amplifier circuit, wherein the input combination or input cancellation or output cancellation feedback signal adjustment power amplifier circuit is implemented by connecting the input combination or input cancellation or output cancellation amplitude modulation circuit and an input combination or input cancellation or output cancellation feedback signal power amplifier circuit, and meets power capacity requirements of the corresponding circuits and requirements of not generating new distortion.

16. The similar combination and cancellation power amplifier circuit according to any one of claims 1 to 15, connected to an ET circuit to implement a similar combination and cancellation ET power amplifier circuit, wherein
the ET circuit is implemented by respectively connecting an input of an envelope tracking control circuit and an input of an ET main signal adjustment time-delay circuit to two outputs of an ET divider circuit, wherein the envelope tracking control circuit is implemented by connecting an output of an envelope tracking signal processing circuit and an envelope input of a control power supply circuit, and an input of an ET input divider circuit, power supply outputs and power supply inputs of a plurality of different voltages of the control power supply circuit in the envelope tracking control circuit, and a main signal output of the ET main signal adjustment time-delay circuit respectively are an input and power supply output of the ET circuit, and a power supply input and a main signal output;
the similar combination and cancellation ET power amplifier circuit is implemented by connecting power supply outputs of a plurality of different and same voltages of the ET circuit and drain power supply ends of a plurality of different power amplifier circuits of a plurality of different and same corresponding voltages in the similar combination and cancellation power amplifier circuit, connecting the power supply input of the ET circuit and a power supply, and connecting the main signal output of the ET circuit and an input of the similar combination and cancellation power amplifier circuit;
in the similar combination and cancellation ET power amplifier circuit, ET control power supply and power features of the power amplifier circuit of the branch similar combination input cancellation combiner main circuit are as follows: through segment selection of an envelope tracking signal and according to a relationship between a drain voltage and an output power, a corresponding output main power is reached under different drain voltage combinations in the similar combination and cancellation power amplifier circuit corresponding to each segment region of the envelope tracking signal;
when the switching of the envelope tracking signal between the segments needs to be re-adjusted to cause the linear ACPR value of the output main power signal of the similar combination and cancellation power amplifier circuit achieving the input combination and input cancellation features of the output of the branch similar input combination and input cancellation combiner main circuit, or achieving the output cancellation features of the output of the branch similar input combination cancellation and branch output cancellation combiner main circuit, or achieving the same type cancellation features of the output of the branch similar input combination cancellation and feed-forward output cancellation series main circuit to reach more than 55 dBc again, and overall efficiency is improved, a sum of a time delay consumed, a signal processing time delay of the envelope tracking signal in the envelope tracking control circuit, and a time delay required for the control power supply circuit to change the voltages is equal to a time delay of the main signal adjustment time-delay circuit, or a time delay consumed under a condition of known envelope tracking signal segment region information is equally equal to a sum of an envelope signal processing time delay of the envelope tracking control circuit and a time delay required for the control power supply to change the voltages, and is equal to a time delay of the ET main signal adjustment time-delay circuit; and
features of the relationship between the drain voltage and the output power are as follows: when an output power of the similar combination and cancellation power amplifier circuit is at one of power values from a high power to a low power, the drain voltages of the plurality of power amplifier circuits are able to be reduced from an original high voltage combination to a low voltage drain voltage combination at one of the power values; and when the output power of the similar combination and cancellation power amplifier circuit is at one of the power values from the low power to the high power, the drain voltages of the plurality of power amplifier circuits shall be increased from an original low voltage combination to a high voltage combination corresponding to one of the power values of the high power, and then the output power is able to change from the low power to one of the power values of the high power.
